# EUROPEAN PATENT APPLICATION

(11) **EP 4 671 253 A1**
(43) Date of publication of application: **31.12.2025**
(21) Application number: 25185583.9
(22) Date of filing: 26.06.2025
(51) Int. Cl.: C07F 5/02, C07F 7/08, C09K 11/06, H10K 50/11

(54) **LIGHT-EMITTING ELEMENT, POLYCYCLIC COMPOUND FOR THE SAME, AND ELECTRONIC DEVICE INCLUDING THE LIGHT-EMITTING ELEMENT**

(30) Priority: 26.06.2024 KR 20240083763; 12.07.2024 KR 20240092654
(71) Applicant: Samsung Display Co., Ltd., Yongin-si, Gyeonggi-do (KR)
(72) Inventor: RYOO, Chihyun, Yongin-si (KR); PAK, Sun Young, Yongin-si (KR); PARK, Junha, Yongin-si (KR); SUNG, MinJae, Yongin-si (KR); SIM, Mun-Ki, Yongin-si (KR); HAN, Giwoong, Yongin-si (KR); HUR, Seonhyoung, Yongin-si (KR)
(74) Representative: Marks & Clerk LLP

(57) **Abstract**

Embodiments provide a polycyclic compound, a light-emitting element that includes the polycyclic compound, and a display device that includes the light-emitting element. The light-emitting element includes a first electrode, a second electrode disposed on the first electrode, and a light-emitting layer disposed between the first electrode and the second electrode, wherein the light-emitting layer includes the polycyclic compound. The polycyclic compound represented by Formula 1, which is explained in the specification.

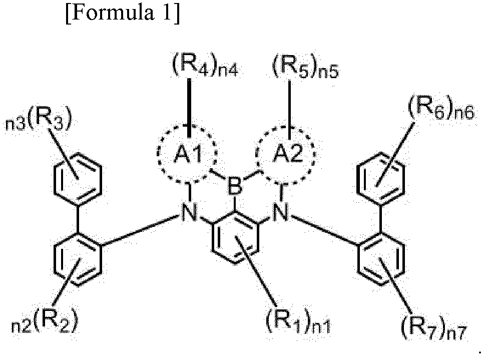

## Description

### BACKGROUND

### 1. Technical Field

The disclosure relates to a light-emitting element, a polycyclic compound used in the light-emitting element, and an electronic device including the light-emitting element.

### 2. Description of the Related Art

Ongoing development continues for an organic electroluminescence display device as an image display device. In contrast to a liquid crystal display device, an organic electroluminescence display device is a so-called self-emissive display device in which holes and electrons respectively injected from a first electrode and a second electrode recombine in a light-emitting layer, so that in the light-emitting layer, a light-emitting material that includes an organic compound emits light to achieve display.

In the application of a light-emitting element to a display device, there is a persistent demand for high luminous efficiency and long lifespan. Thus, continuous development is required for a light-emitting material that is capable of achieving such characteristics.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

The disclosure provides a light-emitting element with improved luminous efficiency and lifespan.

The disclosure also provides a polycyclic compound with improved material lifespan.

The disclosure also provides a display device with excellent display quality by including a light-emitting element with improved luminous efficiency and lifespan.

According to an embodiment, a light-emitting element includes a first electrode, a second electrode disposed on the first electrode, and a light-emitting layer disposed between the first electrode and the second electrode, and including a first compound represented by Formula 1:

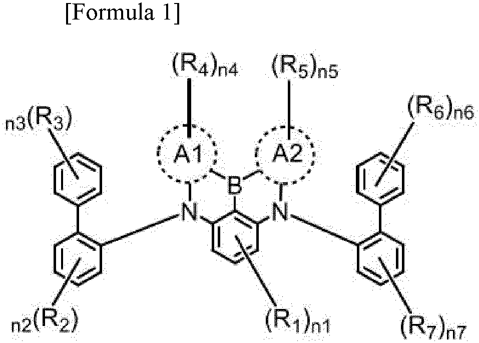

In Formula 1, ring A1 and ring A2 are each independently a substituted or unsubstituted hydrocarbon ring having a ring-forming carbon number of 6 to 30 or a substituted or unsubstituted heterocycle having a ring-forming carbon number of 5 to 30; R₁ to R₇ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60, a substituted or unsubstituted cycloalkyl group having a ring-forming carbon number of 3 to 60, a substituted or unsubstituted alkenyl group having a carbon number of 2 to 60, a substituted or unsubstituted aryl group having a ring-forming carbon number of 6 to 60, or a substituted or unsubstituted heteroaryl group having a ring-forming carbon number of 2 to 60, or combined with an adjacent group to form a ring; n1 is an integer from 0 to 3; n2 and n7 are each independently an integer from 0 to 4; n3 and n6 are each independently an integer from 0 to 5; n4 and n5 are each independently an integer from 0 to 14; and at least one of ring A1, ring A2, and R₁ to R₇ is each independently a substituted or unsubstituted triptycene group.

In an embodiment, the first compound may be represented by Formula 2:

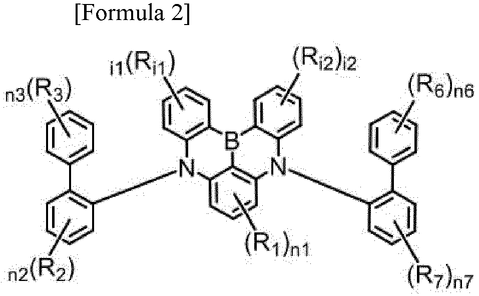

In Formula 2, Rᵢ₁ and Rᵢ₂ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60, a substituted or unsubstituted cycloalkyl group having a ring-forming carbon number of 3 to 60, a substituted or unsubstituted alkenyl group having a carbon number of 2 to 60, a substituted or unsubstituted aryl group having a ring-forming carbon number of 6 to 60, or a substituted or unsubstituted heteroaryl group having a ring-forming carbon number of 2 to 60, or combined with an adjacent group to form a ring; i1 and i2 are each independently an integer from 0 to 4; R₁ to R₃, R₆, R₇, n1 to n3, n6, and n7 are the same as defined in Formula 1; and at least one of Rᵢ₁, Rᵢ₂, R₁ to R₃, R₆, and R₇ are each independently a group represented by Formula a:

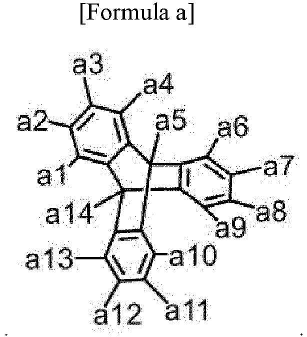

In Formula a, one of a1 to a14 is a position connected to Formula 2; and the remainder of a1 to a14 are each independently a hydrogen atom, a deuterium atom, a substituted or unsubstituted alkyl group having a carbon number of 1 to 30, or a substituted or unsubstituted aryl group having a ring-forming carbon number of 6 to 30.

In an embodiment, the remainder of a1 to a14 that are not connected to Formula 2 may each be a hydrogen atom.

In an embodiment, the first compound may be represented by Formula 2-1 or Formula 2-2, which are explained below.

In an embodiment, the first compound may be represented by Formula 3-1 or Formula 3-2, which are explained below.

In an embodiment, the first compound may be represented by Formula 3-1-1, which is explained below.

In an embodiment, the first compound may be represented by Formula 3-2-1, which is explained below.

In an embodiment, the first compound may be represented by Formula 4, which is explained below.

In an embodiment, in the first compound, at least one hydrogen atom may be substituted with a deuterium atom.

In an embodiment, the light-emitting layer may emit blue light.

In an embodiment, the light-emitting layer may further include at least one of a second compound represented by Formula HT-1, a third compound represented by Formula ET-1, and a fourth compound represented by Formula D-1, which are explained below.

In an embodiment, the light-emitting layer may further include the second compound, the third compound, and the fourth compound.

In an embodiment, the first compound may include at least one compound selected from Compound Group 1, which is explained below.

According to an embodiment, a polycyclic compound is represented by Formula 1, which is explained herein.

In an embodiment, the polycyclic compound may be represented by Formula 2, which is explained below.

In an embodiment, the polycyclic compound may be represented by Formula 3-1 or Formula 3-2, which are explained below.

In an embodiment, the polycyclic compound may be represented by Formula 4, which is explained below.

In an embodiment, the polycyclic compound may be selected from Compound Group 1, which is explained below.

According to an embodiment, an electronic device comprising a display device includes a circuit layer disposed on a base layer, and a display element layer disposed on the circuit layer and including a light-emitting element, wherein the light-emitting element includes a first electrode, a second electrode facing the first electrode, and a polycyclic compound disposed between the first electrode and the second electrode, and the polycyclic compound is represented by Formula 1, which is explained herein.

In an embodiment, the display device may further include an optical control layer disposed on the display element layer, wherein the optical control layer may include a quantum dot.

At least some of the above and other features of the invention are set out in the claims.

It is to be understood that the embodiments above are described in a generic and explanatory sense only and not for the purposes of limitation, and the disclosure is not limited to the embodiments described above.

### BRIEF DESCRIPTION OF THE DRAWINGS

The accompanying drawings are included to provide a further understanding of the embodiments, and are incorporated in and constitute a part of this specification. The drawings illustrate embodiments of the disclosure and principles thereof. The above and other aspects and features of the disclosure will become more apparent by describing in detail embodiments thereof with reference to the accompanying drawings, in which:
FIG. 1 is a schematic plan view of a display device according to an embodiment;
FIG. 2 is a schematic cross-sectional view of a display device according to an embodiment, showing a section taken along virtual line I-I' in FIG. 1;
FIG. 3 is a schematic cross-sectional view of a light-emitting element according to an embodiment;
FIG. 4 is a schematic cross-sectional view of a light-emitting element according to an embodiment;
FIG. 5 is a schematic cross-sectional view of a light-emitting element according to an embodiment;
FIG. 6 is a schematic cross-sectional view of a light-emitting element according to an embodiment;
FIG. 7 is a schematic cross-sectional view of a light-emitting element according to an embodiment;
FIG. 8 is a schematic cross-sectional view of a display device according to an embodiment;
FIG. 9 is a schematic cross-sectional view of a display device according to an embodiment;
FIG. 10 is a schematic cross-sectional view of a display device according to an embodiment;
FIG. 11 is a schematic cross-sectional view of a display device according to an embodiment; and
FIG. 12 is a schematic diagram of an interior of a vehicle in which a display device according to an embodiment is disposed.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, the sizes, thicknesses, ratios, and dimensions of the elements may be exaggerated for ease of description and for clarity. Like reference numbers and reference characters refer to like elements throughout.

In the specification, it will be understood that when an element (or region, layer, part, etc.) is referred to as being "on", "connected to", or "coupled to" another element, it can be directly on, connected to, or coupled to the other element, or one or more intervening elements may be present therebetween. In a similar sense, when an element (or region, layer, part, etc.) is described as "covering" another element, it can directly cover the other element, or one or more intervening elements may be present therebetween.

In the specification, when an element is "directly on," "directly connected to," or "directly coupled to" another element, there are no intervening elements present. For example, "directly on" may mean that two layers or two elements are disposed without an additional element such as an adhesion element therebetween.

As used herein, the expressions used in the singular such as "a," "an," and "the," are intended to include the plural forms as well, unless the context clearly indicates otherwise.

As used herein, the term "and/or" includes any and all combinations of one or more of the associated listed items. For example, "A and/or B" may be understood to mean "A, B, or A and B." The terms "and" and "or" may be used in the conjunctive or disjunctive sense and may be understood to be equivalent to "and/or".

In the specification and the claims, the term "at least one of" is intended to include the meaning of "at least one selected from the group consisting of" for the purpose of its meaning and interpretation. For example, "at least one of A, B, and C" may be understood to mean A only, B only, C only, or any combination of two or more of A, B, and C, such as ABC, ACC, BC, or CC. When preceding a list of elements, the term, "at least one of," modifies the entire list of elements and does not modify the individual elements of the list.

It will be understood that, although the terms first, second, etc. may be used herein to describe various elements, these elements should not be limited by these terms. These terms are only used to distinguish one element from another element. Thus, a first element could be termed a second element without departing from the teachings of the disclosure. Similarly, a second element could be termed a first element, without departing from the scope of the disclosure.

The spatially relative terms "below", "beneath", "lower", "above", "upper", or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

The terms "about" or "approximately" as used herein is inclusive of the stated value and means within an acceptable range of deviation for the recited value as determined by one of ordinary skill in the art, considering the measurement in question and the error associated with measurement of the recited quantity (i.e., the limitations of the measurement system). For example, "about" may mean within one or more standard deviations, or within ±20%, ±10%, or ±5% of the stated value.

It should be understood that the terms "comprises," "comprising," "includes," "including," "have," "having," "contains," "containing," and the like are intended to specify the presence of stated features, integers, steps, operations, elements, components, or combinations thereof in the disclosure, but do not preclude the presence or addition of one or more other features, integers, steps, operations, elements, components, or combinations thereof.

Unless otherwise defined or implied herein, all terms (including technical and scientific terms) used have the same meaning as commonly understood by those skilled in the art to which this disclosure pertains. It will be further understood that terms, such as those defined in commonly used dictionaries, should be interpreted as having a meaning that is consistent with their meaning in the context of the relevant art and should not be interpreted in an ideal or excessively formal sense unless clearly defined in the specification. In the specification, an integer selected from 0 to 3 refers to an integer selected from 0, 1, 2, and 3; an integer selected from 0 to 4 refers to an integer selected from 0, 1, 2, 3, and 4; an integer selected from 0 to 5 refers to an integer selected from 0, 1, 2, 3, 4, and 5; an integer selected from 0 to 7 refers to an integer selected from 0, 1, 2, 3, 4, 5, 6, and 7; an integer selected from 0 to 8 refers to an integer selected from 0, 1, 2, 3, 4, 5, 6, 7, and 8; an integer selected from 0 to 9 refers to an integer selected from 0, 1, 2, 3, 4, 5, 6, 7, 8, and 9; and an integer selected from 0 to 10 refers to an integer selected from 0, 1, 2, 3, 4, 5, 6, 7, 8, 9, and 10.

In the specification, the term "substituted or unsubstituted" may describe a group that is substituted or unsubstituted with at least one substituent selected from the group consisting of a deuterium atom, a halogen atom, a cyano group, a nitro group, an amino group, an amine group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group. Each of the substituents listed above may itself be substituted or unsubstituted. For example, a biphenyl group may be interpreted as an aryl group, or it may be interpreted as a phenyl group substituted with a phenyl group.

In the specification, the term "combined with an adjacent group to form a ring" may refer to a group that is bonded to an adjacent group to form a substituted or unsubstituted hydrocarbon ring or a substituted or unsubstituted heterocycle. A hydrocarbon ring may be aliphatic or aromatic. A heterocycle may be aliphatic or aromatic. A hydrocarbon ring and a heterocycle may each independently be monocyclic or polycyclic. A ring that is formed by adjacent groups being combined with each other may itself be connected to another ring to form a spiro structure.

In the specification, the term "adjacent group" may be interpreted as a substituent that is substituted for an atom which is directly linked to an atom substituted with a corresponding substituent, as another substituent that is substituted for an atom which is substituted with a corresponding substituent, or as a substituent that is sterically positioned at the nearest position to a corresponding substituent. For example, two methyl groups in 1,2-dimethylbenzene may be interpreted as "adjacent groups" to each other, and two ethyl groups in 1,1-diethylcyclopentane may be interpreted as "adjacent groups" to each other. For example, two methyl groups in 4,5-dimethylphenanthrene may be interpreted as "adjacent groups" to each other.

In the specification, examples of a halogen atom may include a fluorine atom, a chlorine atom, a bromine atom, and an iodine atom.

In the specification, an alkyl group may be linear or branched. The number of carbons in an alkyl group may be 1 to 60, 1 to 50, 1 to 30, 1 to 20, 1 to 10, or 1 to 6. Examples of an alkyl group may include a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-henicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, etc., but embodiments are not limited thereto.

In the specification, a cycloalkyl group may be a cyclic alkyl group. The number of carbons in a cycloalkyl group may be 3 to 60, 3 to 50, 3 to 30, 3 to 20, or 3 to 10. Examples of a cycloalkyl group may include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, etc., but embodiments are not limited thereto.

In the specification, an alkenyl group may be a hydrocarbon group that includes at least one carbon-carbon double bond in the middle or at a terminus of an alkyl group having 2 or more carbon atoms. An alkenyl group may be linear or branched. The number of carbon atoms in an alkenyl group is not particularly limited, and may be 2 to 60, 2 to 30, 2 to 20, or 2 to 10. Examples of an alkenyl group may include a vinyl group, a 1-butenyl group, a 1-pentenyl group, a 1,3-butadienyl group, a styrenyl group, a styryl vinyl group, *etc.,* but embodiments are not limited thereto.

In the specification, an alkynyl group may be a hydrocarbon group that includes at least one carbon-carbon triple bond in the middle or at a terminus of an alkyl group having 2 or more carbon atoms. An alkynyl group may be linear or branched. The number of carbon atoms in an alkynyl group is not particularly limited, and may be 2 to 30, 2 to 20, or 2 to 10. Examples of an alkynyl group may include an ethynyl group, a propynyl group, etc., but embodiments are not limited thereto.

In the specification, a hydrocarbon ring group may be any functional group or substituent derived from an aliphatic hydrocarbon ring or an aromatic hydrocarbon ring. For example, a hydrocarbon ring group may be a saturated hydrocarbon ring group having 6 to 30, 5 to 30, or 5 to 20 ring-forming carbon atoms.

In the specification, an aryl group may be any functional group or substituent derived from an aromatic hydrocarbon ring. An aryl group may be monocyclic or polycyclic. The number of ring-forming carbon atoms in an aryl group may be 6 to 36, 6 to 30, 6 to 20, or 6 to 15. Examples of an aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, *etc.,* but embodiments are not limited thereto.

In the specification, a fluorenyl group may be substituted, and two substituents may be combined with each other to form a spiro structure. Examples of a substituted fluorenyl group may include the groups shown below. However, embodiments are not limited thereto.

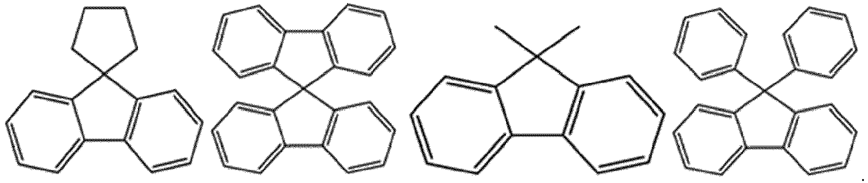

In the specification, a heterocyclic group may be any functional group or substituent derived from a ring containing at least one of B, O, N, P, Si, and S as a heteroatom. A heterocyclic group may be aliphatic or aromatic. An aromatic heterocyclic group may be a heteroaryl group. An aliphatic heterocycle and an aromatic heterocycle may each independently be monocyclic or polycyclic.

If a heterocyclic group includes two or more heteroatoms, the two or more heteroatoms may be the same as or different from each other. The number of ring-forming carbon atoms in a heterocyclic group may be 2 to 60, 5 to 30, 2 to 30, 2 to 20, or 2 to 10.

Examples of an aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, *etc.,* but embodiments are not limited thereto.

Examples of a heteroaryl group may include a thiophene group, a furan group, a pyrrole group, an imidazole group, a pyridine group, a bipyridine group, a pyrimidine group, a triazine group, a triazole group, an acridyl group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzoimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, *etc.,* but embodiments are not limited thereto.

In the specification, the above description of an aryl group may be applied to an arylene group, except that an arylene group is a divalent group. In the specification, the above description of a heteroaryl group may be applied to a heteroarylene group, except that a heteroarylene group is a divalent group.

In the specification, a silyl group may be an alkylsilyl group or an arylsilyl group. Examples of a silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, *etc.,* but embodiments are not limited thereto.

In the specification, the number of carbon atoms in a carbonyl group is not particularly limited, and may be 1 to 40, 1 to 30, or 1 to 20. For example, a carbonyl group may include one of the following structures, but embodiments are not limited thereto.

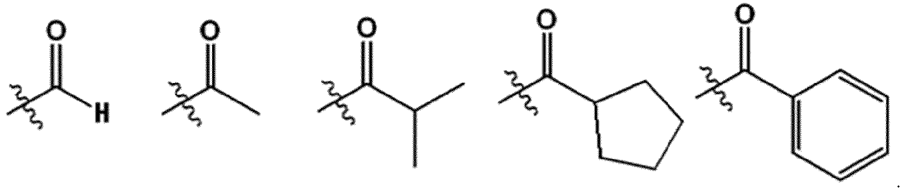

In the specification, the number of carbon atoms in a sulfinyl group or a sulfonyl group is not particularly limited, and may be 1 to 30. A sulfinyl group may be an alkyl sulfinyl group or an aryl sulfinyl group. A sulfonyl group may be an alkyl sulfonyl group or an aryl sulfonyl group.

In the specification, a thio group may be an alkylthio group or an arylthio group. A thio group may be a sulfur atom that is bonded to an alkyl group or to an aryl group as defined above. Examples of a thio group may include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, but embodiments are not limited thereto.

In the specification, an oxy group may be an oxygen atom that is bonded to an alkyl group or to an aryl group as defined above. An oxy group may be an alkoxy group or an aryl oxy group. An alkoxy group may be linear, branched, or cyclic. The number of carbon atoms in an alkoxy group is not particularly limited, and may be, for example, 1 to 20 or 1 to 10. Examples of an oxy group may include a methoxy group, an ethoxy group, an n-propoxy group, an isopropoxy group, a butoxy group, a pentyloxy group, a hexyloxy group, an octyloxy group, a nonyloxy group, a decyloxy group, a benzyloxy group, *etc.,* but embodiments are not limited thereto.

In the specification, a boron group may be a boron atom that is bonded to an alkyl group or to an aryl group as defined above. A boron group may be an alkyl boron group or an aryl boron group. Examples of a boron group may include a dimethylboron group, a trimethylboron group, a t-butyldimethylboron group, a diphenylboron group, a phenylboron group, etc., but embodiments are not limited thereto.

In the specification, the number of carbon atoms in an amine group is not particularly limited, and may be 1 to 30. An amine group may be an alkyl amine group or an aryl amine group. Examples of an amine group may include a methylamine group, a dimethylamine group, a phenylamine group, a diphenylamine group, a naphthylamine group, a 9-methyl-anthracenylamine group, *etc.,* but embodiments are not limited thereto.

In the specification, an alkyl group within an alkylthio group, an alkylsulfoxy group, an alkylaryl group, an alkylamino group, an alkyl boron group, an alkyl silyl group, or an alkyl amine group may be the same as an example of an alkyl group as described above.

In the specification, an aryl group within an aryloxy group, an arylthio group, an arylsulfoxy group, an arylamino group, an arylboron group, an arylsilyl group, or an arylamine group may be the same as an example of an aryl group as described above.

In the specification, the phosphine oxide group may be substituted with, for example, at least one of the alkyl groups or aryl groups described above.

In the specification, the phosphine sulfide group may be substituted with, for example, at least one of the alkyl groups or aryl groups described above.

In the specification, a direct linkage may be a single bond.

In the specification, the symbols 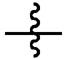 and 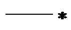 each represent a bond to a neighboring atom in a corresponding formula or moiety.

Hereinafter, embodiments will be described with reference to the accompanying drawings.

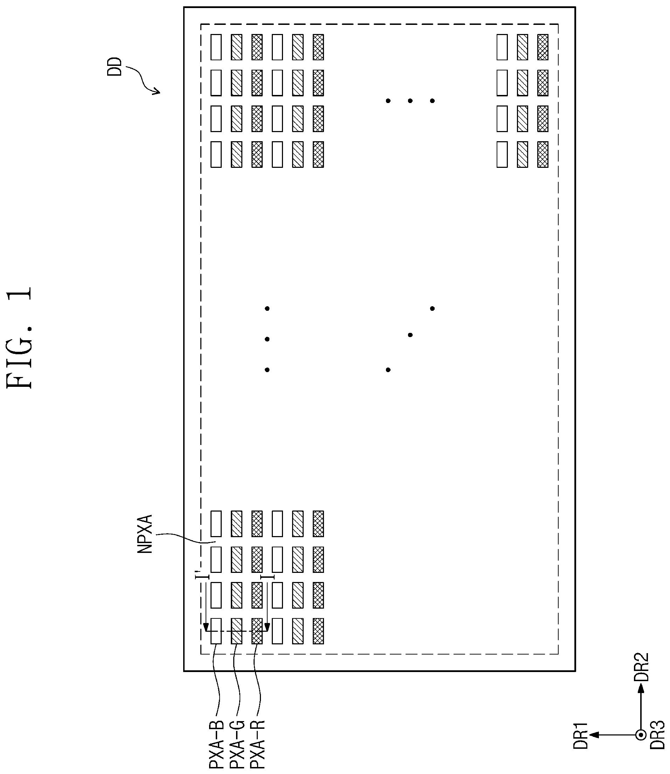

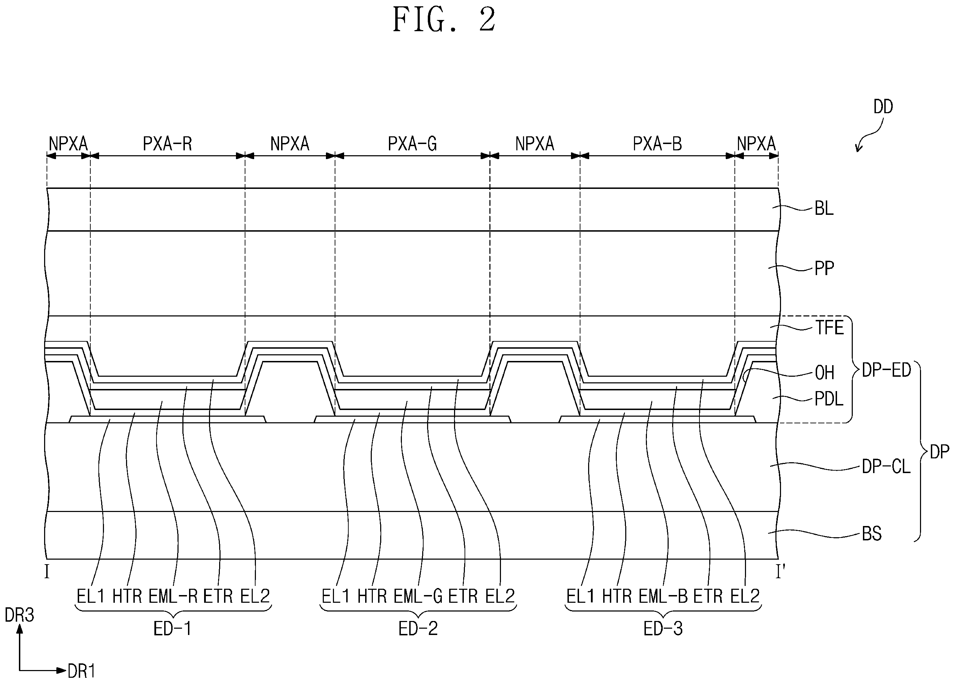

FIG. 1 is a schematic plan view of a display device DD according to an embodiment. FIG. 2 is a schematic cross-sectional view of the display device DD according to an embodiment. FIG. 2 is a schematic cross-sectional view of a portion taken along virtual line I-I' in FIG. 1.

The display device DD may include a display panel DP and an optical layer PP disposed on the display panel DP. The display panel DP includes light-emitting elements ED-1, ED-2, and ED-3. The display device DD may include multiples of each of the light-emitting elements ED-1, ED-2, and ED-3. The optical layer PP may be disposed on the display panel DP to control light that is reflected at the display panel DP from an external light. The optical layer PP may include, for example, a polarization layer or a color filter layer. Although not shown in the drawings, in an embodiment, the optical layer PP may be omitted from the display device DD.

A base substrate BL may be disposed on the optical layer PP. The base substrate BL may provide a base surface on which the optical layer PP is disposed. The base substrate BL may be a glass substrate, a metal substrate, a plastic substrate, *etc.* However, embodiments are not limited thereto, and the base substrate BL may include an inorganic layer, an organic layer, or a composite material layer. Although not shown in the drawings, in an embodiment, the base substrate BL may be omitted.

The display device DD according to an embodiment may further include a filling layer (not shown). The filling layer (not shown) may be disposed between a display element layer DP-ED and the base substrate BL. The filling layer (not shown) may be an organic material layer. The filling layer (not shown) may include at least one of an acrylic-based resin, a silicone-based resin, and an epoxy-based resin.

The display panel DP may include a base layer BS, a circuit layer DP-CL provided on the base layer BS, and the display element layer DP-ED. The display element layer DP-ED may include a pixel defining film PDL, light-emitting elements ED-1, ED-2, and ED-3 disposed between portions of the pixel defining film PDL, and an encapsulation layer TFE disposed on the light-emitting elements ED-1, ED-2, and ED-3.

The base layer BS may provide a base surface on which the display element layer DP-ED is disposed. The base layer BS may be a glass substrate, a metal substrate, a plastic substrate, *etc.* However, embodiments are not limited thereto, and the base layer BS may include an inorganic layer, an organic layer, or a composite material layer.

In an embodiment, the circuit layer DP-CL is disposed on the base layer BS, and the circuit layer DP-CL may include transistors (not shown). The transistors (not shown) may each include a control electrode, an input electrode, and an output electrode. For example, the circuit layer DP-CL may include a switching transistor and a driving transistor for driving the light-emitting elements ED-1, ED-2, and ED-3 of the display element layer DP-ED.

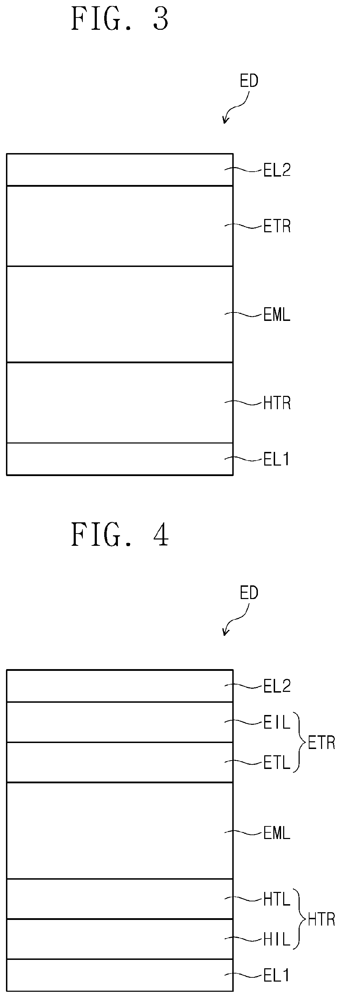

The light-emitting elements ED-1, ED-2, and ED-3 may each have a structure of a light-emitting element ED according to any one of FIGS. 3 to 7, which will be described later. The light-emitting elements ED-1, ED-2, and ED-3 may each include a first electrode EL1, a hole transport region HTR, light-emitting layers EML-R, EML-G, and EML-B, an electron transport region ETR, and a second electrode EL2.

FIG. 2 illustrates an embodiment in which the light-emitting layers EML-R, EML-G, and EML-B of the light-emitting elements ED-1, ED-2, and ED-3 are disposed in openings OH defined in the pixel defining film PDL, and the hole transport region HTR, the electron transport region ETR, and the second electrode EL2 are each provided as a common layer for the light-emitting elements ED-1, ED-2, and ED-3. However, embodiments are not limited thereto. Although not shown in FIG. 2, in an embodiment, the hole transport region HTR and the electron transport region ETR may each be provided by being patterned in the openings OH defined in the pixel defining film PDL. For example, in an embodiment, the hole transport region HTR, the light-emitting layers EML-R, EML-G, and EML-B, and the electron transport region ETR of the light-emitting elements ED-1, ED-2, and ED-3 may be provided by being patterned through an inkjet printing method.

The encapsulation layer TFE may cover the light-emitting elements ED-1, ED-2, and ED-3. The encapsulation layer TFE may seal the display element layer DP-ED. The encapsulation layer TFE may be a thin film encapsulation layer. The encapsulation layer TFE may be formed of a single layer or of multiple layers. The encapsulation layer TFE may include at least one insulation layer. The encapsulation layer TFE according to an embodiment may include at least one inorganic film (hereinafter, an encapsulation-inorganic film). The encapsulation layer TFE according to an embodiment may include at least one organic film (hereinafter, an encapsulation-organic film) and at least one encapsulation-inorganic film.

The encapsulation-inorganic film protects the display element layer DP-ED from moisture and/or oxygen, and the encapsulation-organic film protects the display element layer DP-ED from foreign substances such as dust particles. The encapsulation-inorganic film may include silicon nitride, silicon oxynitride, silicon oxide, titanium oxide, aluminium oxide, or the like, but embodiments are not limited thereto. The encapsulation-organic film may include an acrylic-based compound, an epoxy-based compound, or the like. The encapsulation-organic film may include a photopolymerizable organic material, but embodiments are not limited thereto.

The encapsulation layer TFE may be disposed on the second electrode EL2 and may be disposed to fill the openings OH.

Referring to FIGS. 1 and 2, the display device DD may include non-light emitting regions NPXA and light emitting regions PXA-R, PXA-G, and PXA-B. The light emitting regions PXA-R, PXA-G, and PXA-B may each be a region that emits light respectively generated by the light-emitting elements ED-1, ED-2, and ED-3. The light emitting regions PXA-R, PXA-G, and PXA-B may be spaced apart from each other in a plan view.

The light emitting regions PXA-R, PXA-G, and PXA-B may be regions that are separated from each other by the pixel defining film PDL. The non-light emitting regions NPXA may be regions between the adjacent light emitting regions PXA-R, PXA-G, and PXA-B, and which may correspond to the pixel defining film PDL. In an embodiment, the light emitting regions PXA-R, PXA-G, and PXA-B may each correspond to a pixel. The pixel defining film PDL may separate the light-emitting elements ED-1, ED-2, and ED-3. The light-emitting layers EML-R, EML-G, and EML-B of the light-emitting elements ED-1, ED-2, and ED-3 may be disposed in openings OH defined in the pixel defining film PDL and separated from each other.

The light emitting regions PXA-R, PXA-G, and PXA-B may be arranged into groups according to the color of light generated from the light-emitting elements ED-1, ED-2, and ED-3. In the display device DD according to an embodiment illustrated in FIGS. 1 and 2, three light emitting regions PXA-R, PXA-G, and PXA-B, which respectively emit red light, green light, and blue light, are illustrated as an example. For example, the display device DD may include a red light emitting region PXA-R, a green light emitting region PXA-G, and a blue light emitting region PXA-B, which are distinct from each other.

In the display device DD according to an embodiment, the light-emitting elements ED-1, ED-2, and ED-3 may emit light having wavelengths that are different from each other. For example, in an embodiment, the display device DD may include a first light-emitting element ED-1 that emits red light, a second light-emitting element ED-2 that emits green light, and a third light-emitting element ED-3 that emits blue light. For example, the red light emitting region PXA-R, the green light emitting region PXA-G, and the blue light emitting region PXA-B of the display device DD may respectively correspond to the first light-emitting element ED-1, the second light-emitting element ED-2, and the third light-emitting element ED-3.

However, embodiments are not limited thereto, and the first to third light-emitting elements ED-1, ED-2, and ED-3 may emit light in a same wavelength range, or at least one light-emitting element may emit light in a wavelength range that is different from the remainder. For example, the first to third light-emitting elements ED-1, ED-2, and ED-3 may each emit blue light.

The light emitting regions PXA-R, PXA-G, and PXA-B in the display device DD according to an embodiment may be arranged in a stripe configuration. Referring to FIG. 1, the red light emitting regions PXA-R, the green light emitting regions PXA-G, and the blue light emitting regions PXA-B may be respectively arranged along a second directional axis DR2. In another embodiment, the red light emitting region PXA-R, the green light emitting region PXA-G, and the blue light emitting region PXA-B may be arranged in this repeating order along a first directional axis DR1.

FIGS. 1 and 2 illustrate that the light emitting regions PXA-R, PXA-G, and PXA-B all have a similar area, but embodiments are not limited thereto. In an embodiment, the light emitting regions PXA-R, PXA-G, and PXA-B may be different in size and/or shape from each other, according to a wavelength range of emitted light. The areas of the light emitting regions PXA-R, PXA-G, and PXA-B may be areas in a plan view that are defined by the first directional axis DR1 and the second directional axis DR2. A third direction axis DR3 may be perpendicular to a plane defined by the first direction axis DR1 and the second direction axis DR2.

An arrangement of the light emitting regions PXA-R, PXA-G, and PXA-B is not limited to the configuration illustrated in FIG. 1, and the order in which the red light emitting region PXA-R, the green light emitting region PXA-G, and the blue light emitting region PXA-B are arranged may be provided in various combinations, according to the display quality characteristics that are required for the display device DD. For example, the light emitting regions PXA-R, PXA-G, and PXA-B may be arranged in a pentile configuration (such as PenTile^{®}) or in a diamond configuration (such as Diamond Pixel^{®}).

The areas of the light emitting regions PXA-R, PXA-G, and PXA-B may be different in size from each other. For example, in an embodiment, an area of a green light emitting region PXA-G may be smaller than an area of a blue light emitting region PXA-B, but embodiments are not limited thereto.

Hereinafter, FIG. 3 to FIG. 7 are each a schematic cross-sectional view of a light-emitting element ED according to an embodiment. As shown in FIG. 3, the light-emitting element ED according to an embodiment may include a first electrode EL1, a hole transport region HTR, a light-emitting layer EML, an electron transport region ETR, and a second electrode EL2, stacked in that order.

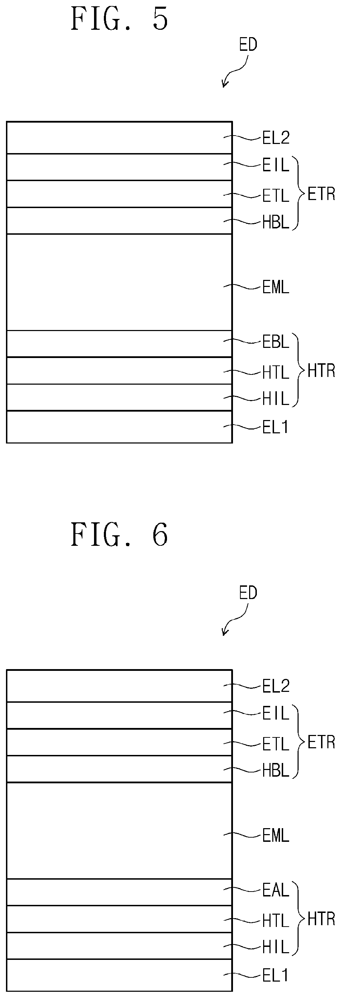

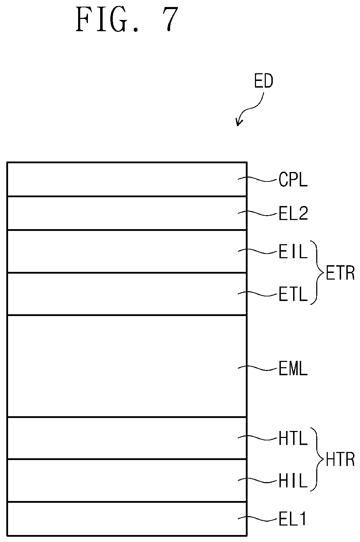

In comparison to FIG. 3, FIG. 4 is a schematic cross-sectional view of a light-emitting element ED, in which a hole transport region HTR includes a hole injection layer HIL and a hole transport layer HTL, and an electron transport region ETR includes an electron injection layer EIL and an electron transport layer ETL. In comparison to FIG. 3, FIG. 5 is a schematic cross-sectional view of a light-emitting element ED, in which a hole transport region HTR includes a hole injection layer HIL, a hole transport layer HTL, and an electron blocking layer EBL, and an electron transport region ETR includes an electron injection layer EIL, an electron transport layer ETL, and a hole blocking layer HBL. In comparison to FIG. 3, FIG. 6 is a schematic cross-sectional view of a light-emitting element ED, in which a hole transport region HTR includes a hole injection layer HIL, a hole transport layer HTL, and an emission-auxiliary layer EAL, and an electron transport region ETR includes an electron injection layer EIL, an electron transport layer ETL, and a hole blocking layer HBL. In comparison to FIG. 4, FIG. 7 is a schematic cross-sectional view of a light-emitting element ED, in which a capping layer CPL is disposed on a second electrode EL2.

The first electrode EL1 has conductivity. The first electrode EL1 may be formed of a metal material, a metal alloy, or a conductive compound. The first electrode EL1 may be an anode or a cathode. However, embodiments are not limited thereto. In an embodiment, the first electrode EL1 may be a pixel electrode. The first electrode EL1 may be a transmissive electrode, a transflective electrode, or a reflective electrode. The first electrode EL1 may include at least one of Ag, Mg, Cu, Al, Pt, Pd, Au, Ni, Nd, Ir, Cr, Li, Ca, LiF, Mo, Ti, W, In, Sn, Zn, an oxide thereof, a compound thereof, and a mixture thereof.

If the first electrode EL1 is a transmissive electrode, the first electrode EL1 may include a transparent metal oxide such as indium tin oxide (ITO), indium zinc oxide (IZO), zinc oxide (ZnO), or indium tin zinc oxide (ITZO). If the first electrode EL1 is a transflective electrode or a reflective electrode, the first electrode EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, a compound thereof, or a mixture thereof (e.g., a mixture of Ag and Mg). In another embodiment, the first electrode EL1 may have a multilayered structure that includes a reflective film or a transflective film formed of the above-described materials, and a transparent conductive film formed of ITO, IZO, ZnO, ITZO, *etc.* For example, the first electrode EL1 may have a three-layered structure of ITO/Ag/ITO, but embodiments are not limited thereto. In an embodiment, the first electrode EL1 may include the above-described metal materials, combinations of at least two of the above-described metal materials, oxides of the above-described metal materials, or the like. A thickness of the first electrode EL1 may be in a range of about 700 Å to about 10,000 Å. For example, the thickness of the first electrode EL1 may be in a range of about 1,000 Å to about 3,000 Å.

The hole transport region HTR may be provided on the first electrode EL1. The hole transport region HTR may include at least one of a hole injection layer HIL, a hole transport layer HTL, a buffer layer (not shown), an emission-auxiliary layer EAL, and an electron blocking layer EBL. A thickness of the hole transport region HTR may be, for example, in a range of about 50 Å to about 15,000 Å.

The hole transport region HTR may have a structure consisting of a layer consisting of a single material, a structure consisting of a layer including different materials, or a structure including multiple layers including different materials.

For example, the hole transport region HTR may have a single-layered structure of a hole injection layer HIL or a hole transport layer HTL, or the hole transport region HTR may have a single-layered structure formed of a hole injection material and a hole transport material. In embodiments, the hole transport region HTR may have a hole injection layer HIL/hole transport layer HTL structure, a hole injection layer HIL/hole transport layer HTL/emission-auxiliary layer EAL structure, a hole injection layer HIL/emission-auxiliary layer EAL structure, a hole transport layer HTL/emission-auxiliary layer EAL structure, or a hole injection layer HIL/hole transport layer HTL/electron blocking layer EBL structure, in which the layers of each structure are stacked in its respective stated order from the first electrode EL1, but embodiments are not limited thereto.

The hole transport region HTR may be formed using various methods such as a vacuum deposition method, a spin coating method, a cast method, a Langmuir-Blodgett (LB) method, an inkjet printing method, a laser printing method, and a laser induced thermal imaging (LITI) method.

In the light-emitting element ED according to an embodiment, the hole transport region HTR may include a compound represented by Formula H-1:

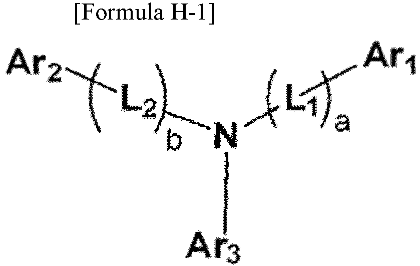

In Formula H-1, L₁ and L₂ may each independently be a direct linkage, a substituted or unsubstituted arylene group having 6 to 30 ring-forming carbon atoms, or a substituted or unsubstituted heteroarylene group having 2 to 30 ring-forming carbon atoms. In Formula H-1, a and b may each independently be an integer from 0 to 10. When a or b is 2 or greater, multiple L₁ or multiple L₂ may each independently be a substituted or unsubstituted arylene group having 6 to 30 ring-forming carbon atoms or a substituted or unsubstituted heteroarylene group having 2 to 30 ring-forming carbon atoms.

In Formula H-1, Ar₁ and Ar₂ may each independently be a substituted or unsubstituted aryl group having 6 to 30 ring-forming carbon atoms or a substituted or unsubstituted heteroaryl group having 2 to 30 ring-forming carbon atoms. In Formula H-1, Ar₃ may be a substituted or unsubstituted aryl group having 6 to 30 ring-forming carbon atoms or a substituted or unsubstituted heteroaryl group having 2 to 30 ring-forming carbon atoms.

In an embodiment, the compound represented by Formula H-1 may be a monoamine compound. In another embodiment, the compound represented by Formula H-1 may be a diamine compound in which at least one of Ar₁ to Ar₃ includes an amine group as a substituent. In an embodiment, the compound represented by Formula H-1 may be a carbazole-based compound in which at least one of Ar₁ and Ar₂ includes a substituted or unsubstituted carbazole group, or may be a fluorene-based compound in which at least one of Ar₁ and Ar₂ includes a substituted or unsubstituted fluorene group.

The compound represented by Formula H-1 may be any compound selected from Compound Group H. However, the compounds listed in Compound Group H are only examples, and a compound represented by Formula H-1 is not limited to Compound Group H:

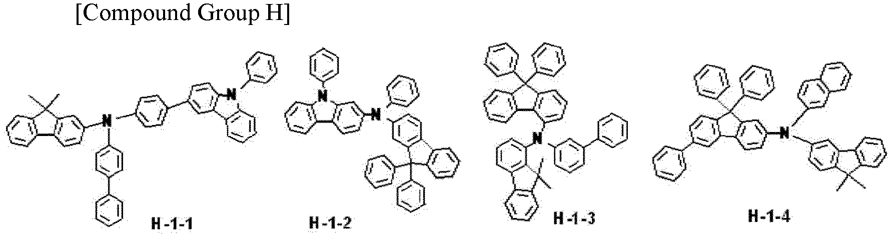

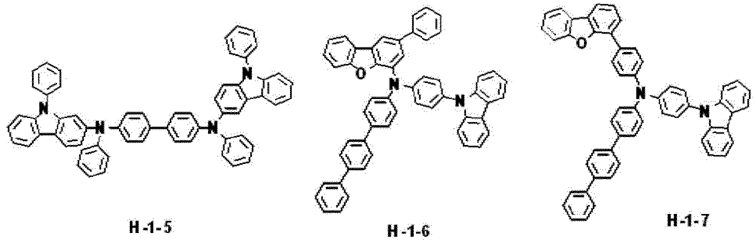

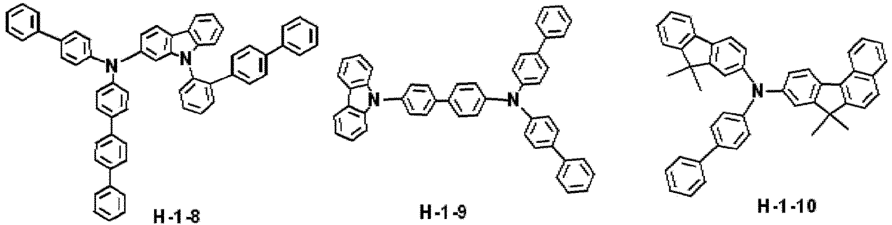

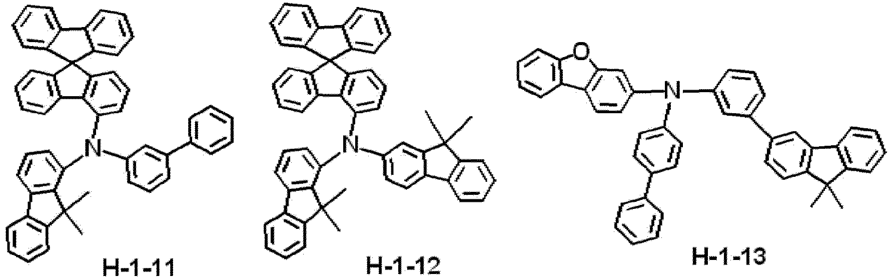

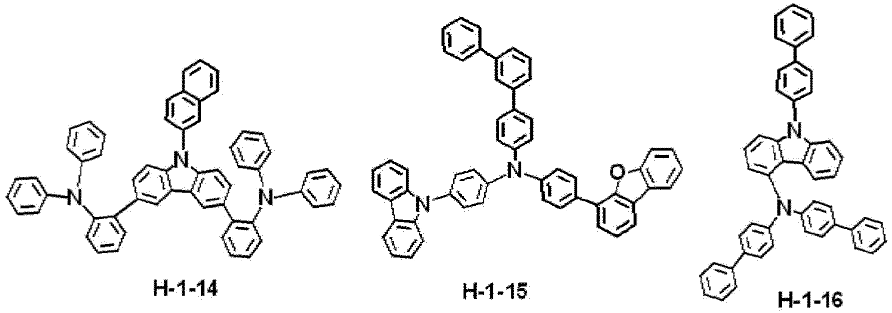

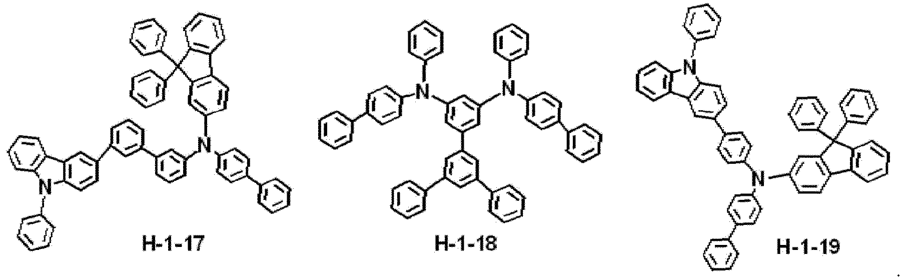

The hole transport region HTR may include a phthalocyanine compound such as copper phthalocyanine, N¹,N^{1'}-([1,1'-biphenyl]-4,4'-diyl)bis(N¹-phenyl- N⁴,N⁴-di-m-tolylbenzene-1,4-diamine) (DNTPD), 4,4',4"-[tris(3-methylphenyl)phenylamino] triphenylamine (m-MTDATA), 4,4',4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalene-1-yl)-N,N'-diphenyl-benzidine (NPB), triphenylamine-containing polyetherketone (TPAPEK), 4-isopropyl-4'-methyldiphenyliodonium [tetrakis(pentafluorophenyl)borate], dipyrazino[2,3-f: 2',3'-h]quinoxaline-2,3,6,7,10,11-hexacarbonitrile (HAT-CN), 2SiTrzPh, *etc.*

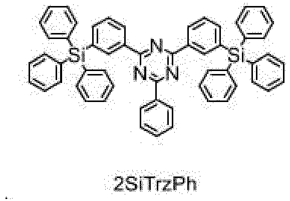

The hole transport region HTR may include a carbazole-based derivative such as N-phenyl carbazole or polyvinyl carbazole, a fluorene-based derivative, a triphenylamine-based derivative such as N,N'-bis(3-methylphenyl)-N,N'-diphenyl-[1,1-biphenyl]-4,4'-diamine (TPD) 4,4',4''-tris(N-carbazolyl)triphenylamine (TCTA), N,N'-di(naphthalene-1-yl)-N,N'-diphenyl-benzidine (NPB), 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), or 1,3-bis(N-carbazolyl)benzene (mCP), *etc.*

In an embodiment, the hole transport region HTR may include 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), etc.

The hole transport region HTR may include the above-described compounds of the hole transport region HTR in at least one of a hole injection layer HIL, a hole transport layer HTL, an emission-auxiliary layer EAL, and an electron blocking layer EBL.

A thickness of the hole transport region HTR may be in a range of about 100 Å to about 10,000 Å. For example, the thickness of the hole transport region HTR may be in a range of about 100 Å to about 5,000 Å. When the hole transport region HTR includes a hole injection layer HIL, the hole injection layer HIL may have a thickness in a range of about 30 Å to about 1,000 Å. When the hole transport region HTR includes a hole transport layer HTL, the hole transport layer HTL may have a thickness in a range of about 250 Å to about 1,000 Å. When the hole transport region HTR includes an electron blocking layer EBL, the electron blocking layer EBL may have a thickness in a range of about 10 Å to about 1,000 Å. If the thicknesses of the hole transport region HTR, the hole injection layer HIL, the hole transport layer HTL and the electron blocking layer EBL satisfy the above-described ranges, satisfactory hole transport properties may be achieved without a substantial increase in driving voltage.

The hole transport region HTR may further include a charge generating material to increase conductivity, in addition to the above-described materials. The charge generating material may be dispersed uniformly or non-uniformly in the hole transport region HTR. The charge generating material may be, for example, a p-dopant. The p-dopant may include at least one of a metal halide, a quinone derivative, a metal oxide, and a cyano group-containing compound, but embodiments are not limited thereto. For example, the p-dopant may include a metal halide such as CuI or RbI, a quinone derivative such as tetracyanoquinodimethane (TCNQ) or 2,3,5,6-tetrafluoro-7,7,8,8-tetracyanoquinodimethane (F4-TCNQ), a metal oxide such as tungsten oxide or molybdenum oxide, a cyano group-containing compound such as dipyrazino[2,3-f: 2',3'-h] quinoxaline-2,3,6,7,10,11-hexacarbonitrile (HAT-CN) or 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), *etc.,* but embodiments are not limited thereto.

As described above, the hole transport region HTR may further include at least one of an emission-auxiliary layer EAL and an electron blocking layer EBL, in addition to a hole injection layer HIL and a hole transport layer HTL. The emission-auxiliary layer EAL may compensate for a resonance distance according to a wavelength of light emitted from the light-emitting layer EML, and may increase light emission efficiency by controlling hole charge balance. The emission-auxiliary layer EAL may prevent electron injection to the hole transport region HTR. A material that may be included in the hole transport region HTR may be included in the emission-auxiliary layer EAL. The electron blocking layer EBL may prevent electron injection from the electron transport region ETR to the hole transport region HTR.

The light-emitting layer EML may include a first compound. In a light-emitting element ED according to an embodiment, the light-emitting layer EML may include the first compound according to an embodiment, and may further include at least one of a second compound, a third compound, and a fourth compound. The second compound may include a condensed tricyclic moiety that includes a nitrogen atom as a ring-forming atom. The third compound may include a six-membered heterocyclic group that includes at least one nitrogen atom as a ring-forming atom. The fourth compound may include an organometallic complex. The second to fourth compounds will be described in more detail later.

In the specification, the first compound may be referred to as a polycyclic compound according to an embodiment. The polycyclic compound includes, as a central structure, a condensed ring including two nitrogen (N) atoms and a boron (B) atom as ring-forming atoms. The polycyclic compound includes a biphenyl derivative and a triptycene group as bulky sterically protective substituents. In the polycyclic compound, the biphenyl derivative is connected to each of the two nitrogen atoms that constitute the central structure. The triptycene group may be directly connected to the central structure, or may be connected via a linker, or may be additionally condensed to the central structure. When the triptycene group is directly connected to the condensed ring central structure, the triptycene group may be connected to a benzene ring of the condensed ring central structure. When the triptycene group is connected to the condensed ring central structure via a linker, the linker may be the biphenyl derivative as described above. The triptycene group may be substituted with a deuterium atom, an alkyl group, an aryl group, or the like, or it may not be substituted.

Since the polycyclic compound includes the triptycene group and the biphenyl derivative which are sterically bulky, intermolecular interactions which may cause reduction of luminous efficiency, such as aggregation of polycyclic compound molecules and excimer formation between molecules, may decrease, and thus excellent material stability may be exhibited.

Since the central structure of the polycyclic compound includes a boron (B) atom and has multiple resonance and light emission properties, protection of the central structure is desirable so as to suppress Dexter energy transfer. The polycyclic compound has a configuration in which the central structure is protected by sterically bulky substituents, such as the biphenyl derivative and the triptycene group, and thus that p-orbitals of the boron (B) atom, which is part of the central structure, may be sufficiently protected to increase material stability.

The polycyclic compound according to an embodiment may have decreased molecular planarity due to its structural features, and thus intermolecular distance may increase to suppress Dexter energy transfer and undesirable molecular interactions, such as triplet-triplet annihilation (TTA) or triplet exciton-polaron quenching (TPQ), thereby having excellent stability while it is used for light emission. Thus, the polycyclic compound according to an embodiment may have reduced synthesis reaction time and complexity, and may contribute to cost reduction.

The light-emitting element ED may include the polycyclic compound according to an embodiment in the light-emitting layer EML. The polycyclic compound according to an embodiment is represented by Formula 1:

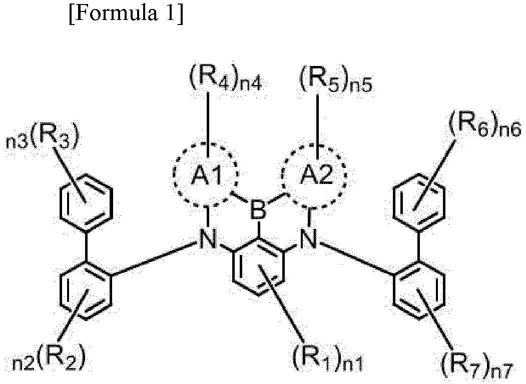

In Formula 1, ring A1 and ring A2 are each independently a substituted or unsubstituted hydrocarbon ring having a ring-forming carbon number of 6 to 30 (e.g. 6 to 20) or a substituted or unsubstituted heterocycle having a ring-forming carbon number of 5 to 30 (e.g. 5 to 20). For example, ring A1 and ring A2 may each independently be a substituted or unsubstituted phenyl group, a substituted or unsubstituted dibenzofuran group, a substituted or unsubstituted dibenzothiophene group, a substituted or unsubstituted indolocarbazole group, or a substituted or unsubstituted triptycene group.

In Formula 1, R₁ to R₇ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60 (e.g. 1 to 20), a substituted or unsubstituted cycloalkyl group having a ring-forming carbon number of 3 to 60 (e.g. 3 to 20), a substituted or unsubstituted alkenyl group having a carbon number of 2 to 60 (e.g. 2 to 20), a substituted or unsubstituted aryl group having a ring-forming carbon number of 6 to 60 (e.g. 6 to 30), or a substituted or unsubstituted heteroaryl group having a ring-forming carbon number of 2 to 60 (e.g. 2 to 20), or combined with an adjacent group to form a ring.

For example, R₁ to R₇ may each independently be a hydrogen atom, a deuterium atom, a substituted or unsubstituted t-butyl group, a substituted or unsubstituted phenyl group, a substituted or unsubstituted biphenyl group, a substituted or unsubstituted triptycene group, a substituted or unsubstituted diphenylamine group, or a group represented by Formula S-1:

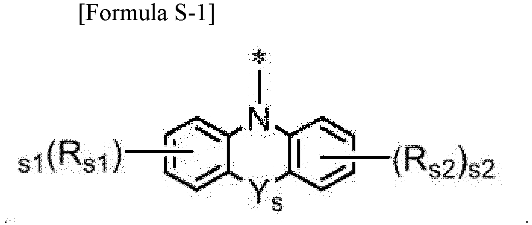

In Formula S-1, Yₛ may be a direct linkage, C(Rₛ₃)(Rₛ₄), or Si(Rₛ₅)(Rₛ₆). In Formula S-1, -* represents a position connected to the polycyclic compound according to an embodiment. For example, -* may represent a position connected to Formula 1.

In Formula S-1, Rₛ₁ to Rₛ₆ may each independently be a hydrogen atom, a deuterium atom, a cyano group, a substituted or unsubstituted oxy group, a substituted or unsubstituted alkyl group having a carbon number of 1 to 15, a substituted or unsubstituted alkenyl group having a carbon number of 2 to 15, a substituted or unsubstituted aryl group having a ring-forming carbon number of 6 to 30, or a substituted or unsubstituted heteroaryl group having a ring-forming carbon number of 5 to 30, or combined with an adjacent group to form a ring. For example, Rₛ₁ to Rₛ₆ may each independently be a hydrogen atom, a deuterium atom, a substituted or unsubstituted t-butyl group, a substituted or unsubstituted phenyl group, a substituted or unsubstituted biphenyl group, a substituted or unsubstituted carbazole group, or a substituted or unsubstituted dibenzofuran group. In Formula S-1, s1 and s2 may each independently be an integer selected from 0 to 4. A case in which s1 and s2 are each 4, and four Rₛ₁ and four Rₛ₂ are all hydrogen atoms may be the same as a case in which s1 and s2 are each 0. When s1 and s2 are each 2 or more, multiple Rₛ₁ and multiple Rₛ₂ may be the same as each other, or at least one thereof may be different from the remainder.

In Formula S1, s1 and s2 may each independently be an integer from 0 to 4.

In an embodiment, in Formula 1, R₁ to R₇ may each independently be a group selected from Substituent Group 1, but embodiments are not limited thereto.

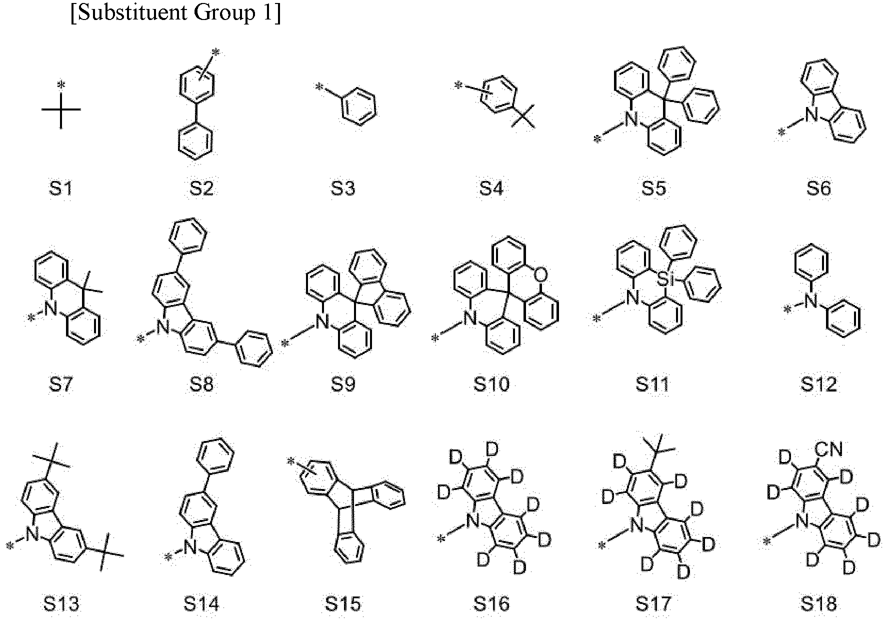

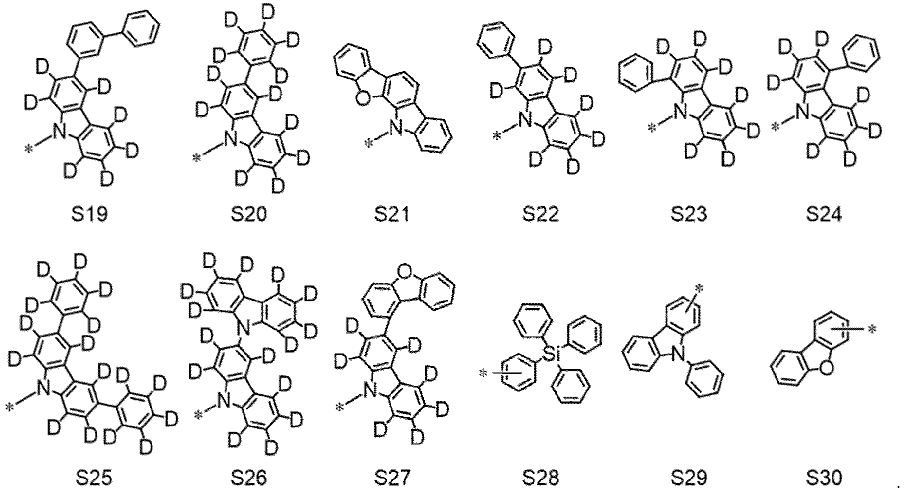

In Substituent Group 1, D represents a hydrogen atom, and -* represents a position connected to the polycyclic compound according to an embodiment. For example, 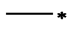 may represent a position connected to Formula 1.

In Formula 1, n1 is an integer from 0 to 3. When n1 is 0, the polycyclic compound not substituted with R₁. A case in which n1 is 3, and three R₁ are all hydrogen atoms may be the same as a case in which n1 is 0. When n1 is 2 or more, multiple R₁ may be the same as each other, or at least one thereof may be different from the remainder.

In Formula 1, n2 and n7 are each independently an integer from 0 to 4. When n2 and n7 are each 0, the polycyclic compound is not substituted with R₂ and R₇, respectively. A case in which n2 and n7 are each 4, and four R₂ and four R₇ are all hydrogen atoms may be the same as a case in which n2 and n7 are each 0. When n2 and n7 are each 2 or more, multiple R₂ and multiple R₇ may be the same as each other, or at least one thereof may be different from the remainder.

In Formula 1, n3 and n6 are each independently an integer from 0 to 5. When n3 and n6 are each 0, the polycyclic compound is not substituted with R₃ and R₆, respectively. A case in which n3 and n6 are each 5, and five R₃ and five R₆ are all hydrogen atoms may be the same as a case in which n3 and n6 are each 0. When n3 and n6 are each 2 or more, multiple R₃ and multiple R₆ may be the same as each other, or at least one thereof may be different from the remainder.

In Formula 1, n4 and n5 are each independently an integer from 0 to 14. When n4 and n5 are each 0, the polycyclic compound is not substituted with R₄ and R₅, respectively. A case in which n4 and n5 are each 14 and fourteen R₄ and fourteen R₅ are all hydrogen atoms may be the same as a case in which n4 and n5 are each 0. When n4 and n5 are each 2 or more, multiple R₄ and multiple R₅ may be the same as each other, or at least one thereof may be different from the remainder.

In Formula 1, at least one of ring A1, ring A2, and R₁ to R₇ is each independently a substituted or unsubstituted triptycene group. For example, at least one of ring A1 and ring A2 may each independently be a substituted or unsubstituted triptycene group, or at least one of R₁ to R₇ may each independently be a substituted or unsubstituted triptycene group. For example, at least one of ring A1 and ring A2 may each independently be a substituted or unsubstituted triptycene group, and at least one of R₁ to R₇ may each independently be a substituted or unsubstituted triptycene group.

In embodiments, the substituted or unsubstituted triptycene group in the polycyclic compound may be represented by Formula a:

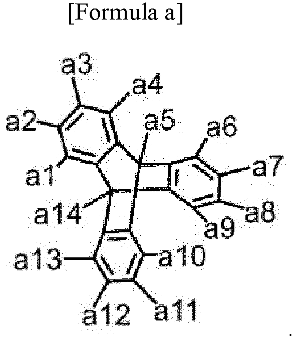

In Formula 1, when ring A1 and/or ring A2 is the group represented by Formula a, an adjacent pair among a1 to a14 of Formula a may be connected to the central structure of the polycyclic compound represented by Formula 1. For example, a1 and a2, a3 and a4, a6 and a7, a8 and a9, a10 and a11, or a12 and a13 may be connected to a boron atom and a nitrogen atom of Formula 1, but embodiments are not limited thereto.

When at least one of R₁ to R₇ is the group represented by Formula a, one of a1 to a14 of Formula a may be connected to Formula 1. For example, one of a1 to a14 of Formula a may be connected to a benzene ring of the polycyclic compound represented by Formula 1. For example, a2, a3, a7, a8, a11, or a12 in Formula a may be a position connected to Formula 1, but embodiments are not limited thereto.

In Formula a, the remainder of a1 to a14 that are not a position connected to Formula 1 may each independently be a hydrogen atom, a deuterium atom, a substituted or unsubstituted alkyl group having a carbon number of 1 to 30 (e.g. 1 to 20), or a substituted or unsubstituted aryl group having a ring-forming carbon number of 6 to 30 (e.g. 6 to 20). In an embodiment, the remainder of a1 to a14 that are not a position connected to Formula 1 may each be a hydrogen atom, but embodiments are not limited thereto.

The polycyclic compound includes a substituted or unsubstituted triptycene group, which sterically protects the central structure that includes a boron (B) atom, and thus intermolecular distance may be increased to prevent undesirable intermolecular interactions. Accordingly, the light-emitting element ED according to an embodiment using the polycyclic compound as a light-emitting material may exhibit excellent luminous efficiency and long lifespan characteristics.

In an embodiment, in the polycyclic compound represented by Formula 1, at least one hydrogen atom may be substituted with a deuterium atom. For example, in the polycyclic compound represented by Formula 1, such deuterium substitution does not only apply to a hydrogen atom of the central structure or to the biphenyl derivative connected to the central structure, and any hydrogen atom of any substituent of the central structure may be substituted with a deuterium atom.

The polycyclic compound according to an embodiment may include a substituted or unsubstituted triptycene group that is directly bonded to or combined with the central structure, or that is connected to the condensed ring central structure via the biphenyl derivative. In an embodiment, the polycyclic compound represented by Formula 1 may be represented by Formula 2:

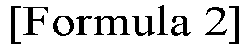

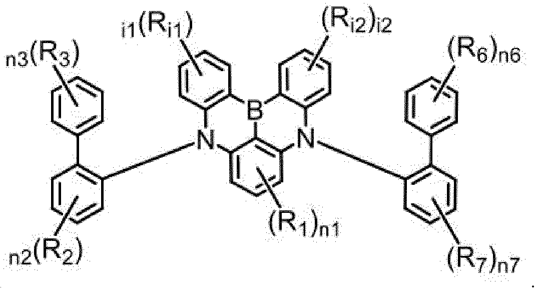

In Formula 2, Rᵢ₁ and Rᵢ₂ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60 (e.g. 1 to 20), a substituted or unsubstituted cycloalkyl group having a ring-forming carbon number of 3 to 60 (e.g. 3 to 20), a substituted or unsubstituted alkenyl group having a carbon number of 2 to 60 (e.g. 2 to 20), a substituted or unsubstituted aryl group having a ring-forming carbon number of 6 to 60 (e.g. 6 to 30), or a substituted or unsubstituted heteroaryl group having a ring-forming carbon number of 2 to 60 (e.g. 2 to 30), or combined with an adjacent group to form a ring.

For example, Rᵢ₁ and Rᵢ₂ may each independently be a hydrogen atom, a deuterium atom, a substituted or unsubstituted amine group, a substituted or unsubstituted aryl group having a ring-forming carbon number of 6 to 30, or a substituted or unsubstituted heteroaryl group having a ring-forming carbon number of 2 to 30 (e.g. 2 to 20). For example, Rᵢ₁ and Rᵢ₂ may each independently be a hydrogen atom, a deuterium atom, a substituted or unsubstituted phenyl group, a substituted or unsubstituted triptycene group, a substituted or unsubstituted diphenylamine group, or a group represented by Formula S-1, as described above. In an embodiment, Rᵢ₁ and Rᵢ₂ may each independently be a group selected from Substituent Group 1 as described above, but embodiments are not limited thereto.

In an embodiment, an adjacent pair of Rᵢ₁ or an adjacent pair of Rᵢ₂ may combine with each other to form a hydrocarbon ring or a heterocycle. For example, a pair of adjacent Rᵢ₁ may combine with each other to form a hydrocarbon ring or a heterocycle, and a pair of adjacent Rᵢ₂ may combine with each other to form a hydrocarbon ring or a heterocycle.

In Formula 2, i1 and i2 are each independently an integer from 0 to 4. When i1 and i2 are each 0, the polycyclic compound is not substituted with Rᵢ₁ and Rᵢ₂, respectively. A case in which i1 and i2 are each 4, and four Rᵢ₁ and four Rᵢ₂ are all hydrogen atoms may be the same as a case in which i1 and i2 are each 0. When i1 and i2 are each 2 or more, multiple Rᵢ₁ and multiple Rᵢ₂ may be the same as each other, or at least one thereof may be different from the remainder.

In Formula 2, R₁ to R₃, R₆, R₇, n1 to n3, n6, and n7 are the same as defined in Formula 1.

The polycyclic compound represented by Formula 2 includes at least one substituted or unsubstituted triptycene group. In embodiments, at least one of Rᵢ₁, Rᵢ₂, R₁ to R₃, R₆, and R₇ is each independently a group represented by Formula a as described above. For example, one of a1 to a14 may be a position connected to Formula 2, and the remainder of a1 to a14 may each independently be a hydrogen atom, a deuterium atom, a substituted or unsubstituted alkyl group having a carbon number of 1 to 30 (e.g. 1 to 20), or a substituted or unsubstituted aryl group having a ring-forming carbon number of 6 to 30 (e.g. 6 to 20). For example, a1 to a14 may each be a hydrogen atom, except for the position connected to Formula 2, but embodiments are not limited thereto.

In an embodiment, the polycyclic compound represented by Formula 2 may be represented by Formula 2-1 or Formula 2-2:

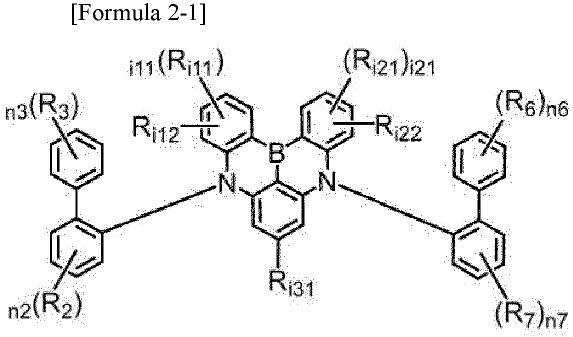

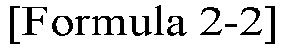

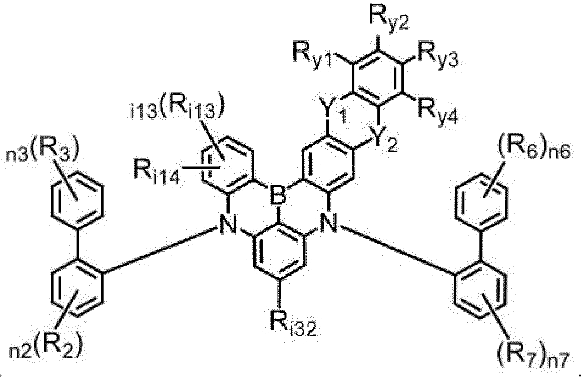

In Formula 2-1, Rᵢ₁₁ and Rᵢ₂₁ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60 (e.g. 1 to 20), a substituted or unsubstituted cycloalkyl group having a ring-forming carbon number of 3 to 60 (e.g. 3 to 20), a substituted or unsubstituted alkenyl group having a carbon number of 2 to 60 (e.g. 2 to 20), a substituted or unsubstituted aryl group having a ring-forming carbon number of 6 to 60 (e.g. 6 to 30), or a substituted or unsubstituted heteroaryl group having a ring-forming carbon number of 2 to 60 (e.g. 2 to 20), or combined with an adjacent group to form a ring. For example, Rᵢ₁₁ and Rᵢ₂₁ may each be a hydrogen atom, but embodiments are not limited thereto. For example, a pair of adjacent Rᵢ₁₁ may combine with each other to form a hydrocarbon ring, and a pair of adjacent Rᵢ₂₁ may combine with each other to form a hydrocarbon ring.

In Formula 2-1, Rᵢ₁₂, Rᵢ₂₂, and Rᵢ₃₁ may each independently be a substituted or unsubstituted amine group, a substituted or unsubstituted alkyl group having a carbon number of 1 to 30 (e.g. 1 to 20), a substituted or unsubstituted aryl group having a ring-forming carbon number of 6 to 60 (e.g. 6 to 30), or a substituted or unsubstituted heteroaryl group having a ring-forming carbon number of 2 to 60 (e.g. 2 to 30). For example, Rᵢ₁₂, Rᵢ₂₂, and Rᵢ₃₁ may each independently be a substituted or unsubstituted t-butyl group, a substituted or unsubstituted phenyl group, a substituted or unsubstituted biphenyl group, a substituted or unsubstituted triptycene group, a substituted or unsubstituted diphenylamine group, or a group represented by Formula S-1 as described above. For example, Rᵢ₁₂, Rᵢ₂₂, and Rᵢ₃₁ may each independently be a group selected from Substituent Group 1.

In an embodiment, in Formula 2-1, Rᵢ₁₂, Rᵢ₂₂, and Rᵢ₃₁ may each be connected to a benzene ring, such that they are each at a para-position with respect to the boron atom of the central structure, but embodiments are not limited thereto. In another embodiment, in Formula 2-1, at least one of Rᵢ₁₂ and Rᵢ₂₂ may be connected to a benzene ring, such that it is at a meta-position with respect to the boron atom of the central structure.

In Formula 2-1, i11 and i21 are each independently an integer from 0 to 3. When i11 and i21 are each 0, the polycyclic compound is not substituted with Rᵢ₁₁ and Rᵢ₂₁, respectively. A case in which i11 and i21 are each 3, and three Rᵢ₁₁ and three Rᵢ₂₁ are all hydrogen atoms may be the same as a case in which i11 and i21 are each 0. When i11 and i21 are each 2 or more, multiple Rᵢ₁₁ and multiple Rᵢ₂₁ may be the same as each other, or at least one thereof may be different from the remainder.

The polycyclic compound represented by Formula 2-1 may include at least one substituted or unsubstituted triptycene group. In embodiments, in Formula 2-1, at least one of Rᵢ₁₂, Rᵢ₂₂, Rᵢ₃₁, R₂, R₃, R₆, and R₇ is each independently a group represented by Formula a; and in Formula a, one of a1 to a14 may be a position connected to Formula 2-1, and the remainder of a1 to a14 may each independently be a hydrogen atom, a deuterium atom, a substituted or unsubstituted alkyl group having a carbon number of 1 to 30 (e.g. 1 to 20), or a substituted or unsubstituted aryl group having a ring-forming carbon number of 6 to 30 (e.g. 6 to 20). For example, the remainder of a1 to a14 that are not connected to Formula 2-1 may each be a hydrogen atom, but embodiments are not limited thereto.

In Formula 2-2, one of Y₁ and Y₂ is a direct linkage, and the other of Y₁ and Y₂ is N(R_{y5}), O, or S. For example, Y₁ may be a direct linkage, and Y₂ may be N(R_{y5}), O, or S. However, embodiments are not limited thereto, and Y₂ may be a direct linkage, and Y₁ may be N(R_{y5}), O, or S.

In Formula 2-2, R_{y1} to R_{y5} are each independently a hydrogen atom, a deuterium atom, a substituted or unsubstituted alkyl group having a carbon number of 1 to 30 (e.g. 1 to 20), a substituted or unsubstituted alkenyl group having a carbon number of 2 to 30 (e.g. 2 to 20), or a substituted or unsubstituted aryl group having a ring-forming carbon number of 6 to 30 (e.g. 6 to 20), or combined with an adjacent group to form a ring.

In Formula 2-2, Rᵢ₁₃ is a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60 (e.g. 1 to 20), a substituted or unsubstituted cycloalkyl group having a ring-forming carbon number of 3 to 60 (e.g. 3 to 20), a substituted or unsubstituted alkenyl group having a carbon number of 2 to 60 (e.g. 2 to 20), a substituted or unsubstituted aryl group having a ring-forming carbon number of 6 to 60 (e.g. 6 to 30), or a substituted or unsubstituted heteroaryl group having a ring-forming carbon number of 2 to 60 (e.g. 2 to 20), or combined with an adjacent group to form a ring. For example, Rᵢ₁₃ may be a hydrogen atom, but embodiments are not limited thereto. For example, an adjacent pair of Rᵢ₁₃ may combine with each other to form a hydrocarbon ring.

In Formula 2-2, Rᵢ₁₄ and Rᵢ₃₂ are each independently a substituted or unsubstituted amine group, a substituted or unsubstituted alkyl group having a carbon number of 1 to 30 (e.g. 1 to 20), a substituted or unsubstituted aryl group having a ring-forming carbon number of 6 to 60 (e.g. 6 to 30), or a substituted or unsubstituted heteroaryl group having a ring-forming carbon number of 2 to 60 (e.g. 2 to 20). For example, Rᵢ₁₄ and Rᵢ₃₂ may each independently be a substituted or unsubstituted t-butyl group, a substituted or unsubstituted phenyl group, a substituted or unsubstituted biphenyl group, a substituted or unsubstituted triptycene group, a substituted or unsubstituted diphenylamine group, or a group represented by Formula S-1 as described above. For example, Rᵢ₁₄ and Rᵢ₃₂ may each independently be a group selected from Substituent Group 1.

In an embodiment, in Formula 2-2, Rᵢ₁₄ and Rᵢ₃₂ may each be connected to a benzene ring, such that they are each at a para-position with respect to the boron atom of the central structure, but embodiments are not limited thereto. In another embodiment, in Formula 2-2, Rᵢ₁₄ may be connected to a benzene ring, such that it is at a meta-position with respect to the boron atom of the central structure.

In Formula 2-2, i13 is an integer from 0 to 3. When i13 is 0, the polycyclic compound is not substituted with Rᵢ₁₃. A case in which i13 is 3, and three Rᵢ₁₃ are all hydrogen atoms may be the same as a case in which each of i13 is 0. When i13 is 2 or more, multiple Rᵢ₁₃ may be the same as each other, or at least one thereof may be different from the remainder.

The polycyclic compound represented by Formula 2-2 includes at least one substituted or unsubstituted triptycene group. In embodiments, in Formula 2-2, at least one of Rᵢ₁₄, Rᵢ₃₂, R₂, R₃, R₆, and R₇ is each independently a group represented by Formula a; and in Formula a, one of a1 to a14 may be a position connected to Formula 2-2, and the remainder of a1 to a14 may each independently be a hydrogen atom, a deuterium atom, a substituted or unsubstituted alkyl group having a carbon number of 1 to 30 (e.g. 1 to 20), or a substituted or unsubstituted aryl group having a ring-forming carbon number of 6 to 30 (e.g. 6 to 20). For example, the remainder of a1 to a14 that are not connected to Formula 2-2 may each be a hydrogen atom, but embodiments are not limited thereto.

In Formula 2-1 and Formula 2-2, R₂, R₃, R₆, and R₇ are each the same as defined in Formula 1, in case that they are not a group represented by Formula a, and n2, n3, n6, and n7 are the same as defined in Formula 1.

The polycyclic compound may include a substituted or unsubstituted triptycene group that is condensed to the central structure. In an embodiment, the polycyclic compound represented by Formula 1 may be represented by Formula 3-1 or Formula 3-2. Formula 3-1 and Formula 3-2 each represent a case in which ring A1 or ring A2 of Formula 1 is a triptycene group.

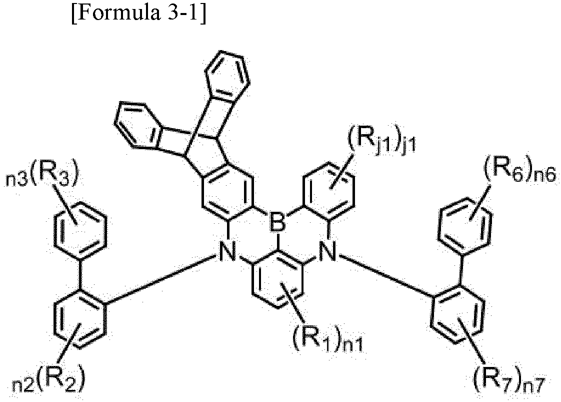

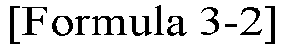

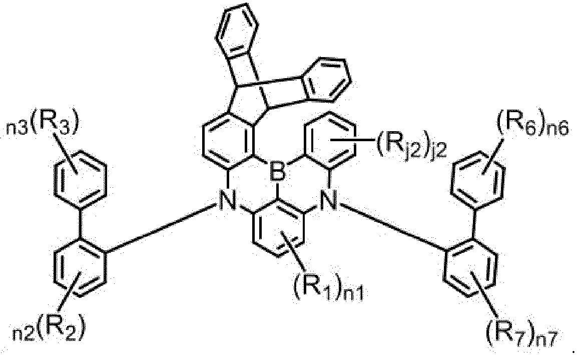

In Formulae 3-1 and 3-2, Rⱼ₁ and Rⱼ₂ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60 (e.g. 1 to 20), a substituted or unsubstituted cycloalkyl group having a ring-forming carbon number of 3 to 60 (e.g. 3 to 20), a substituted or unsubstituted alkenyl group having a carbon number of 2 to 60 (e.g. 2 to 20), a substituted or unsubstituted aryl group having a ring-forming carbon number of 6 to 30 (e.g. 6 to 20), or a substituted or unsubstituted heteroaryl group having a ring-forming carbon number of 2 to 60 (e.g. 2 to 30), or combined with an adjacent group to form a ring.

For example, Rⱼ₁ and Rⱼ₂ may each independently be a hydrogen atom, a deuterium atom, a substituted or unsubstituted amine group, a substituted or unsubstituted aryl group having a ring-forming carbon number of 6 to 30 (e.g. 6 to 20), or a substituted or unsubstituted heteroaryl group having a ring-forming carbon number of 2 to 30 (e.g. 2 to 20). For example, Rⱼ₁ and Rⱼ₂ may each independently be a hydrogen atom, a deuterium atom, a substituted or unsubstituted phenyl group, a substituted or unsubstituted triptycene group, or a substituted or unsubstituted diphenylamine group, or a group represented by Formula S-1 as described above. In an embodiment, Rⱼ₁ and Rⱼ₂ may each independently be a group selected from Substituent Group 1 as described above, but embodiments are not limited thereto.

In an embodiment, an adjacent pair of Rⱼ₁ or an adjacent pair of Rⱼ₂ may combine with each other to form a hydrocarbon ring or a heterocycle. For example, a pair of adjacent Rⱼ₁ may combine with each to form a hydrocarbon ring or a heterocycle, and a pair of adjacent Rⱼ₂ may combine with each other to form a hydrocarbon ring or a heterocycle.

In Formulae 3-1 and 3-2, j1 and j2 are each independently an integer from 0 to 4. When j1 and j2 are each 0, the polycyclic compound is not substituted with Rⱼ₁ and Rⱼ₂, respectively. A case in which j 1 and j2 are each 4, and four Rⱼ₁ and four Rⱼ₂ are each hydrogen atoms may be the same as a case in which j 1 and j2 are each 0. When j1 and j2 are each 2 or more, multiple Rⱼ₁ and multiple Rⱼ₂ may be the same as each other, or at least one thereof may be different from the remainder.

In Formulae 3-1 and 3-2, R₁ to R₃, R₆, R₇, n1 to n3, n6, and n7 are the same as defined in Formula 1.

In an embodiment, the polycyclic compound represented by Formula 3-1 may be represented by Formula 3-1-1:

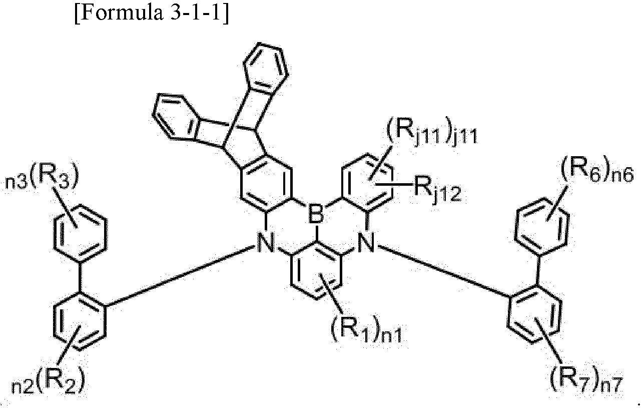

In Formula 3-1-1, Rⱼ₁₁ is a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60 (e.g. 1 to 20), a substituted or unsubstituted cycloalkyl group having a ring-forming carbon number of 3 to 60 (e.g. 3 to 20), a substituted or unsubstituted alkenyl group having a carbon number of 2 to 60 (e.g. 2 to 20), a substituted or unsubstituted aryl group having a ring-forming carbon number of 6 to 60 (e.g. 6 to 30), or a substituted or unsubstituted heteroaryl group having a ring-forming carbon number of 2 to 60 (e.g. 2 to 20), or combined with an adjacent group to form a ring. For example, Rⱼ₁₁ may be a hydrogen atom, but embodiments are not limited thereto. For example, an adjacent pair of Rⱼ₁₁ may combine with each other to form a hydrocarbon ring or heterocycle.

In Formula 3-1-1, Rⱼ₁₂ is a substituted or unsubstituted amine group, a substituted or unsubstituted aryl having a ring-forming carbon number of 6 to 30 (e.g. 6 to 20), or a substituted or unsubstituted heteroaryl group having a ring-forming carbon number of 2 to 60 (e.g. 2 to 20). For example, Rⱼ₁₂ may be a substituted or unsubstituted diphenylamine group, a substituted or unsubstituted phenyl group, a substituted or unsubstituted triptycene group, or a group represented by Formula S-1 as described above. For example, Rⱼ₁₂ may be a group selected from Substituent Group 1. In an embodiment, in Formula 3-1-1, Rⱼ₁₂ may be connected to a benzene ring, such that it is at a para-position with respect to the boron atom of the central structure, but embodiments are not limited thereto.

In Formula 3-1-1, j11 is an integer from 0 to 3. When j11 is 0, the polycyclic compound is not substituted with Rⱼ₁₁. A case in which j11 is 3, and three Rⱼ₁₁ are all hydrogen atoms may be the same as a case in which j 11 is 0. When j 11 is 2 or more, multiple Rⱼ₁₁ may be the same as each other, or at least one thereof may be different from the remainder.

In Formula 3-1-1, R₁ to R₃, R₆, R₇, n1 to n3, n6, and n7 are the same as defined in Formula 1.

In an embodiment, the polycyclic compound represented by Formula 3-2 may be represented by Formula 3-2-1:

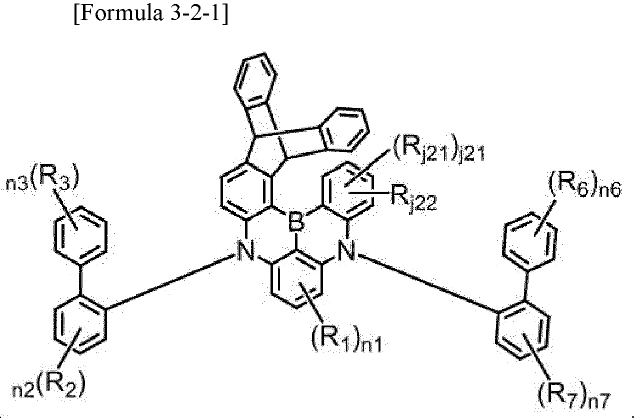

In Formula 3-2-1, Rⱼ₂₁ is a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60 (e.g. 1 to 20), a substituted or unsubstituted cycloalkyl group having a ring-forming carbon number of 3 to 60 (e.g. 3 to 20), a substituted or unsubstituted alkenyl group having a carbon number of 2 to 60 (e.g. 2 to 20), a substituted or unsubstituted aryl group having a ring-forming carbon number of 6 to 60 (e.g. 6 to 30), or a substituted or unsubstituted heteroaryl group having a ring-forming carbon number of 2 to 60 (e.g. 2 to 20), or combined with an adjacent group to form a ring. For example, Rⱼ₂₁ may be a hydrogen atom, but embodiments are not limited thereto. For example, an adjacent pair of Rⱼ₂₁ may combine with each other to form a hydrocarbon ring or heterocycle.

In Formula 3-2-1, Rⱼ₂₂ is a substituted or unsubstituted amine group, a substituted or unsubstituted aryl having a ring-forming carbon number of 6 to 30 (e.g. 6 to 20), or a substituted or unsubstituted heteroaryl group having a ring-forming carbon number of 2 to 60 (e.g. 2 to 20). For example, Rⱼ₂₂ may be a substituted or unsubstituted diphenylamine group, a substituted or unsubstituted phenyl group, a substituted or unsubstituted triptycene group, or a group represented by Formula S-1 as described above. For example, Rⱼ₂₂ may be a group selected from Substituent Group 1. In an embodiment, in Formula 3-2-1, Rⱼ₂₂ may be connected to a benzene ring, such that it is at a para-position with respect to the boron atom of the central structure, but embodiments are not limited thereto.

In Formula 3-2-1, j21 is an integer from 0 to 3. When j21 is 0, the polycyclic compound is not substituted with Rⱼ₂₁. A case in which j21 is 3, and three Rⱼ₂₁ are all hydrogen atoms may be the same as a case in which j21 is 0. When j21 is 2 or more, multiple Rⱼ₂₁ may be the same as each other, or at least one thereof may be different from the remainder.

In Formula 3-2-1, R₁ to R₃, R₆, R₇, n1 to n3, n6. and n7 are the same as defined in Formula 1.

In the polycyclic compound, a phenyl group may be connected to each of nitrogen atoms of the central structure, a substituted or unsubstituted phenyl group may be connected to the phenyl group at an ortho-position with respect to a nitrogen atom, and an alkyl group or aryl group may be additionally connected to the phenyl group at another ortho-position with respect to the nitrogen atom. In an embodiment, the polycyclic compound represented by Formula 1 may be represented by Formula 4:

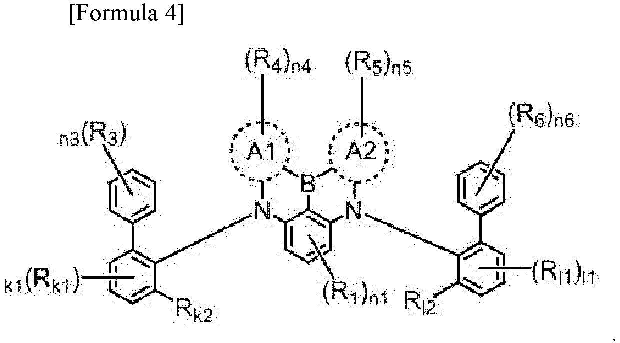

In Formula 4, Rₖ₁ and Rₗ₁ are each independently a hydrogen atom, a deuterium atom, a substituted or unsubstituted alkyl group having a carbon number of 1 to 10 (e.g. 1 to 5), or a substituted or unsubstituted aryl group having a ring-forming carbon number of 6 to 30 (e.g. 6 to 20). For example, Rₖ₁ and Rₗ₁ may each independently be a hydrogen atom, a deuterium atom, a substituted or unsubstituted t-butyl group, or a substituted or unsubstituted phenyl group.

In Formula 4, Rₖ₂ and Rₗ₂ are each independently a substituted or unsubstituted alkyl group having a carbon number of 1 to 10 (e.g. 1 to 5) or a substituted or unsubstituted aryl group having a ring-forming carbon number of 6 to 30 (e.g. 6 to 20). For example, Rₖ₂ and Rₗ₂ may each independently be a substituted or unsubstituted t-butyl group, a substituted or unsubstituted phenyl group, a substituted or unsubstituted biphenyl group, or a substituted or unsubstituted triptycene group.

In Formula 4, k1 and l1 are each independently an integer from 0 to 3. When k1 and l1 are each 0, the polycyclic compound is not substituted with Rₖ₁ and Rₗ₁, respectively. A case in which k1 and l1 are each 3 and three Rₖ₁ and three Rₗ₁ are all hydrogen atoms may be the same as a case in which k1 and l1 are each 0. When k1 and l1 are each 2 or more, multiple Rₖ₁ and multiple Rₗ₁ may be the same as each other, or at least one thereof may be different from the remainder.

In Formula 4, at least one of ring A1, ring A2, R₁, R₃ to R₆, Rₖ₂, and R₁₂ is each independently a substituted or unsubstituted triptycene group. In an embodiment, one, two, or three selected from ring A1, ring A2, R₁, R₃ to R₆, Rₖ₂, and R₁₂ may each independently be a substituted or unsubstituted triptycene group. When any of ring A1, ring A2, R₁, R₃ to R₆, Rₖ₂, and R₁₂ is a substituted or unsubstituted triptycene group, the substituted or unsubstituted triptycene group may be a group represented by Formula a.

In Formula 4, ring A1, ring A2, R₁, and R₃ to R₆ are each the same as defined in Formula 1, in case that they are not a substituted or unsubstituted triptycene group. In Formula 4, n1 and n3 to n6 are the same as defined in Formula 1.

The polycyclic compound according to an embodiment includes a biphenyl derivative directly bonded to each of the nitrogen atoms of the central structure, and a triptycene group bonded to or additionally condensed with a benzene ring of the central structure to sterically protect the central structure. The polycyclic compound according to an embodiment includes the biphenyl derivative and the triptycene group as sterically bulky substituents to reduce or inhibit undesirable intermolecular interactions, and thus excellent material stability may be exhibited. Accordingly, the polycyclic compound may contribute to performance of high efficiency and long lifespan of the light-emitting element ED.

In an embodiment, the polycyclic compound represented by Formula 1 may be any compound selected from Compound Group 1. In an embodiment, the light-emitting element ED may include at least one compound selected from Compound Group 1. In an embodiment, in the light-emitting element ED, the first compound may include at least one compound selected from Compound Group 1. In Compound Group 1, D represents a deuterium atom.

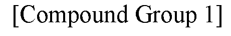

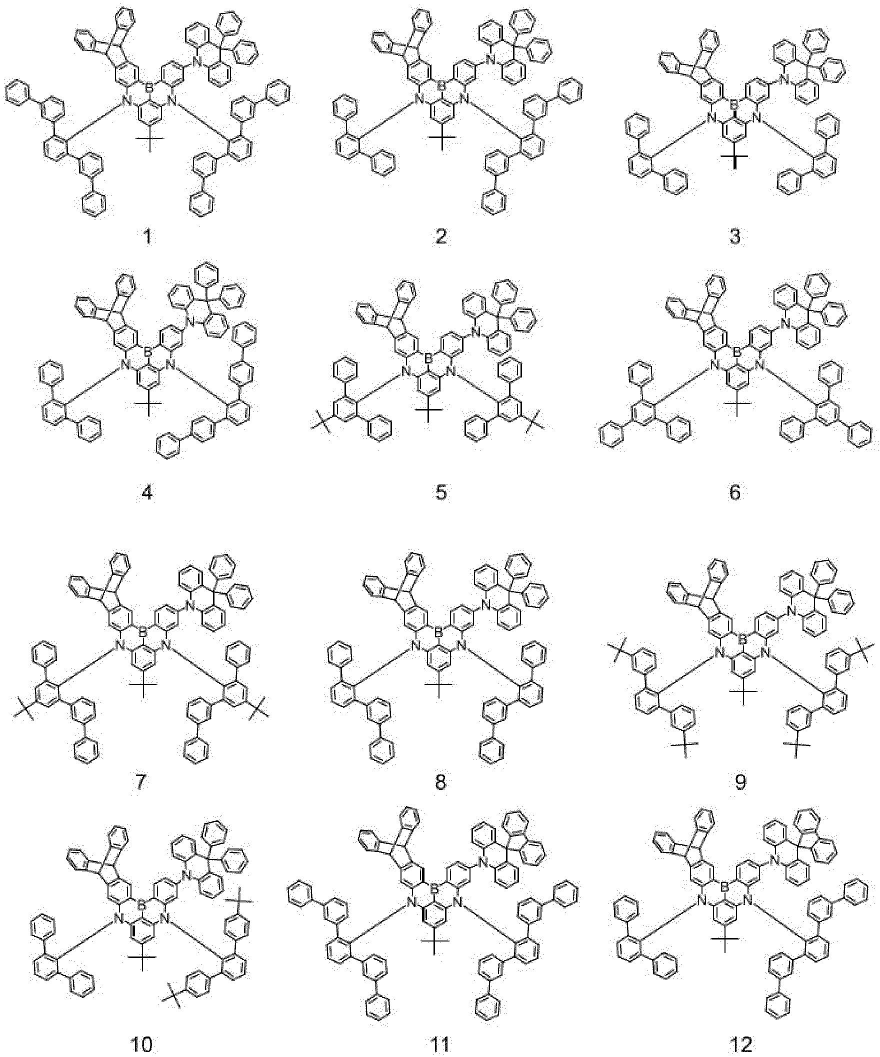

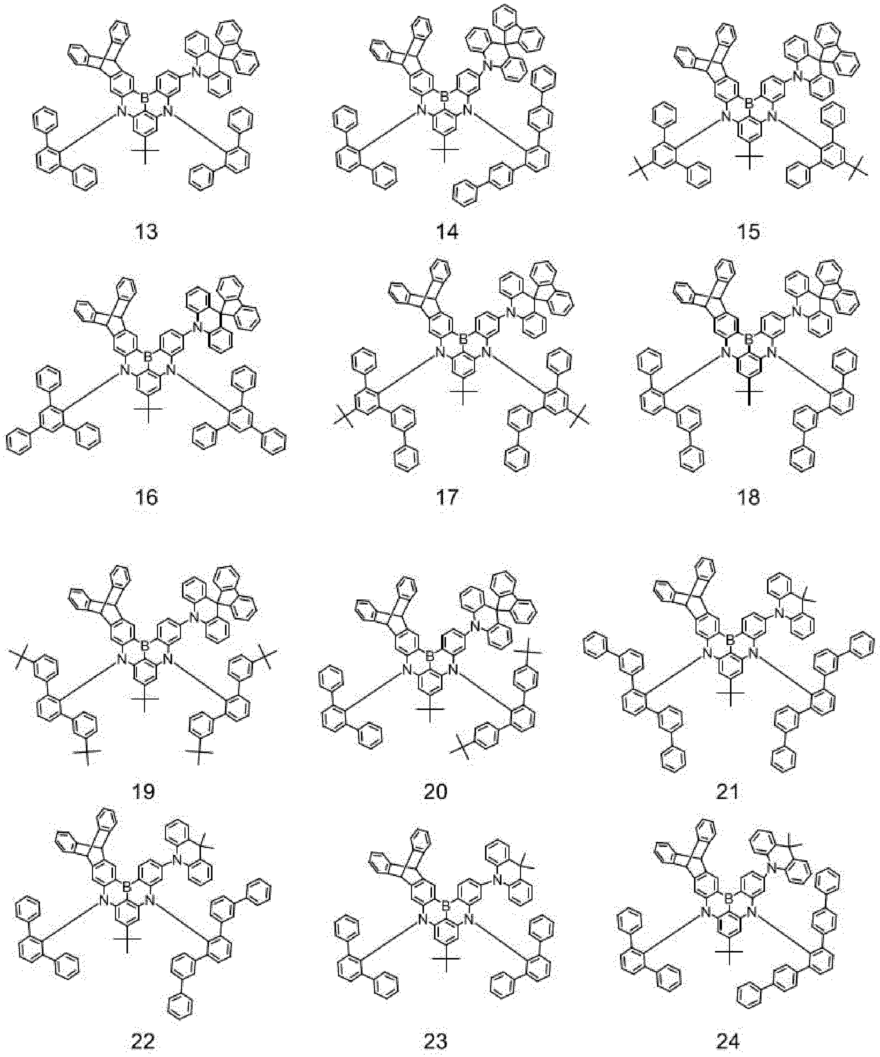

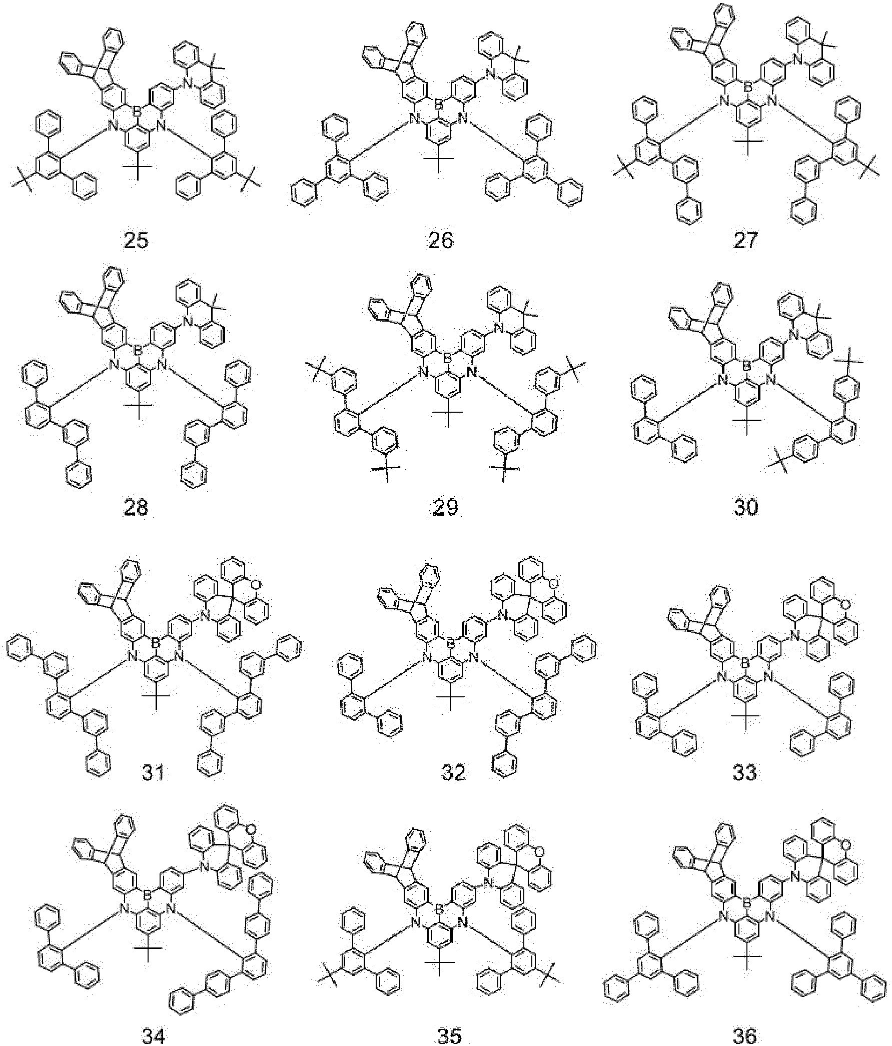

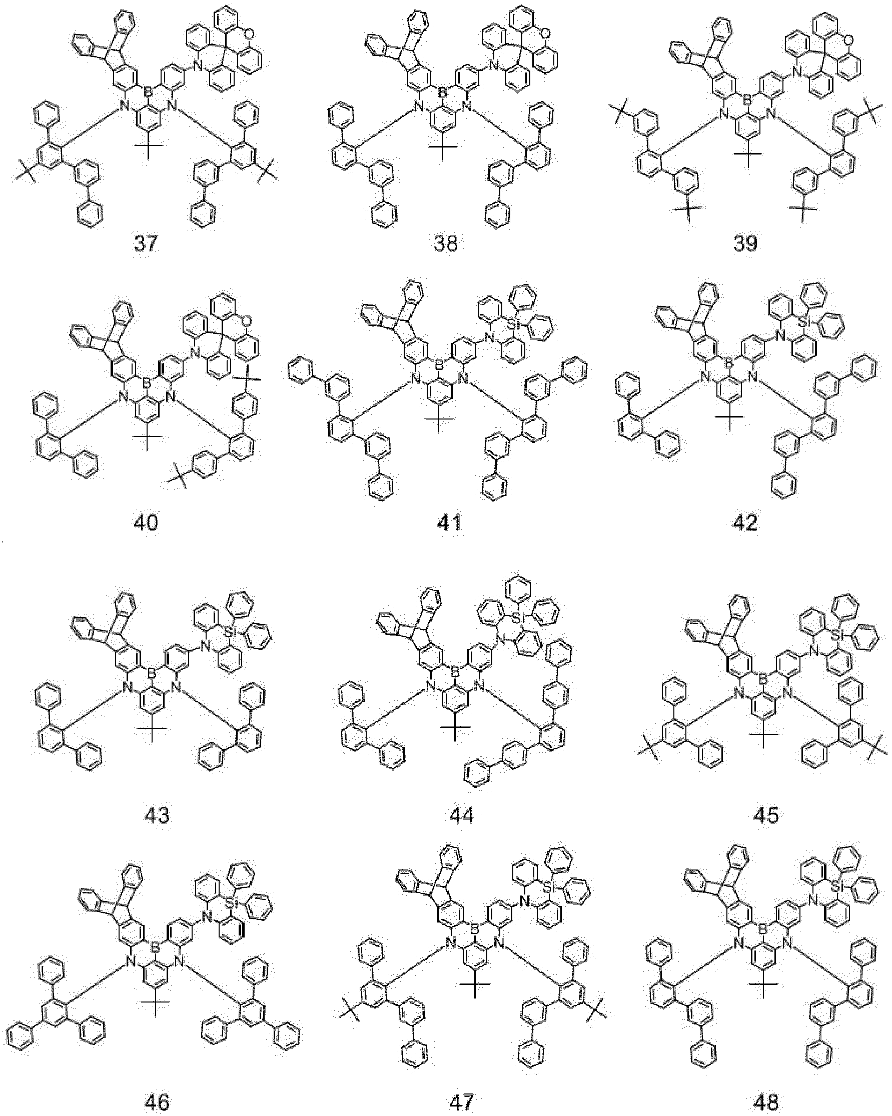

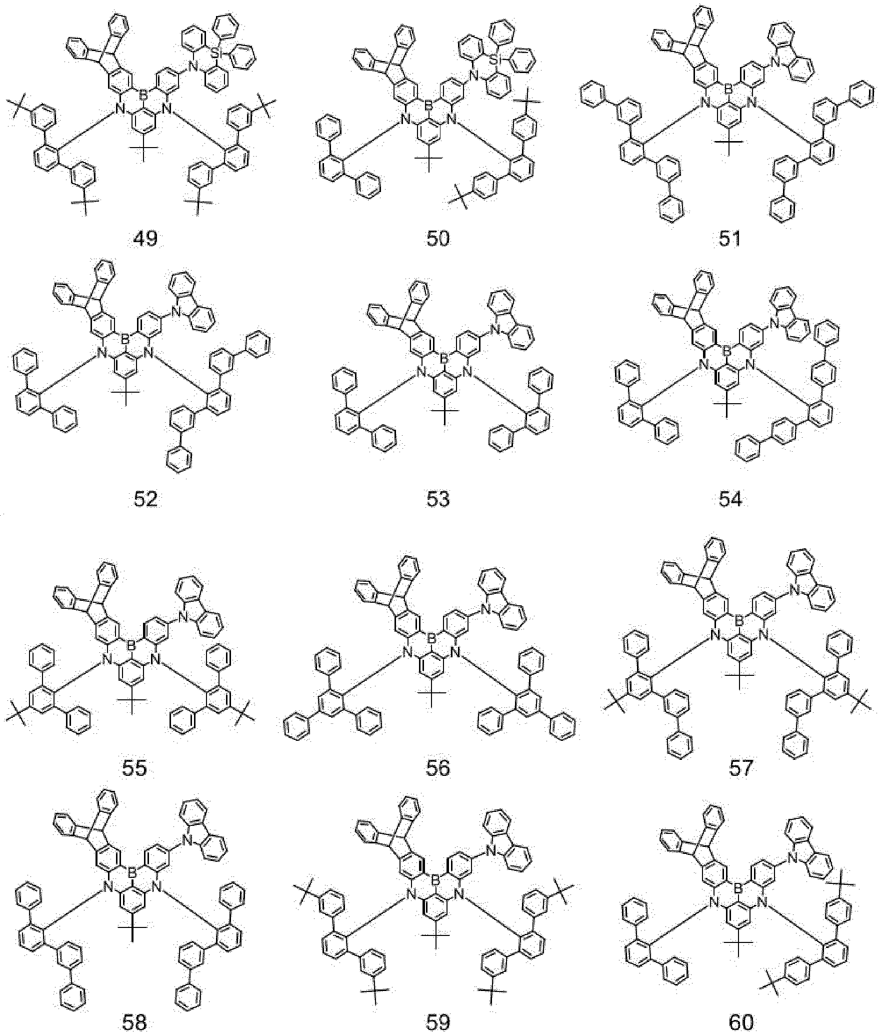

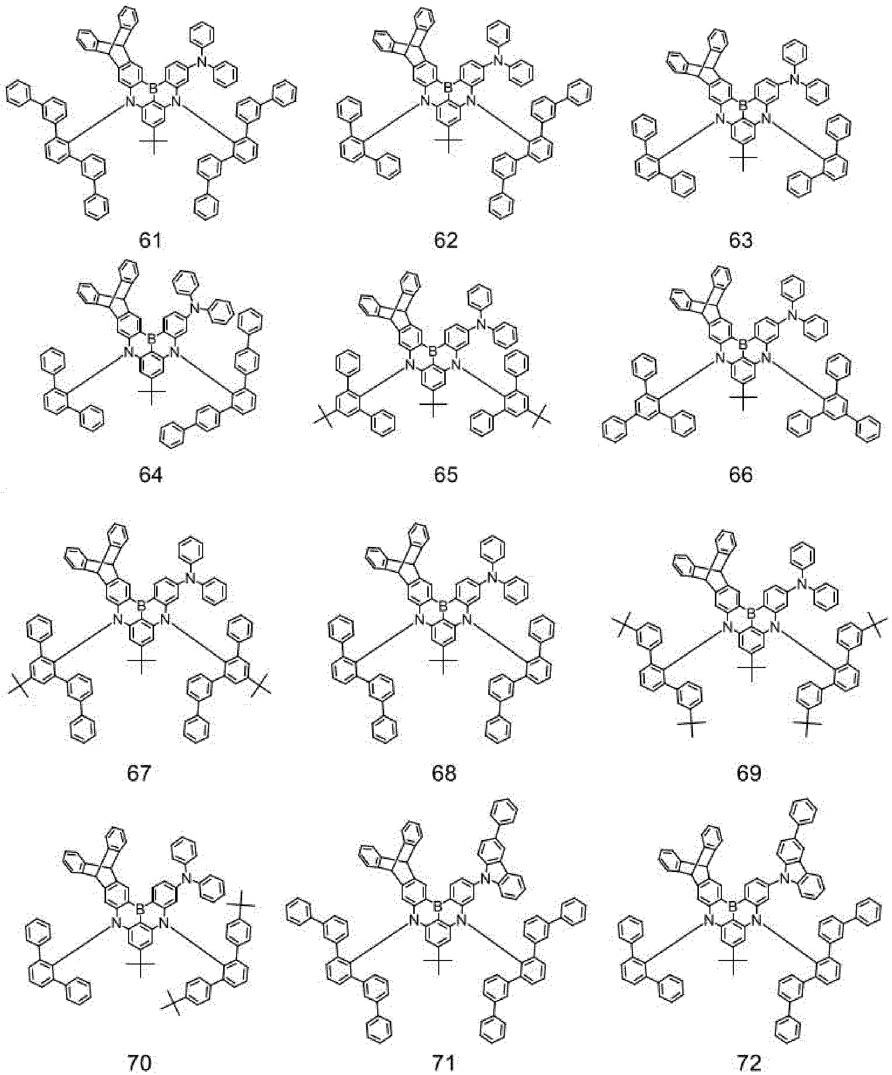

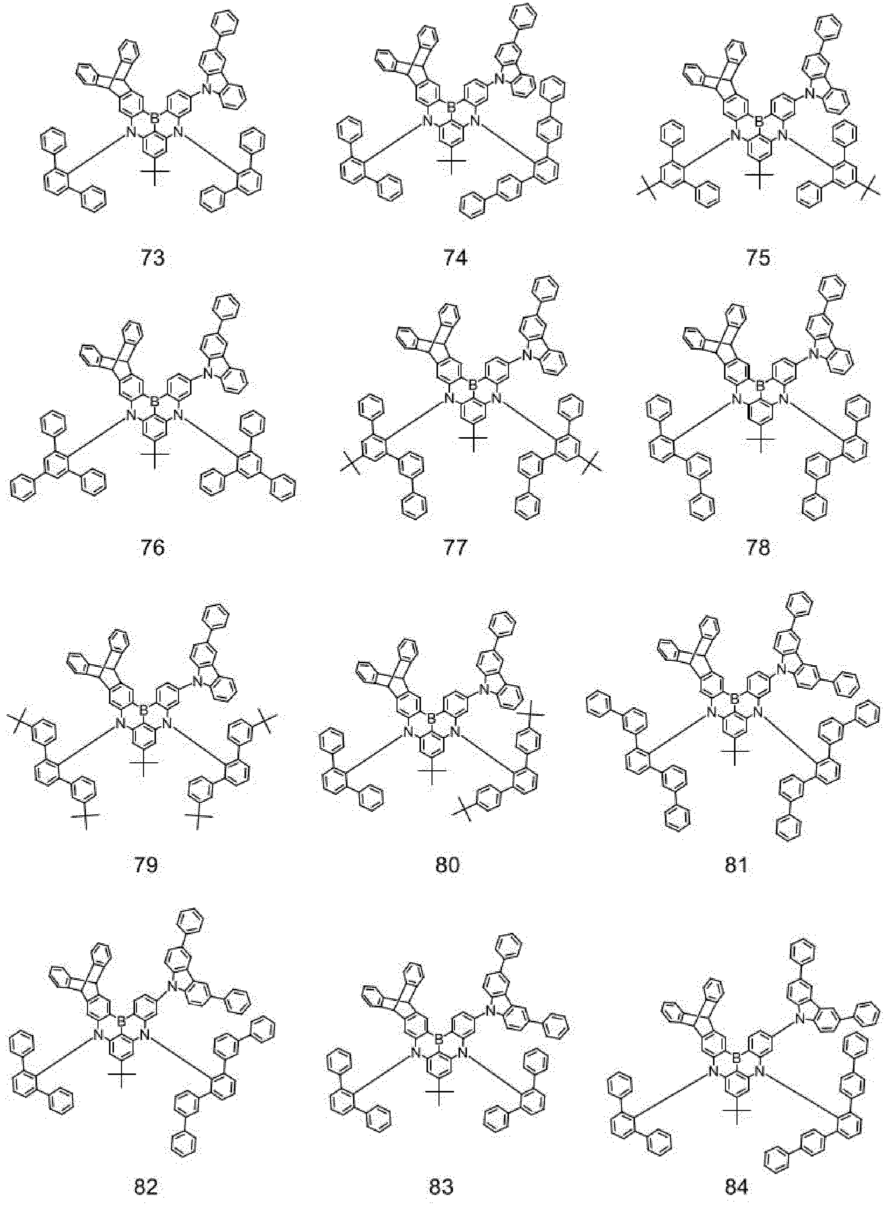

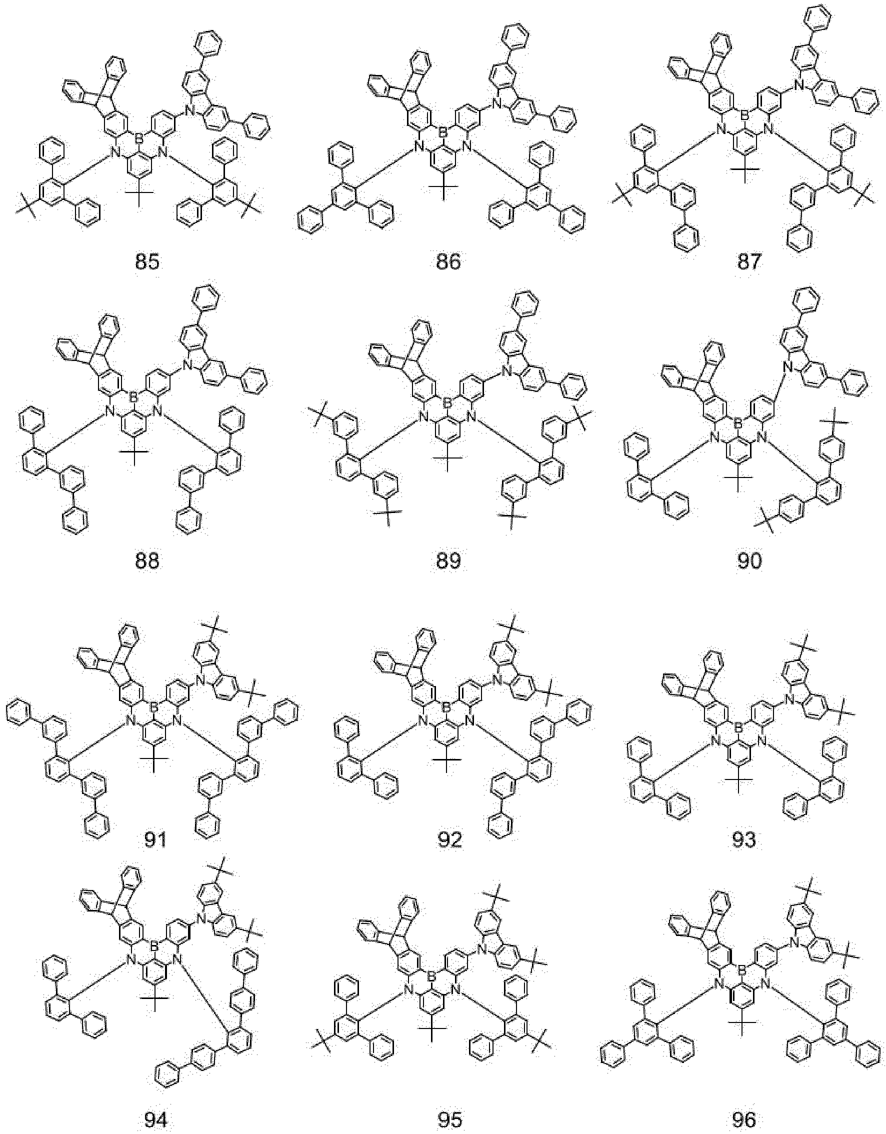

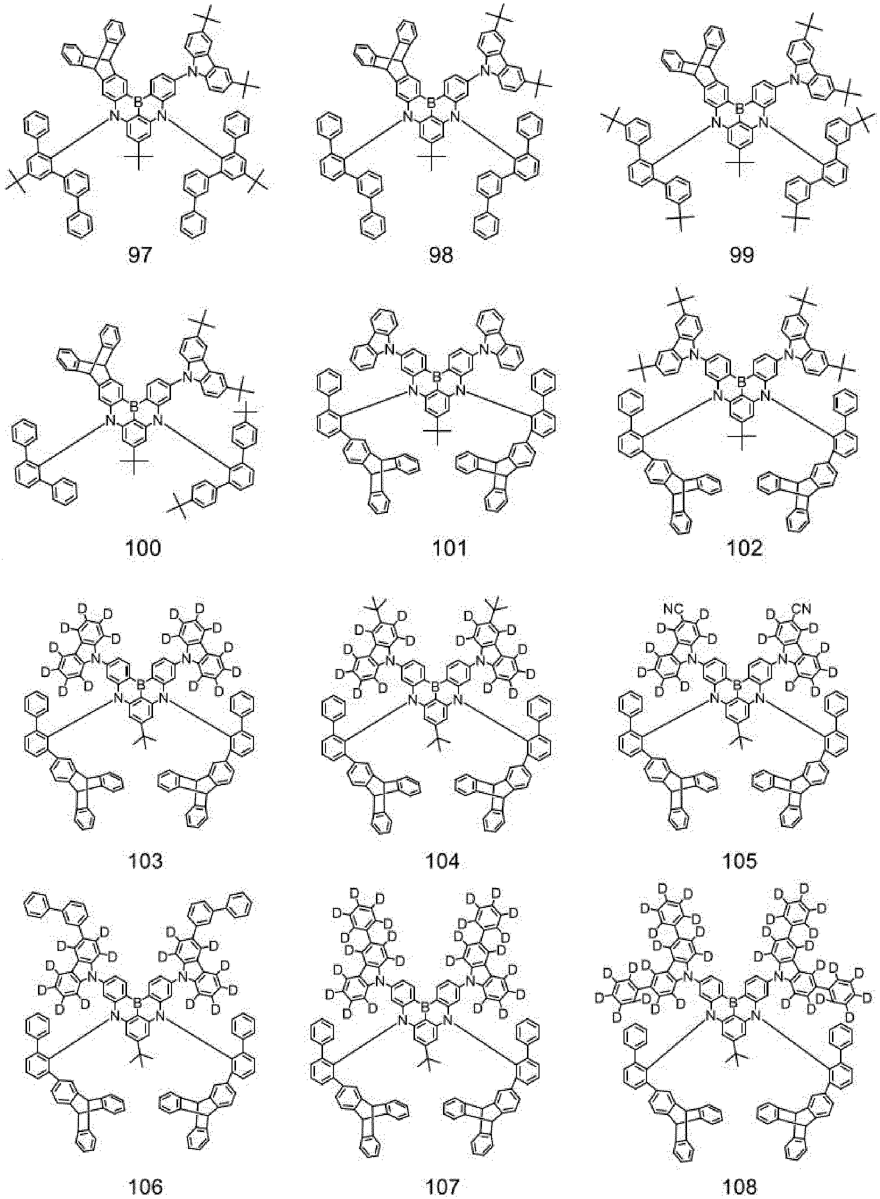

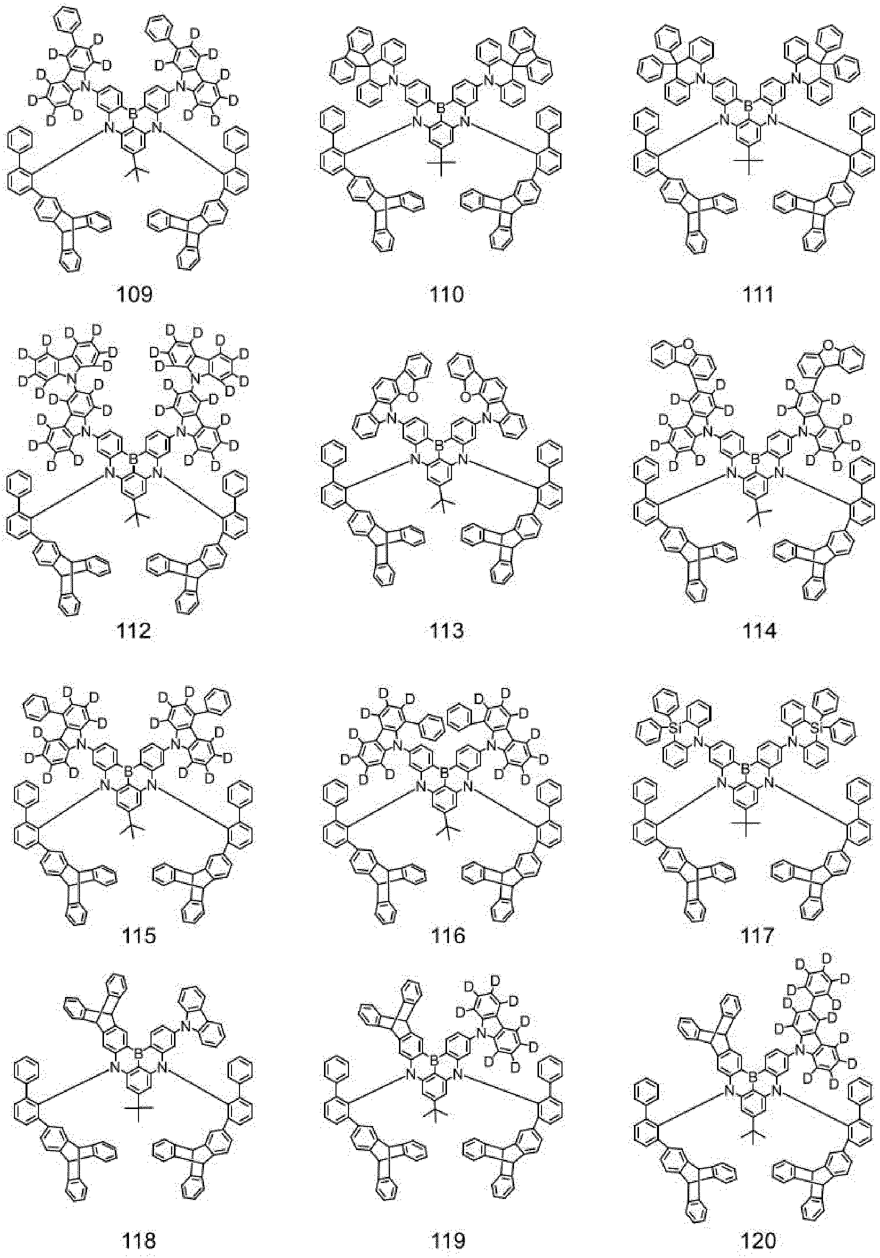

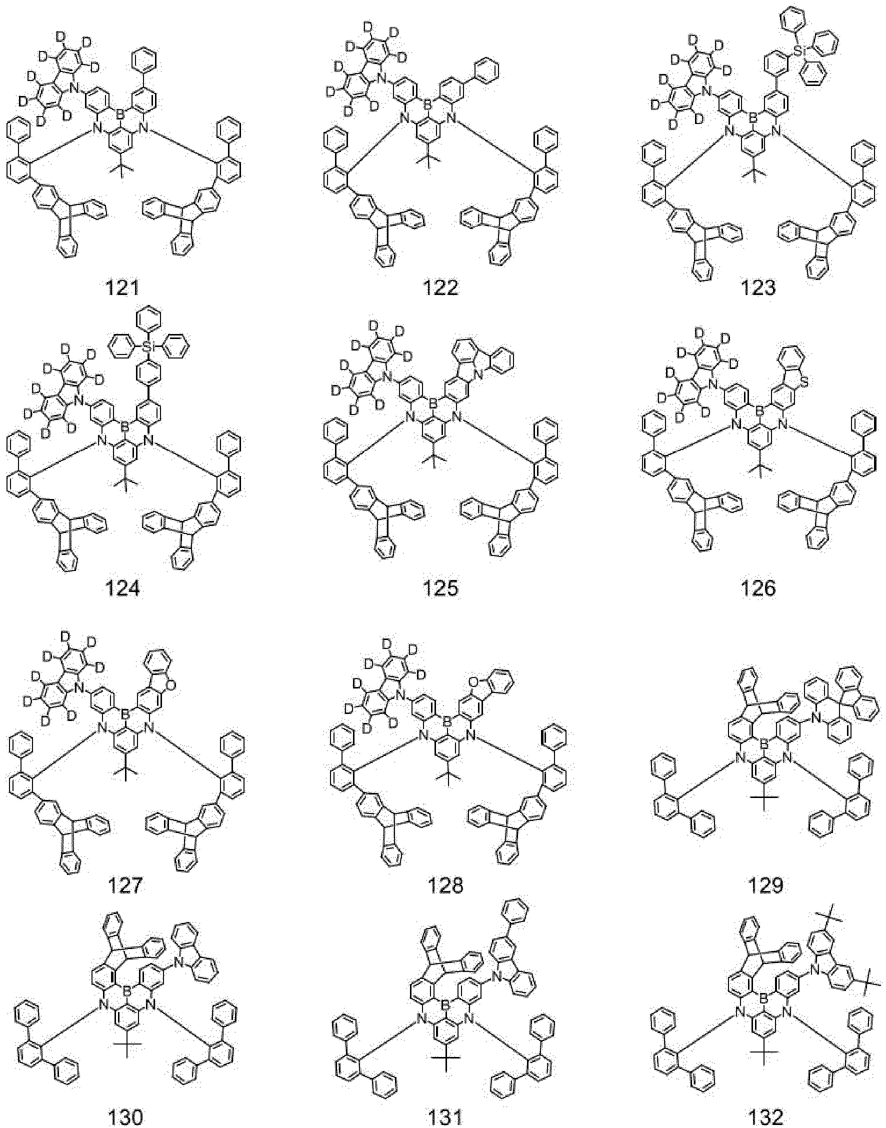

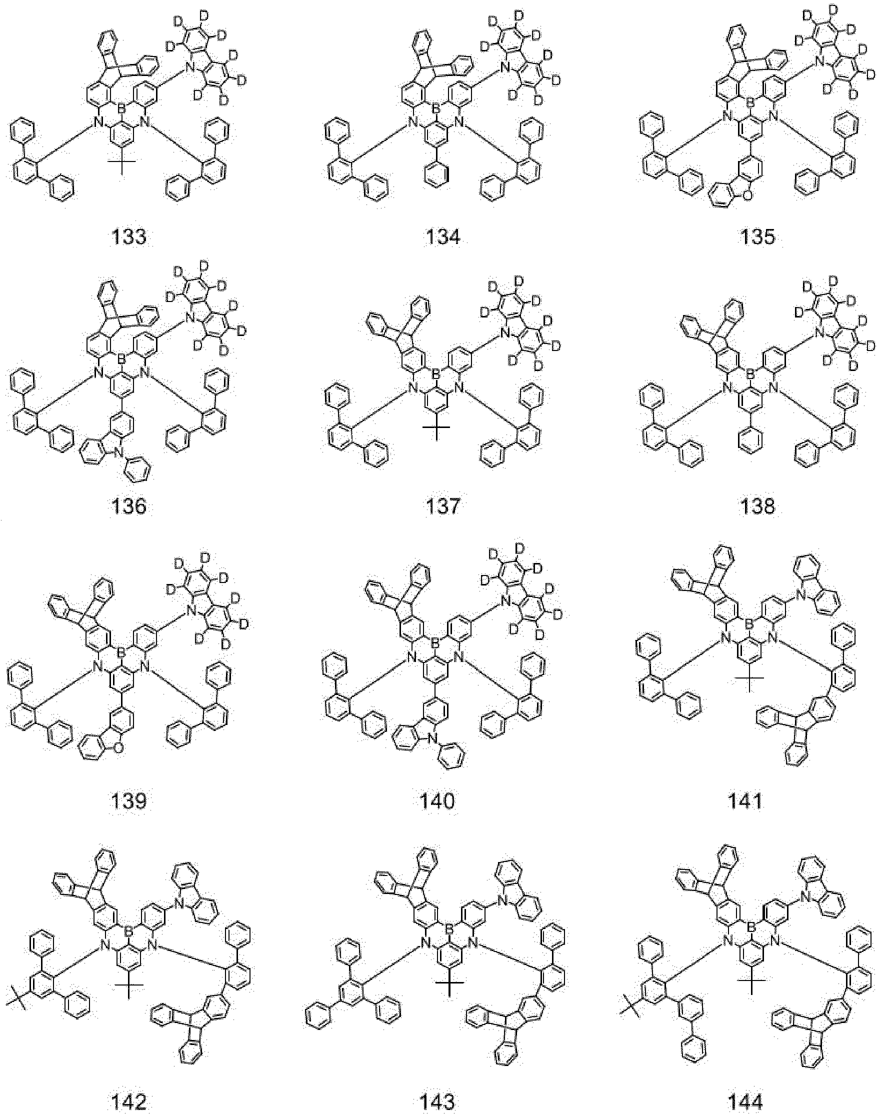

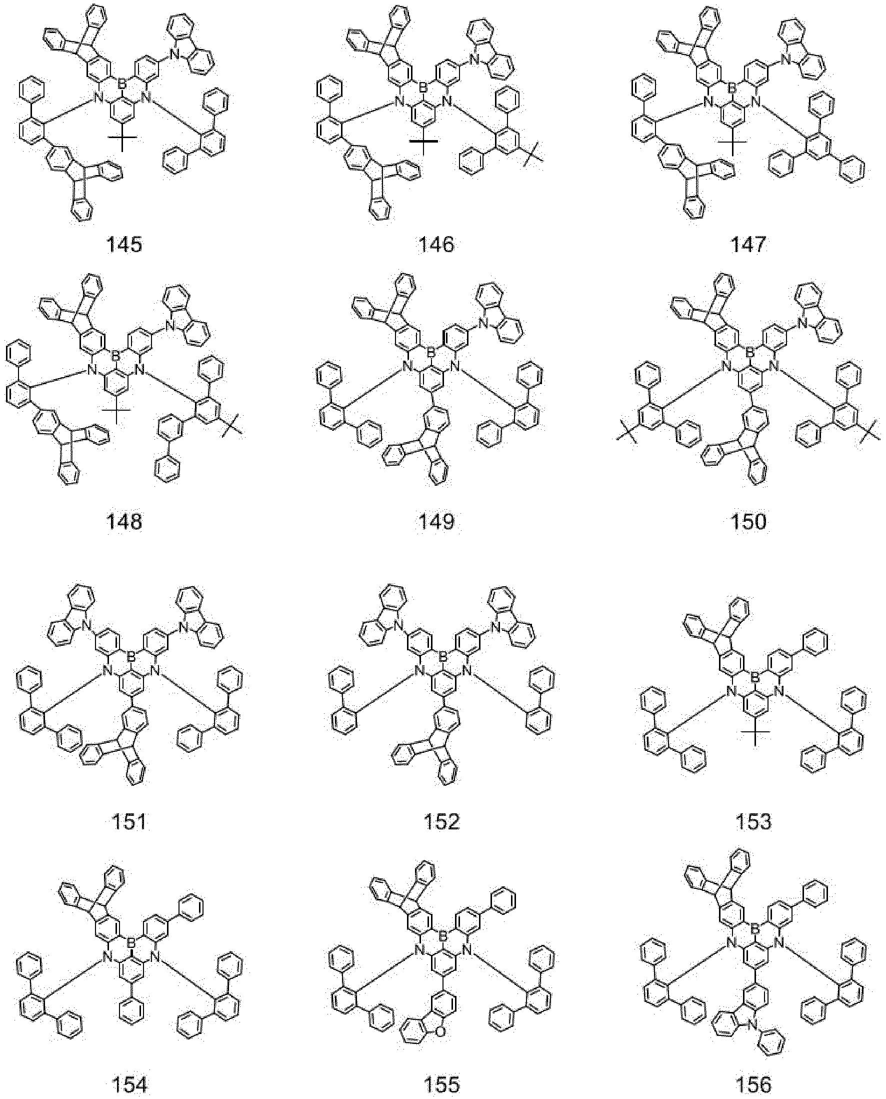

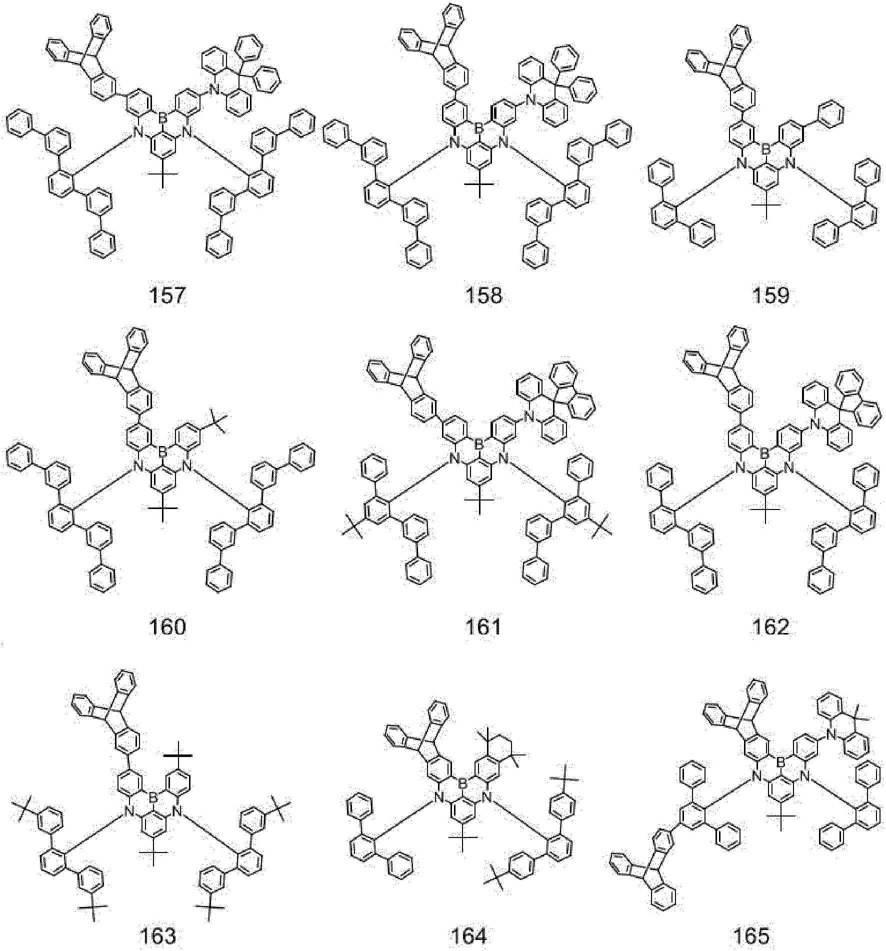

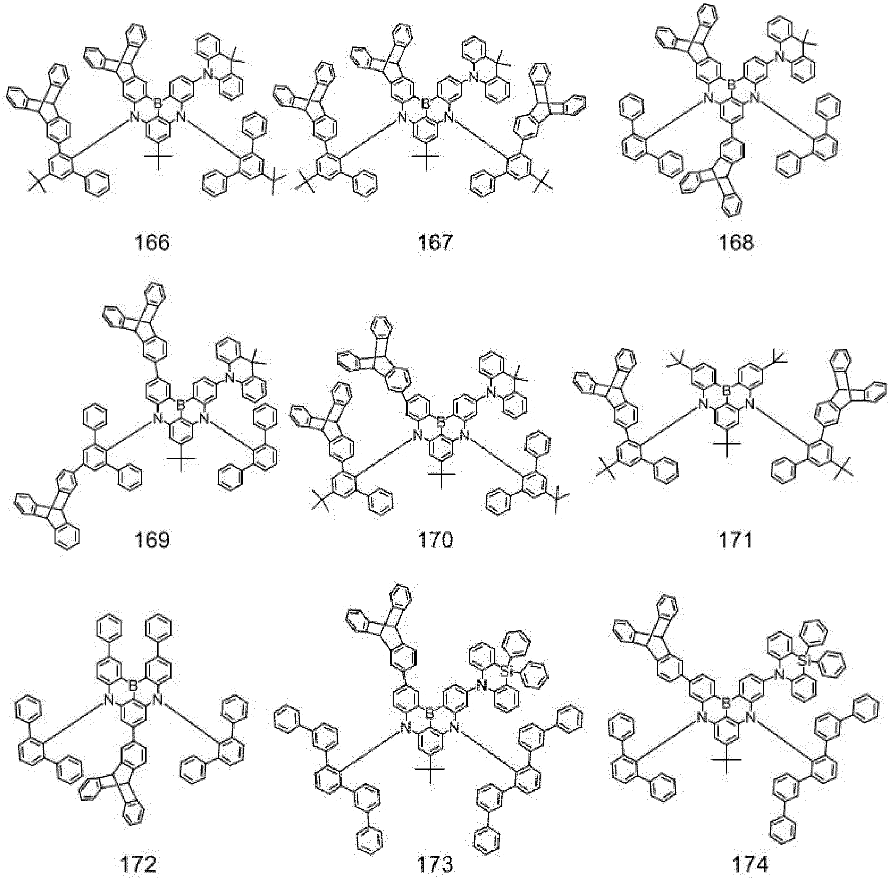

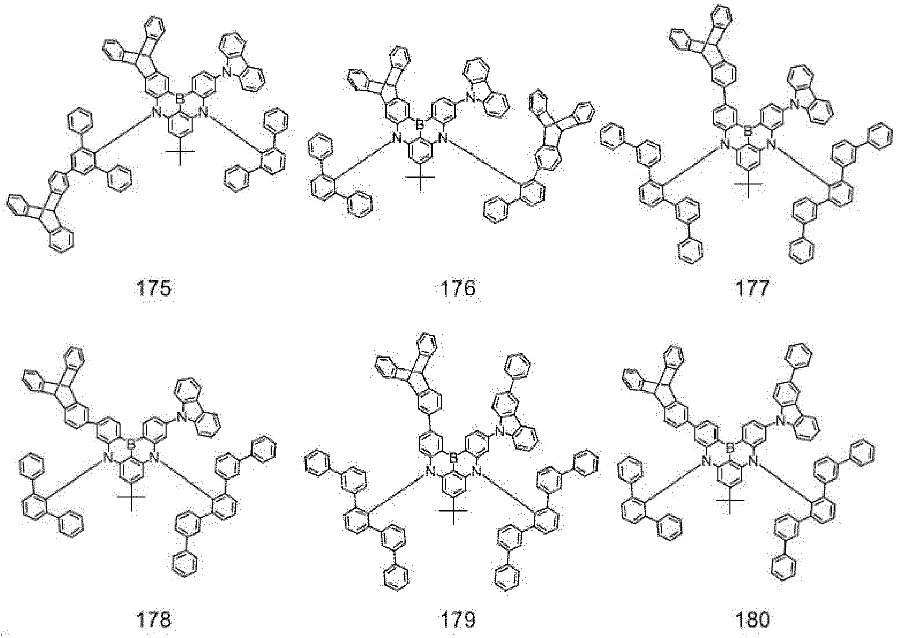

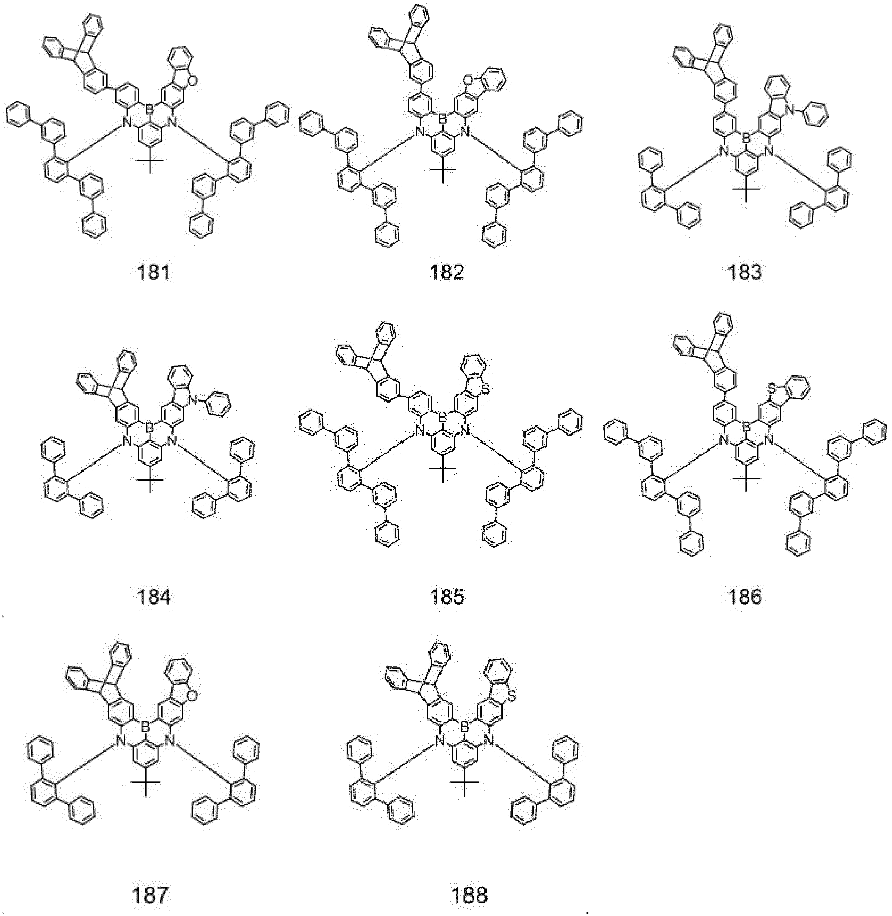

In the polycyclic compound according to an embodiment, an empty p-orbital of a boron atom may be effectively protected by a sterically bulky substituent to effectively maintain a trigonal bonding configuration of the boron atom, and thus planarity of the polycyclic compound may be reduced to reduce molecular interactions. Accordingly, the polycyclic compound according to an embodiment may have a structure in which the central structure is surrounded and protected by the sterically bulky substituent, thereby exhibiting excellent material stability.

In the light-emitting element ED according to an embodiment, the light-emitting layer EML may include a host and a dopant. The light-emitting layer EML may include, as the dopant, the polycyclic compound according to an embodiment. For example, the light-emitting layer EML may include at least one compound selected from Compound Group 1 as described above as a thermally activated delayed fluorescence (TADF) dopant.

The polycyclic compound according to an embodiment may emit blue light. For example, the polycyclic compound may be a light-emitting material having a central emission wavelength in a range of about 430 nm to about 490 nm. For example, the polycyclic compound may be a light-emitting material having a central emission wavelength in a range of about 450 nm to about 470 nm.

According to embodiments, the light-emitting layer EML may include the polycyclic compound according to an embodiment, and may further include at least one of a second compound, a third compound, and a fourth compound.

In an embodiment, the light-emitting layer EML may further include a second compound represented by Formula HT-1. In an embodiment, the second compound may be used as a hole transport host material in the light-emitting layer EML.

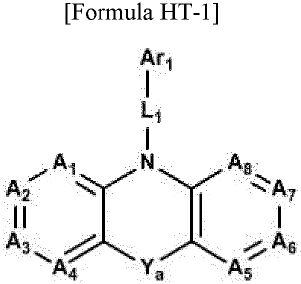

In Formula HT-1, A₁ to A₈ are each independently N or C(R₅₁). For example, A₁ to A₈ may each independently be C(R₅₁). As another example, one of A₁ to A₈ may be N, and the remainder of A₁ to A₈ may each independently be C(R₅₁).

In Formula HT-1, L₁ is a direct linkage, a substituted or unsubstituted arylene group having 6 to 30 ring-forming carbon atoms, or a substituted or unsubstituted heteroarylene group having 2 to 30 ring-forming carbon atoms. For example, L₁ may be a direct linkage, a substituted or unsubstituted phenylene group, a substituted or unsubstituted divalent biphenyl group, a substituted or unsubstituted divalent carbazole group, etc., but embodiments are not limited thereto.

In Formula HT-1, Yₐ is a direct linkage, C(R₅₂)(R₅₃), or Si(R₅₄)(R₅₅). For example, the two benzene rings that are linked to the nitrogen atom in Formula HT-1 may be linked to each other via a direct linkage, 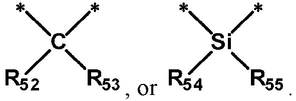 In Formula HT-1, when Yₐ is a direct linkage, the second compound represented by Formula HT-1 may include a carbazole moiety.

In Formula HT-1, Ar₁ is a substituted or unsubstituted aryl group having 6 to 30 ring-forming carbon atoms or a substituted or unsubstituted heteroaryl group having 2 to 30 ring-forming carbon atoms. For example, Ar₁ may be a substituted or unsubstituted carbazole group, a substituted or unsubstituted dibenzofuran group, a substituted or unsubstituted dibenzothiophene group, a substituted or unsubstituted biphenyl group, *etc.,* but embodiments are not limited thereto.

In Formula HT-1, R₅₁ to R₅₅ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, or combined with an adjacent group to form a ring. For example, R₅₁ to R₅₅ may each independently be a hydrogen atom or a deuterium atom. For example, R₅₁ to R₅₅ may each independently be an unsubstituted methyl group or an unsubstituted phenyl group.

In an embodiment, the second compound represented by Formula HT-1 may be selected from Compound Group 2. In an embodiment, in the light-emitting element ED, the second compound may include at least one compound selected from Compound Group 2:

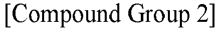

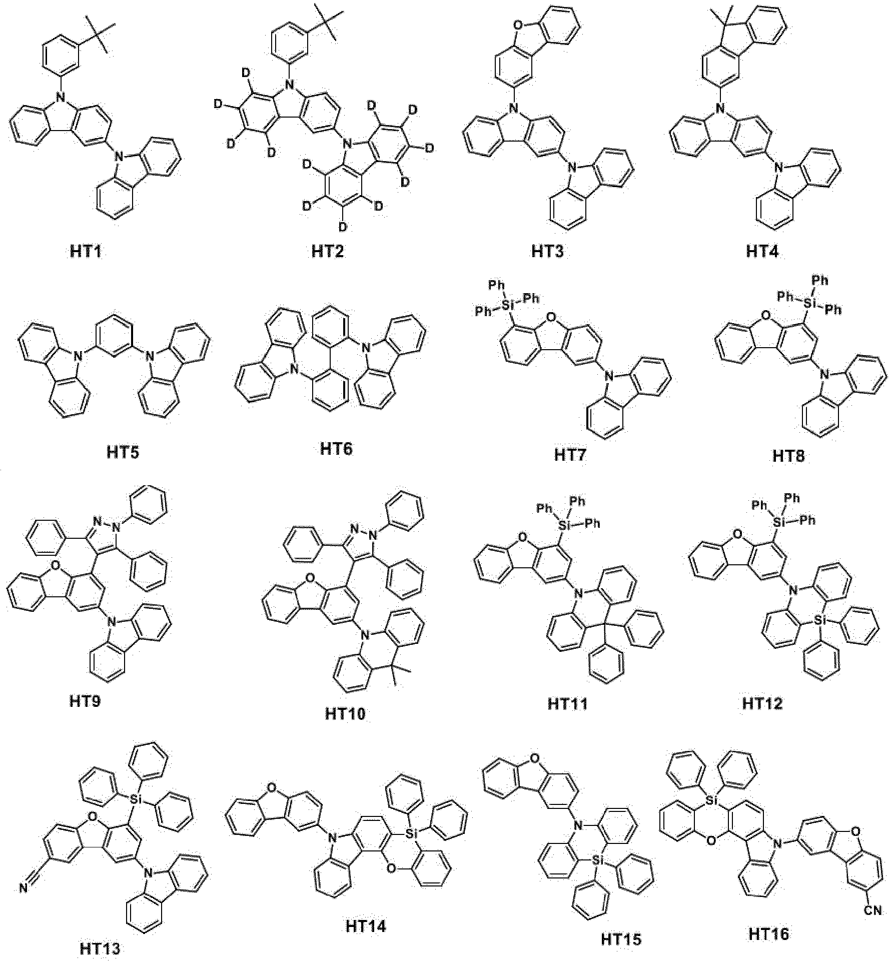

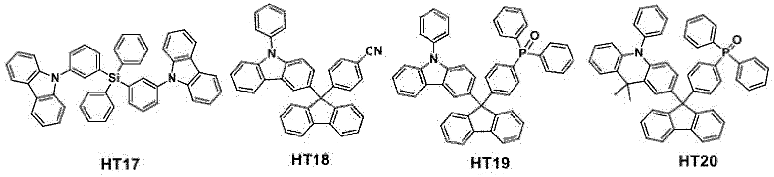

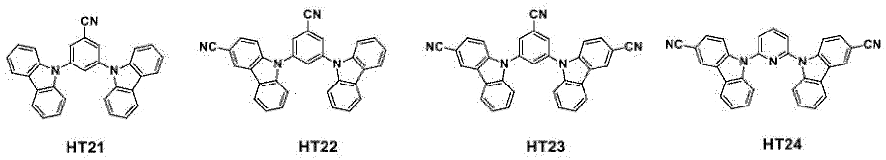

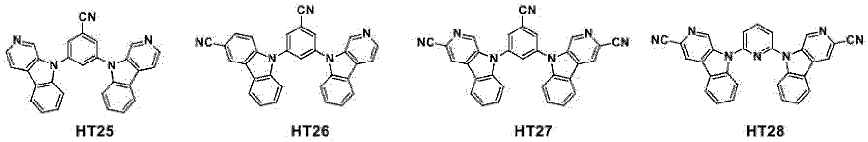

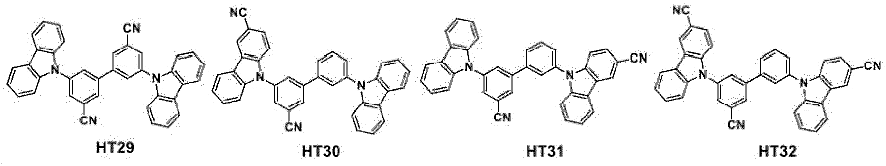

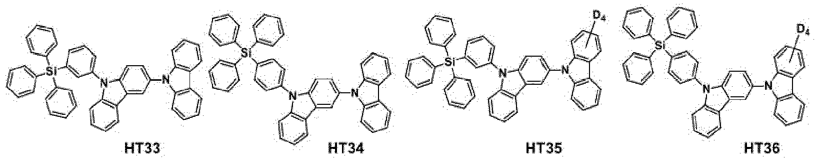

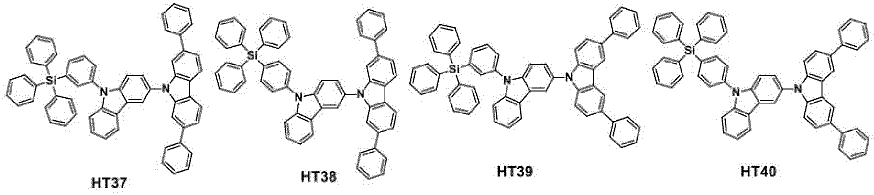

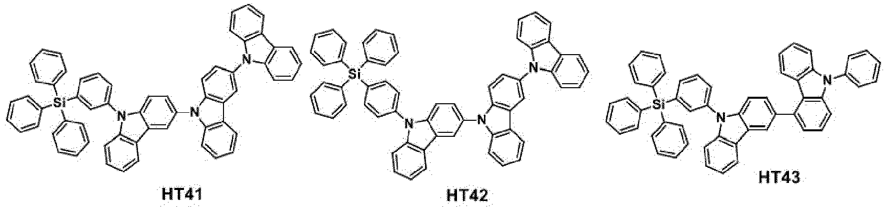

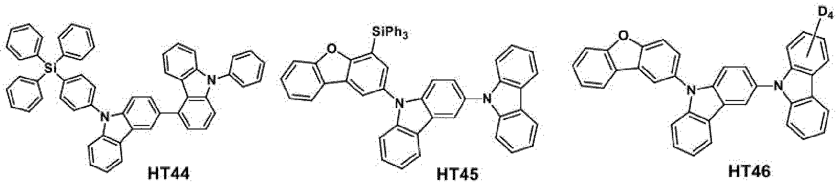

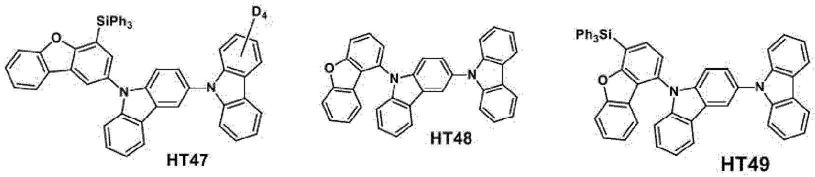

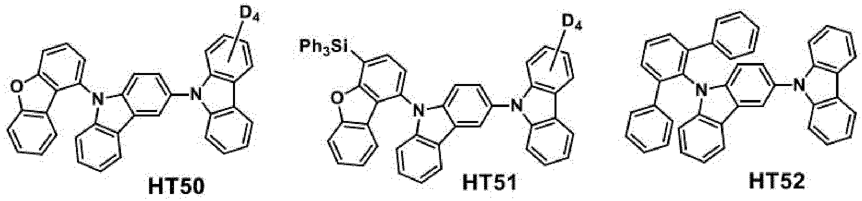

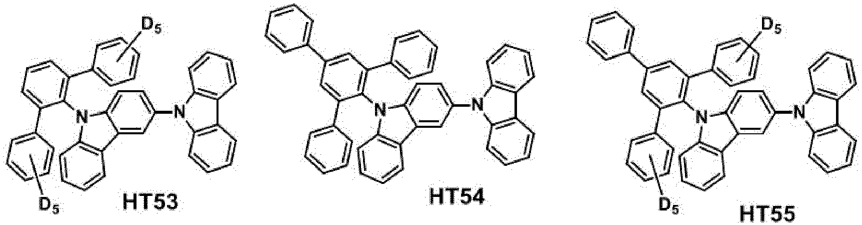

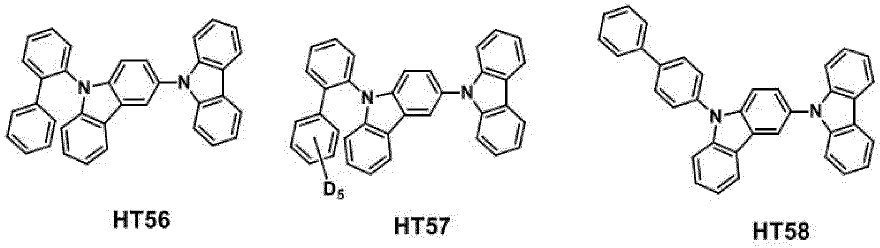

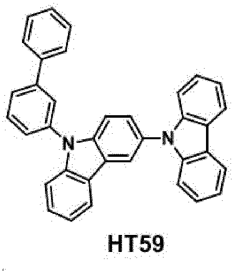

In Compound Group 2, D represents a deuterium atom, and Ph represents a substituted or unsubstituted phenyl group. For example, in Compound Group 2, Ph may represent an unsubstituted phenyl group.

In an embodiment, the light-emitting layer EML may further include a third compound represented by Formula ET-1. In an embodiment, the third compound may be used as an electron transport host material for the light-emitting layer EML.

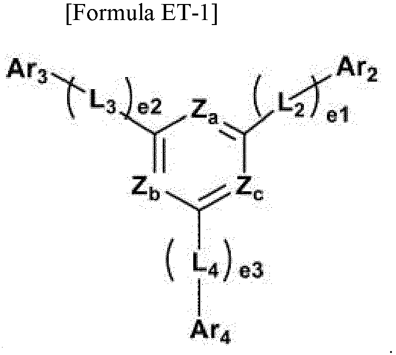

In Formula ET-1, at least one of Zₐ, Z_{b}, and Z_{c} is N, and the remainder of Zₐ, Z_{b}, and Z_{c} are each independently C(R₅₆). For example, one of Zₐ to Z_{c} may be N, and the remainder of Zₐ to Z_{c} may each independently be C(R₅₆). Thus, the third compound represented by Formula ET-1 may include a pyridine moiety. As another example, two of Zₐ to Z_{c} may be N, and the remainder of Zₐ to Z_{c} may be C(R₅₆). Thus, the third compound represented by Formula ET-1 may include a pyrimidine moiety. As yet another example, Zₐ to Z_{c} may each be N. Thus, the third compound represented by Formula ET-1 may include a triazine moiety.

In Formula ET-1, R₅₆ is a hydrogen atom, a deuterium atom, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms.

In Formula ET-1, e1 to e3 are each independently an integer from 0 to 10.

In Formula ET-1, Ar₂ to Ar₄ are each independently a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, Ar₂ to Ar₄ may each independently be a substituted or unsubstituted phenyl group or a substituted or unsubstituted carbazole group.

In Formula ET-1, L₂ to L₄ are each independently a direct linkage, a substituted or unsubstituted arylene group having 6 to 30 ring-forming carbon atoms, or a substituted or unsubstituted heteroarylene group having 2 to 30 ring-forming carbon atoms. When e1 to e3 are each 2 or greater, multiple groups of each of L₂ to L₄ may each independently be a substituted or unsubstituted arylene group having 6 to 30 ring-forming carbon atoms or a substituted or unsubstituted heteroarylene group having 2 to 30 ring-forming carbon atoms.

In an embodiment, the third compound represented by Formula ET-1 may be selected from Compound Group 3. In an embodiment, in the light-emitting element ED, the third compound may include at least one compound selected from Compound Group 3:

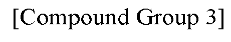

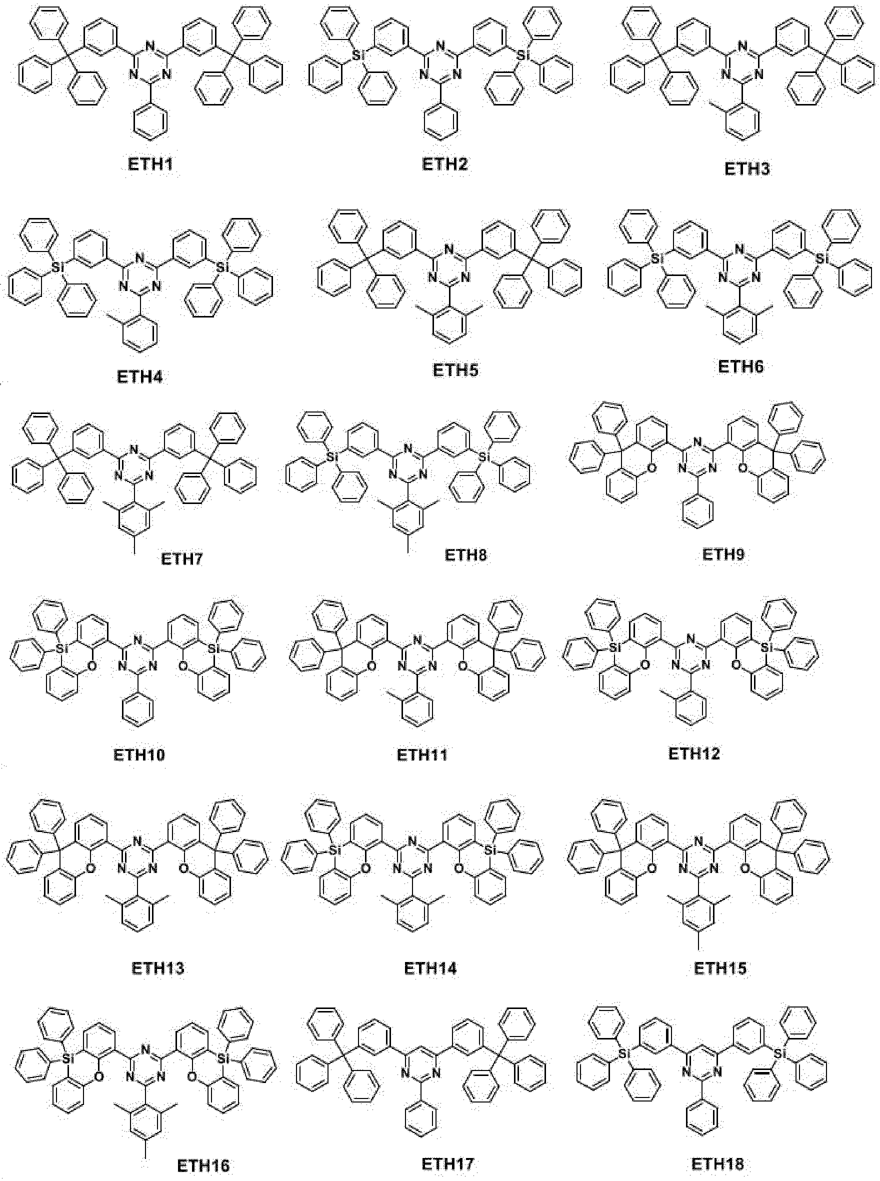

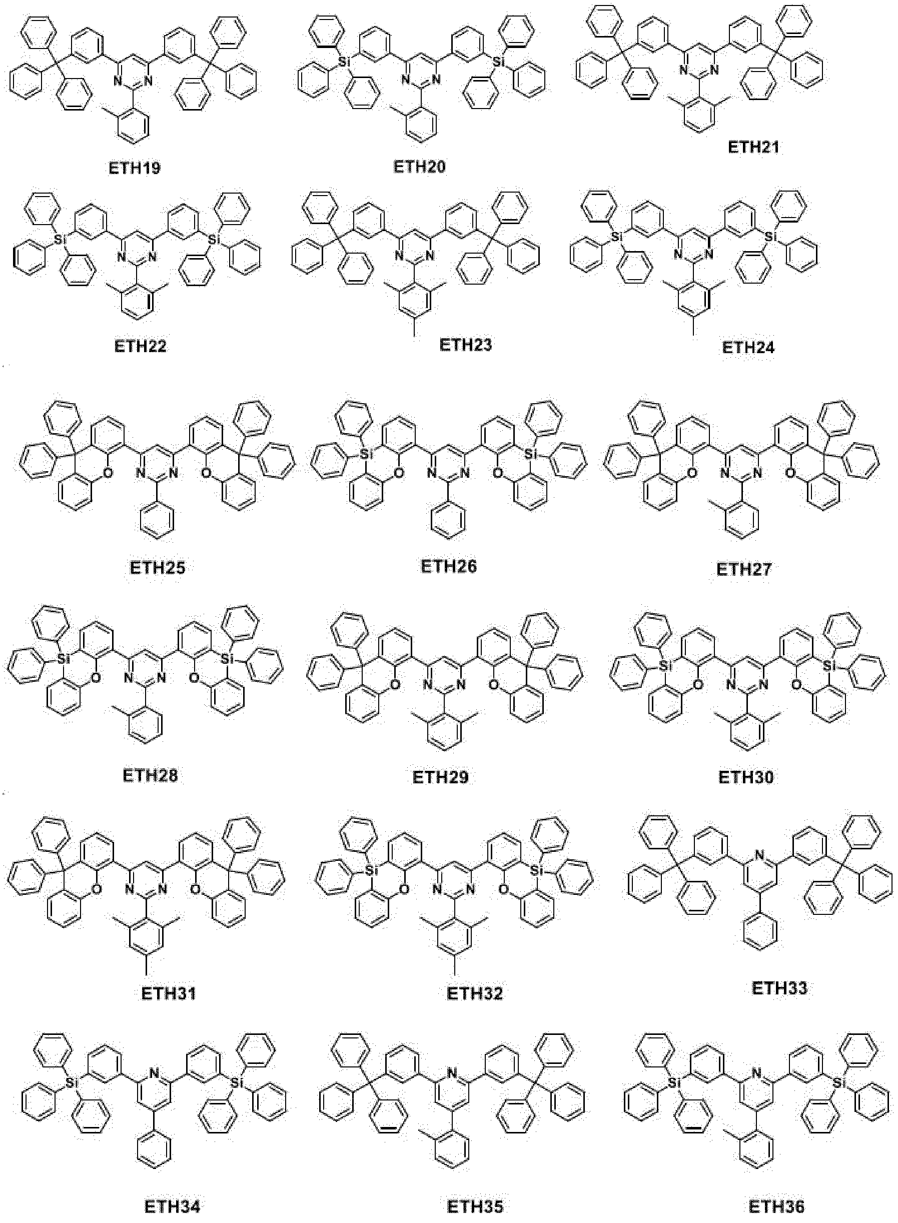

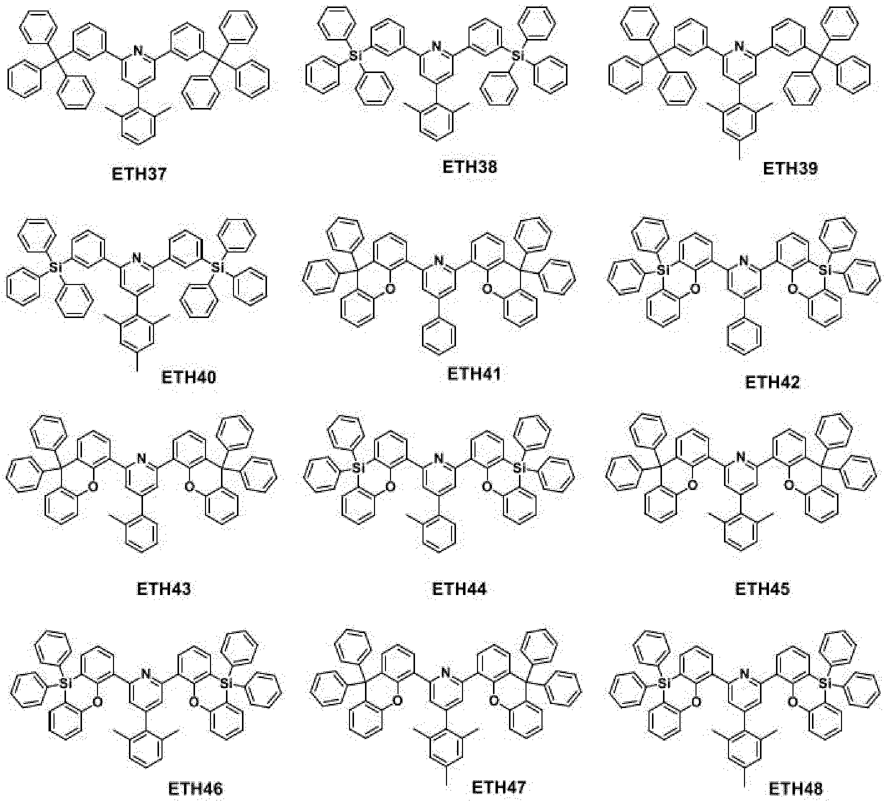

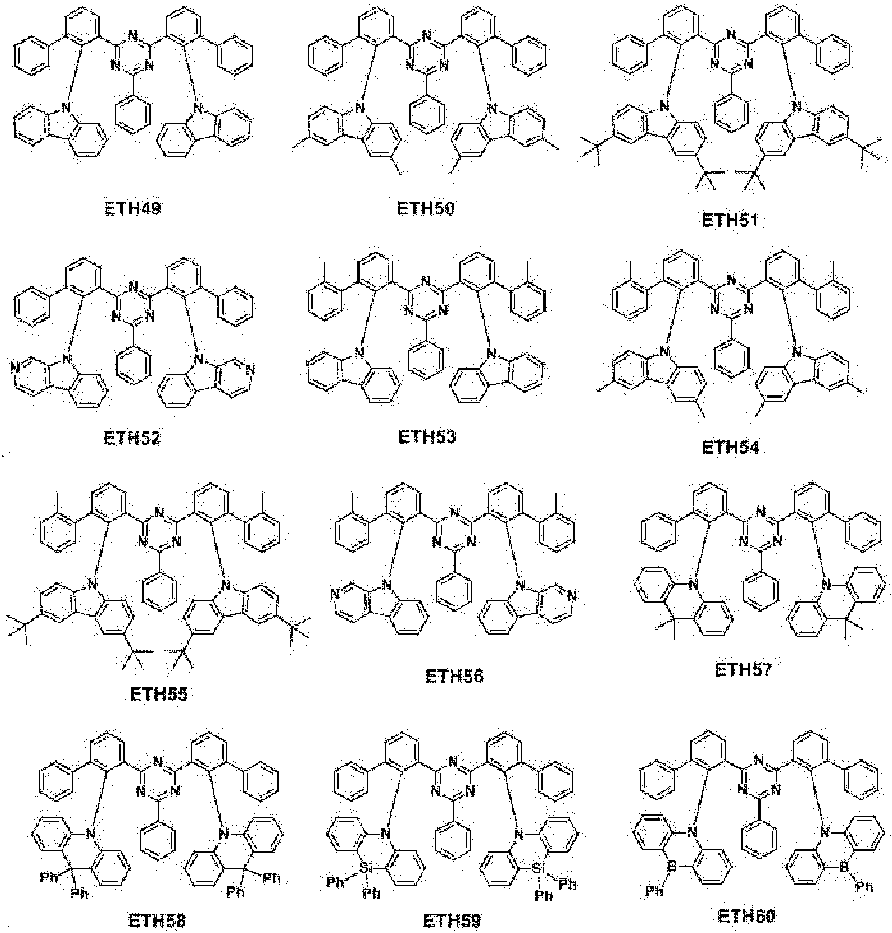

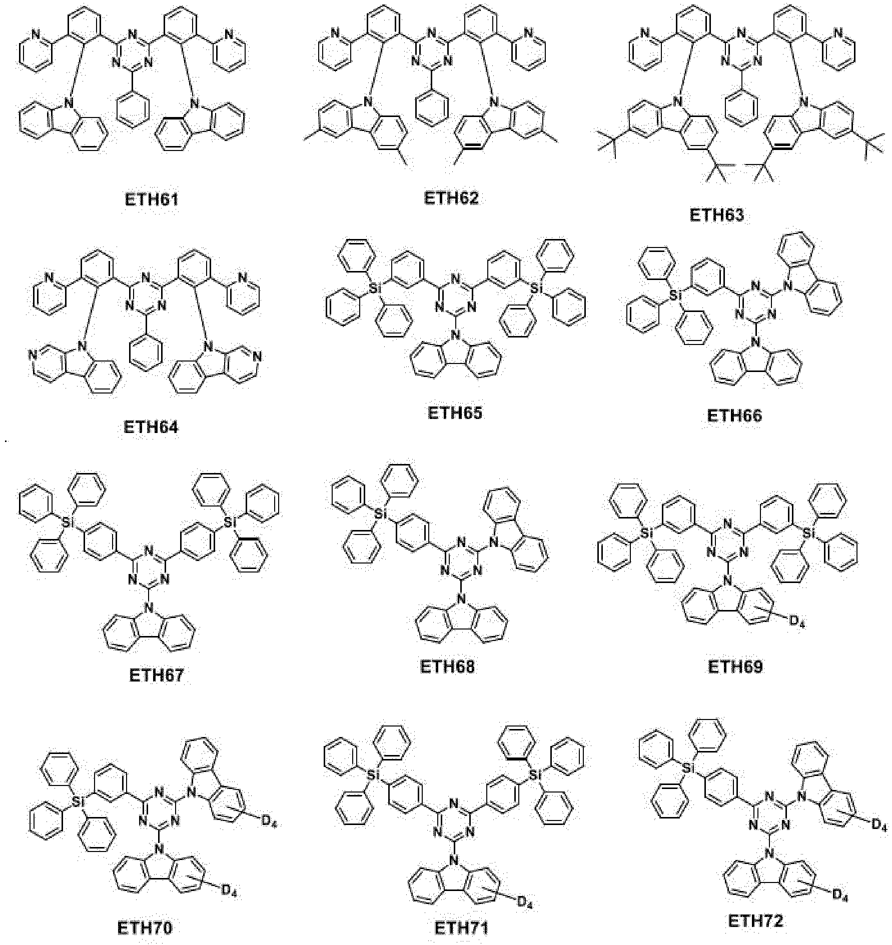

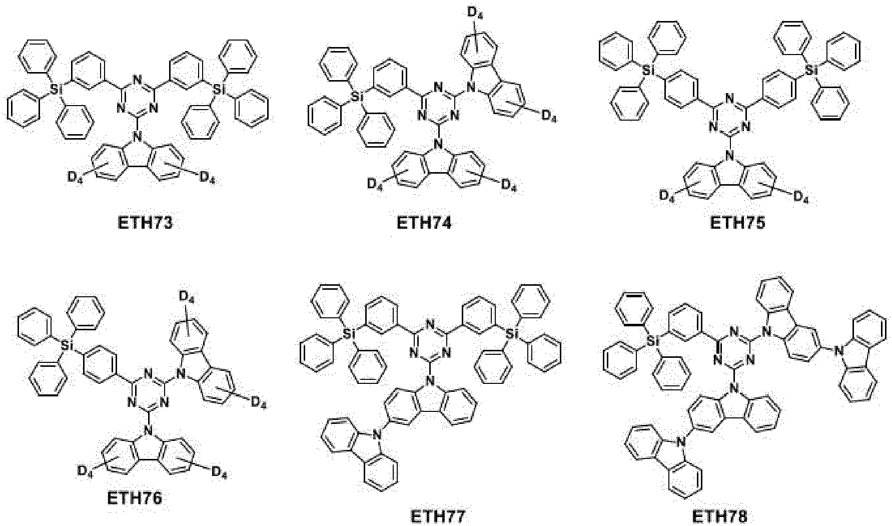

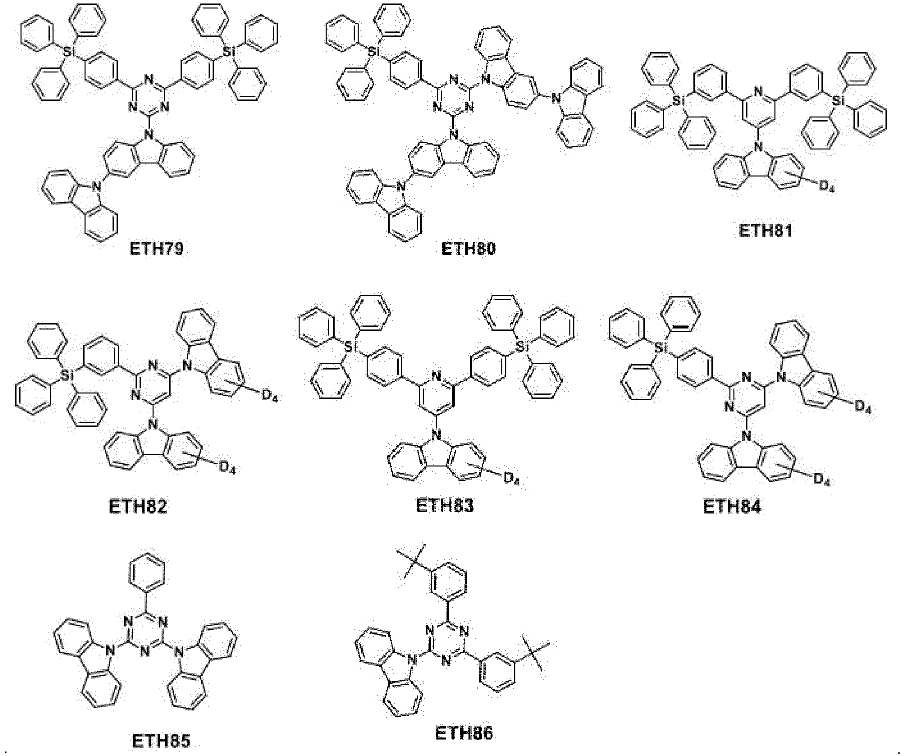

In Compound Group 3, D represents a deuterium atom, and Ph represents an unsubstituted phenyl group.

In an embodiment, the light-emitting layer EML may include the second compound and the third compound, and the second compound and the third compound may form an exciplex. In the light-emitting layer EML, an exciplex may be formed by a hole transport host and an electron transport host. A triplet energy of the exciplex formed by a hole transport host and an electron transport host may correspond to a difference between a lowest unoccupied molecular orbital (LUMO) energy level of the electron transport host and a highest occupied molecular orbital (HOMO) energy level of the hole transport host.

For example, an absolute value of a triplet energy level (T1) of the exciplex formed by the hole transport host and the electron transport host may be in a range of about 2.4 eV to about 3.0 eV. The triplet energy level of the exciplex may be a value that is less than an energy gap of each host material. The exciplex may have a triplet energy level equal to or less than about 3.0 eV, which is an energy gap between the hole transport host and the electron transport host.

In an embodiment, the light-emitting layer EML may further include a fourth compound, in addition to the first compound, the second compound, and the third compound as described above. The fourth compound may be used as a phosphorescent sensitizer in the light-emitting layer EML. Energy may be transferred from the fourth compound to the first compound, thereby implementing light emission.

In an embodiment, the light-emitting layer EML may further include, as a fourth compound, an organometallic complex that includes platinum (Pt) as a central metal atom and ligands linked to the central metal atom. In an embodiment, the light-emitting layer EML may include a fourth compound represented by Formula D-1:

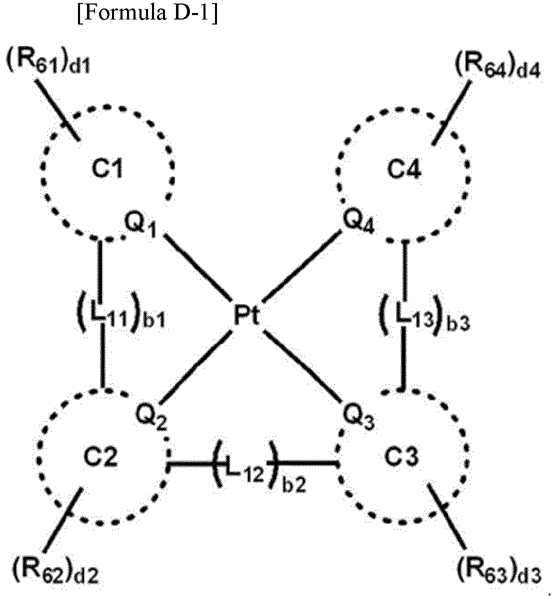

In Formula D-1, Q₁ to Q₄ are each independently C or N. In Formula D-1, C1 to C4 are each independently a substituted or unsubstituted hydrocarbon ring having 5 to 30 ring-forming carbon atoms, or a substituted or unsubstituted heterocycle having 2 to 30 ring-forming carbon atoms.

In Formula D-1, L₁₁ to L₁₃ are each independently a direct linkage, 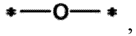 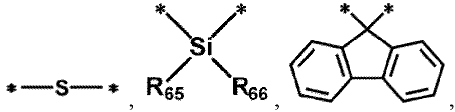 a substituted or unsubstituted alkylene group having 1 to 20 carbon atoms, a substituted or unsubstituted arylene group having 6 to 30 ring-forming carbon atoms, or a substituted or unsubstituted heteroarylene group having 2 to 30 ring-forming carbon atoms. In L₁₁ to L₁₃, -* represents a bond to one of C1 to C4.

In Formula D-1, b1 to b3 are each independently 0 or 1. If b1 is 0, C1 and C2 are not directly linked to each other. If b2 is 0, C2 and C3 are not directly linked to each other. If b3 is 0, C3 and C4 are not directly linked to each other.

In Formula D-1, R₆₁ to R₆₆ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms, or combined with an adjacent group to form a ring. For example, R₆₁ to R₆₆ may each independently be a substituted or unsubstituted methyl group or a substituted or unsubstituted t-butyl group.

In Formula D-1, d1 to d4 are each independently an integer from 0 to 4. If d1 to d4 are each 0, the fourth compound is not substituted with R₆₁ to R₆₄, respectively. A case where d1 to d4 are each 4 and four groups of each of R₆₁ to R₆₄ are all hydrogen atoms may be the same as a case where d1 to d4 are each 0. When d1 to d4 are each 2 or more, multiple groups of each of R₆₁ to R₆₄ may all be the same, or at least one thereof may be different from the remainder.

In an embodiment, in Formula D-1, C1 to C4 may each independently be a substituted or unsubstituted hydrocarbon ring or a substituted or unsubstituted heterocycle that is represented by one of Formula C-1 to Formula C-4:

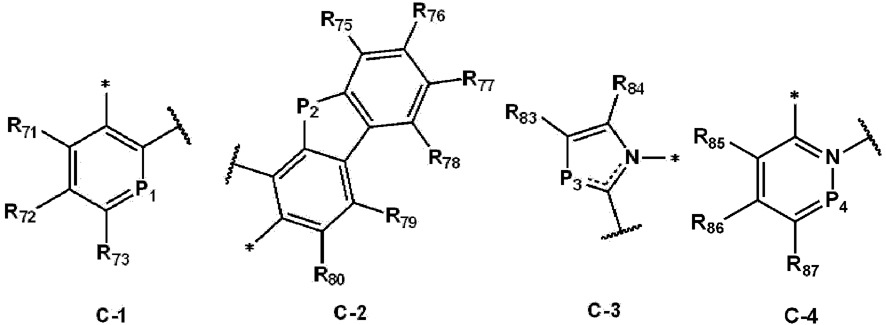

In Formula C-1 to Formula C-4, P₁ may be 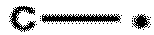 or C(R₇₄), P₂ may be 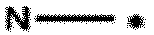 or N(R₈₁), P₃ may be 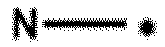 or N(R₈₂), and P₄ may be 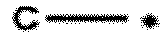 or C(R₈₈). In Formula C-1 to Formula C-4, R₇₁ to R₈₈ may each independently be a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or combined with an adjacent group to form a ring.

In Formula C-1 to Formula C-4, 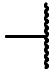 represents a bond to Pt, which is a central metal atom, and -* represents a bond to a neighboring cyclic group (C1 to C4) or to a linking moiety (L₁₁ to L₁₃).

In an embodiment, the light-emitting layer EML may include the first compound represented by Formula 1, and at least one of the second compound, the third compound, and the fourth compound. In an embodiment, the light-emitting layer EML may include the first compound, the second compound, and the third compound. In the light-emitting layer EML, the second compound and the third compound may form an exciplex, and energy may be transferred from the exciplex to the first compound, thereby emitting light.

In another embodiment, the light-emitting layer EML may include the first compound, the second compound, the third compound, and the fourth compound. In the light-emitting layer EML, the second compound and the third compound may form an exciplex, and energy may be transferred from the exciplex to the fourth compound and to the first compound, thereby emitting light. In an embodiment, the fourth compound may be a sensitizer. In the light-emitting element ED, the fourth compound included in the light-emitting layer EML may serve as a sensitizer that transfers energy from a host (for example, an exciplex host) to the first compound, which is a light emitting dopant. For example, the fourth compound, which serves as an auxiliary dopant, may accelerate energy transfer to the first compound, which is a light emitting dopant, thereby increasing an emission ratio of the first compound. Therefore, the light-emitting layer EML may exhibit improved luminous efficiency. When energy transfer to the first compound is increased, excitons formed in the light-emitting layer EML may not accumulate the light-emitting layer EML and may rapidly emit light, so that deterioration of the device may be reduced. Therefore, the service life of the light-emitting element ED may increase.

The light-emitting element ED may include the first compound, the second compound, the third compound, and the fourth compound, and the light-emitting layer EML may include a combination of two host materials and two dopant materials. In the light-emitting element ED, the light-emitting layer EML may include the second compound and the third compound, which are two different hosts, the first compound that emits delayed fluorescence, and the fourth compound that includes an organometallic complex, so that the light-emitting element ED may exhibit excellent luminous efficiency characteristics.

In an embodiment, the fourth compound represented by Formula D-1 may be selected from Compound Group 4. In an embodiment, in light-emitting element ED, the fourth compound may include at least one compound selected from Compound Group 4:

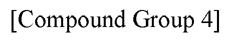

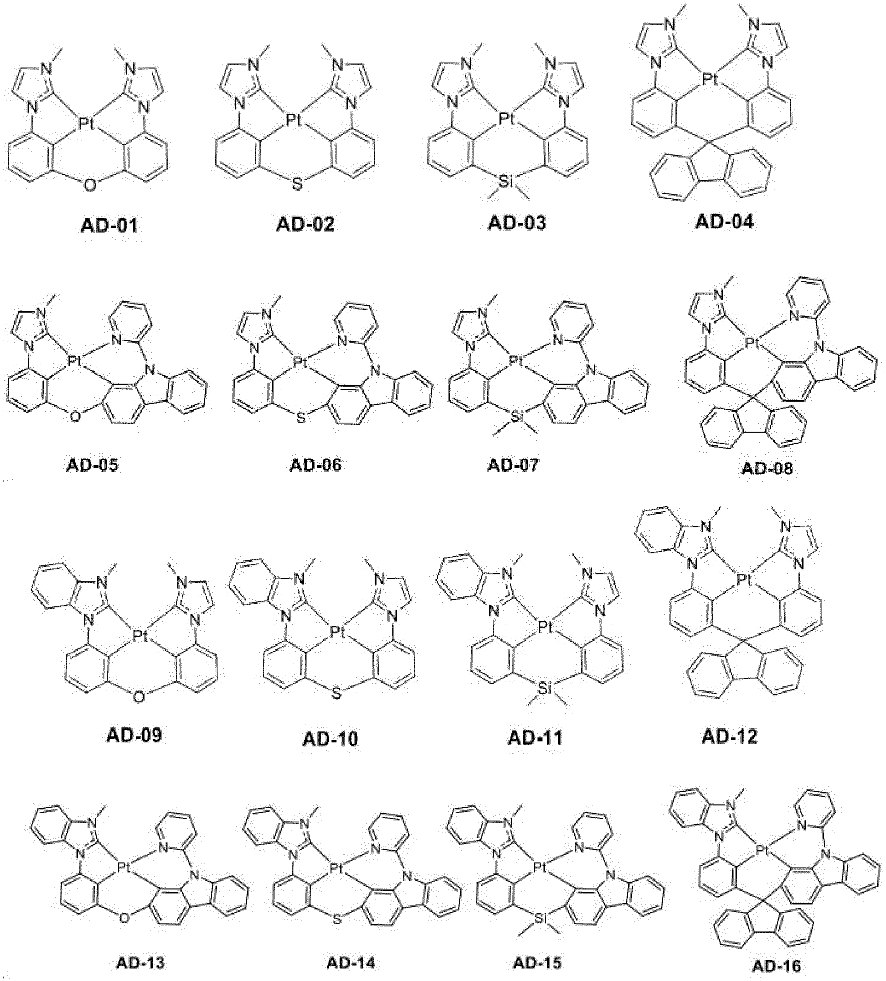

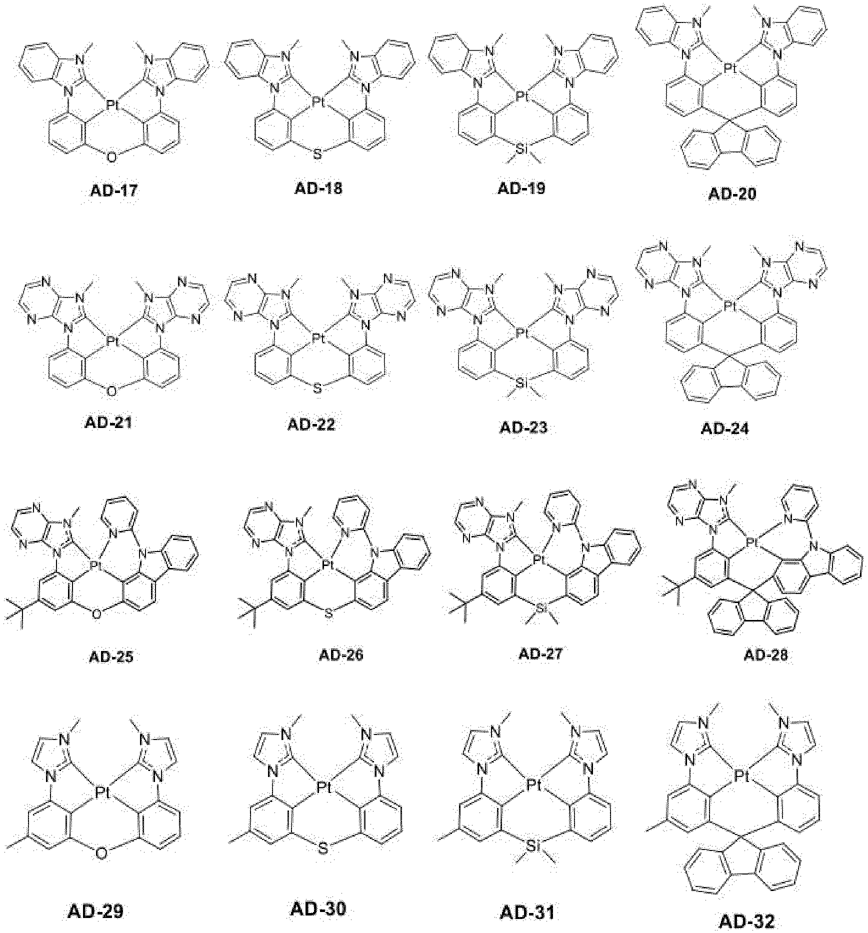

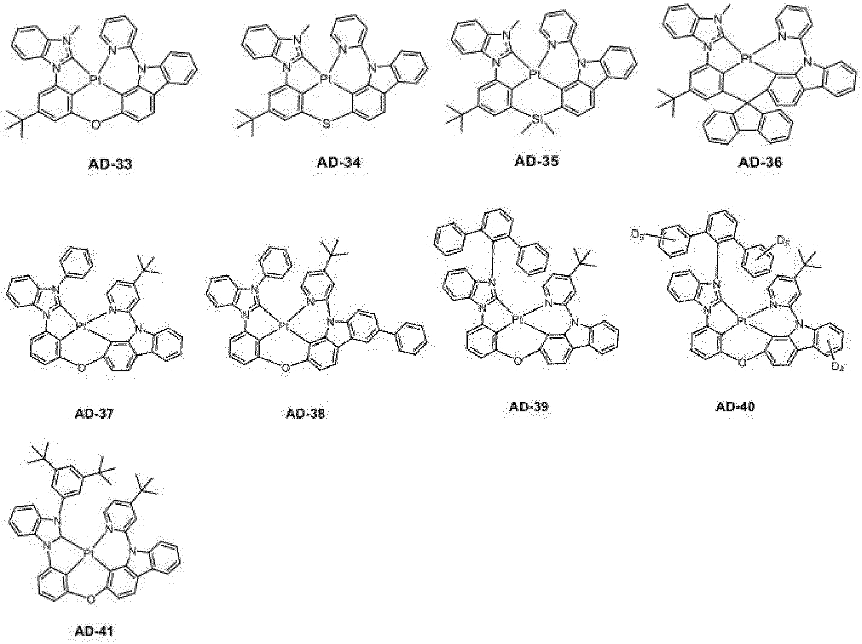

In Compound Group 4, D represents a deuterium atom.

In the light-emitting element ED, when the light-emitting layer EML includes the first compound, the second compound, and the third compound, and the fourth compound, an amount of the first compound may be in a range of about 0.1 wt% to about 5 wt%, with respect to a total weight of the first compound, the second compound, the third compound, and the fourth compound. However, embodiments are not limited thereto. When an amount of the first compound satisfies the range described above, energy transfer from the second compound and the third compound to the first compound may increase, so that luminous efficiency and device service life may increase.

In the light-emitting layer EML, a combined amount of the second compound and the third compound may be the remainder of the total weight of the first compound, the second compound, the third compound, and the fourth compound, excluding the amount of the first compound, and the fourth compound. For example, a combined amount of the second compound and the third compound in the light-emitting layer EML may be in a range of about 65 wt% to about 95 wt%, with respect to a total weight of the first compound, the second compound, the third compound, and the fourth compound.

Within the combined amount of the second compound and the third compound, a weight ratio of the second compound to the third compound may be in a range of about 3:7 to about 7:3.

When the amounts of the second compound and the third compound satisfy the above-described ranges and ratios, charge balance characteristics of the light-emitting layer EML may improve, and luminous efficiency and device service life may increase. When the amounts of the second compound and the third compound deviate from the above-described ranges and ratios, charge balance in the light-emitting layer EML may not be achieved, so that luminous efficiency may be reduced and the element may readily deteriorate.

When the light-emitting layer EML includes the fourth compound, an amount of the fourth compound in the light-emitting layer EML may be in a range of about 10 wt% to about 30 wt%, with respect to a total weight of the first compound, the second compound, the third compound, and the fourth compound. However, embodiments are not limited thereto. When an amount of the fourth compound satisfies the above-described range, energy transfer from a host (for example, an exciplex host) to the first compound, which is a light emitting dopant, may increase, so that an emission ratio may improve, and thus the luminous efficiency of the light-emitting layer EML may be improved. When the amounts of the first compound, the second compound, the third compound, and the fourth compound included in the light-emitting layer EML satisfy the above-described ranges and ratios, excellent luminous efficiency and long service life may be achieved.

In the light-emitting element ED according to embodiments as shown in FIGS. 3 to 7, the light-emitting layer EML may include the polycyclic compound according to an embodiment as described above. In the light-emitting element ED according to embodiments as shown in FIGS. 3 to 7, the light-emitting layer EML may include at least one of a first compound, which is the polycyclic compound according to an embodiment, the second compound represented by Formula HT-1, and the third compound represented by Formula ET-1. In the light-emitting element ED according to embodiments as shown in FIGS. 3 to 7, the light-emitting layer EML may include at least one of a first compound, which is the polycyclic compound according to an embodiment, the second compound represented by Formula HT-1, the third compound represented by Formula ET-1, and the fourth compound represented by Formula D-1.

In the light-emitting element ED, the light-emitting layer EML may include an anthracene derivative, a pyrene derivative, a fluoranthene derivative, a chrysene derivative, a dihydrobenzanthracene derivative, or a triphenylene derivative. For example, the light-emitting layer EML may include an anthracene derivative or a pyrene derivative.

In the light-emitting element ED according to embodiments as shown in each of FIGS. 3 to 7, the light-emitting layer EML may further include a host and a dopant of the related art, in addition to the above-described host and dopant.

In an embodiment the light-emitting layer EML may include a compound represented by Formula E-1. The compound represented by Formula E-1 may be used as a fluorescent host material.

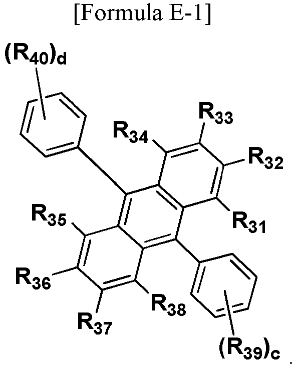

In Formula E-1, R₃, to R₄₀ may each independently be a hydrogen atom, a deuterium atom, a halogen atom, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, or a substituted or unsubstituted heteroaryl group having 2 to 30 ring-forming carbon atoms, or combined with an adjacent group to form a ring. For example, R₃₁ to R₄₀ may be combined with an adjacent group to form a saturated hydrocarbon ring, an unsaturated hydrocarbon ring, a saturated heterocycle, or an unsaturated heterocycle.

In Formula E-1, c and d may each independently be an integer from 0 to 5.

In an embodiment, the compound represented by Formula E-1 may be any compound selected from Compound E1 to Compound E19:

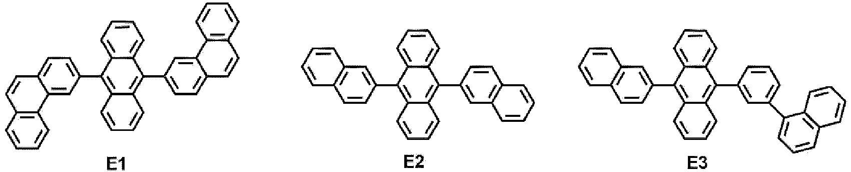

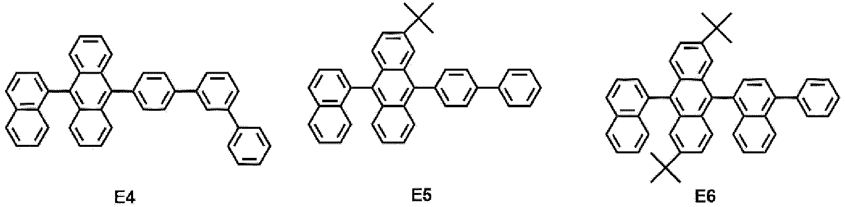

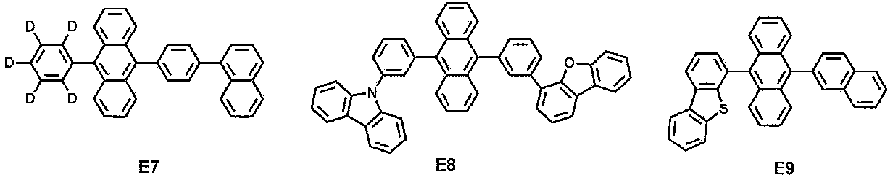

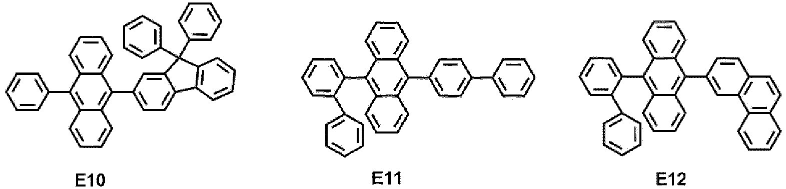

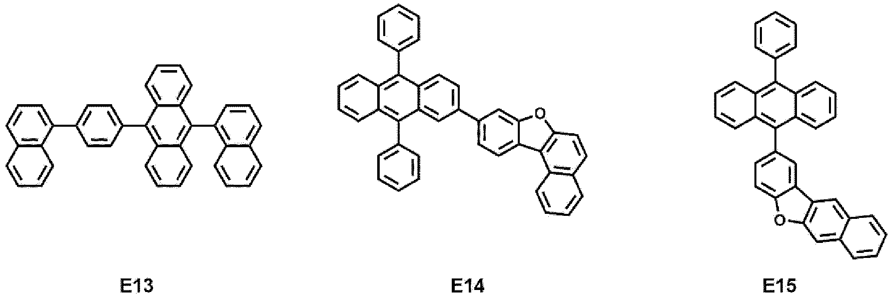

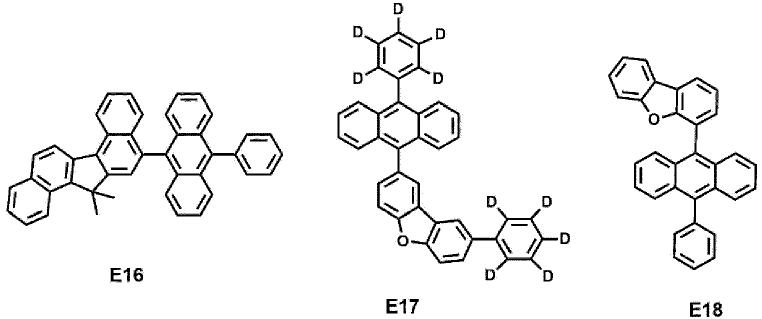

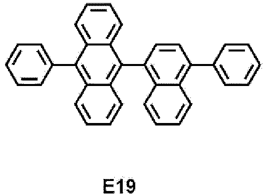

In an embodiment, the light-emitting layer EML may include a compound represented by Formula E-2a or Formula E-2b. The compound represented by Formula E-2a or Formula E-2b may be used as host material for a phosphorescent element.

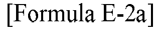

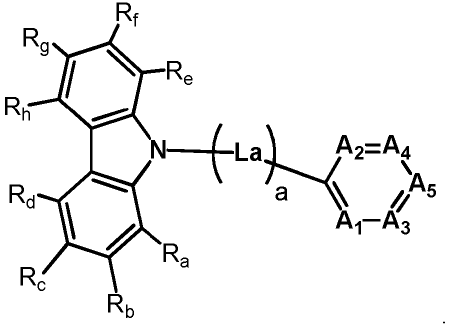

In Formula E-2a, a may be an integer from 0 to 10; and La may be a direct linkage, a substituted or unsubstituted arylene group having 6 to 30 ring-forming carbon atoms, or a substituted or unsubstituted heteroarylene group having 2 to 30 ring-forming carbon atoms. When a is 2 or greater, multiple La may each independently be a substituted or unsubstituted arylene group having 6 to 30 ring-forming carbon atoms or a substituted or unsubstituted heteroarylene group having 2 to 30 ring-forming carbon atoms.

In Formula E-2a, A₁ to A₅ may each independently be N or C(Rᵢ). In Formula E-2a, Rₐ to Rᵢ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or combined with an adjacent group to form a ring. For example, Rₐ to Rᵢ may be combined with an adjacent group to form a hydrocarbon ring or a heterocycle containing N, O, S*, etc.,* as a ring-forming atom.

In Formula E-2a, two or three of A₁ to A₅ may each be N, and the remainder of A₁ to A₅ may each independently be C(Rᵢ).

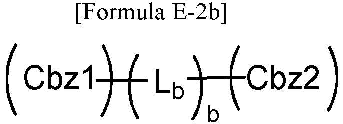

In Formula E-2b, Cbz1 and Cbz2 may each independently be an unsubstituted carbazole group, or a carbazole group substituted with an aryl group having 6 to 30 ring-forming carbon atoms. In Formula E-2b, L_{b} may be a direct linkage, a substituted or unsubstituted arylene group having 6 to 30 ring-forming carbon atoms, or a substituted or unsubstituted heteroarylene group having 2 to 30 ring-forming carbon atoms. In Formula E-2b, b may be an integer from 0 to 10. When b is 2 or more, multiple L_{b} may each independently be a substituted or unsubstituted arylene group having 6 to 30 ring-forming carbon atoms or a substituted or unsubstituted heteroarylene group having 2 to 30 ring-forming carbon atoms.

In an embodiment, the compound represented by Formula E-2a or Formula E-2b may be any compound selected from Compound Group E-2. However, the compounds listed in Compound Group E-2 are only example, and the compound represented by Formula E-2a or Formula E-2b is not limited to Compound Group E-2:

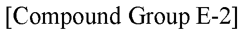

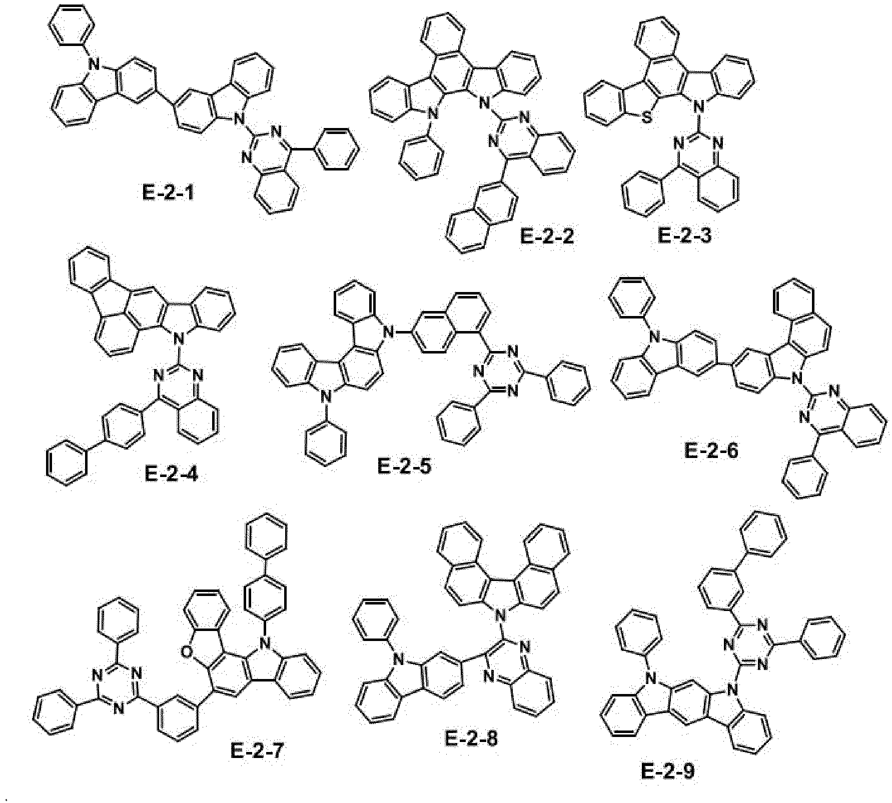

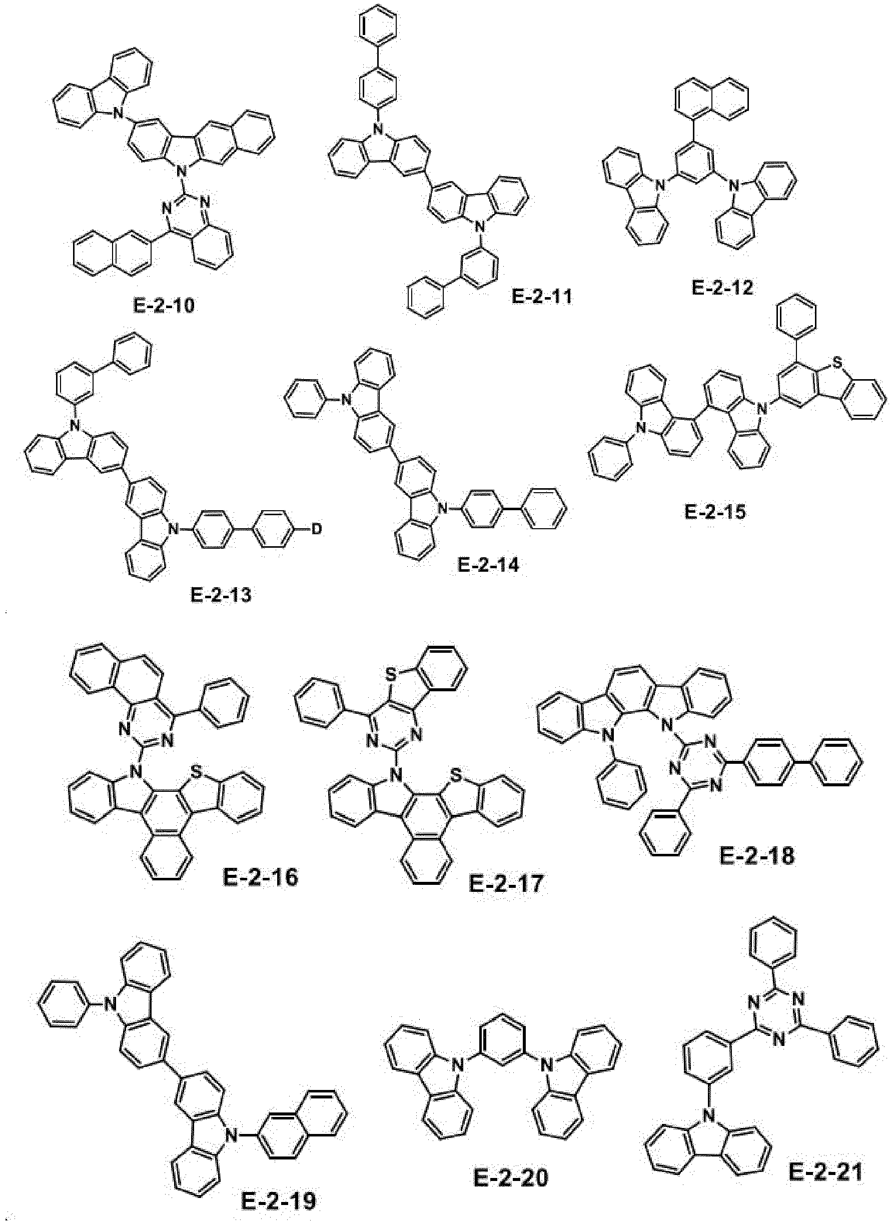

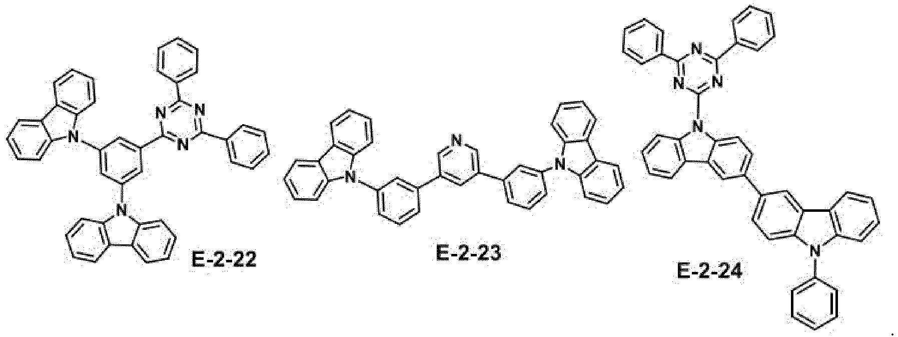

In an embodiment, the light-emitting layer EML may include a compound represented by Formula M-a. The compound represented by Formula M-a may be used as a phosphorescent dopant material.

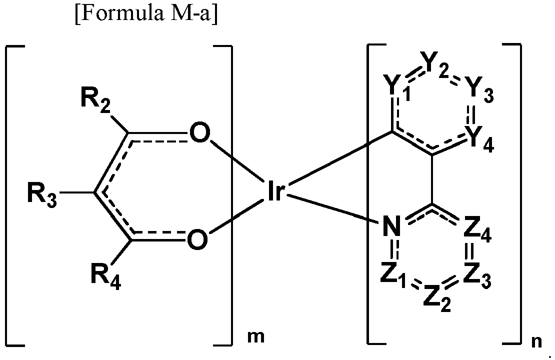

In Formula M-a, Y₁ to Y₄ and Z₁ to Z₄ may each independently be C(R₁) or N; and R₁ to R₄ may each independently be a hydrogen atom, a deuterium atom, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or combined with an adjacent group to form a ring. In Formula M-a, m may be 0 or 1, and n may be 2 or 3. In Formula M-a, when m is 0, n may be 3, and when m is 1, n may be 2.

In an embodiment, the compound represented by Formula M-a may be any compound selected from Compound M-a1 to Compound M-a25. However, Compounds M-a1 to M-a25 are only examples, and the compound represented by Formula M-a is not limited to Compounds M-a1 to M-a25:

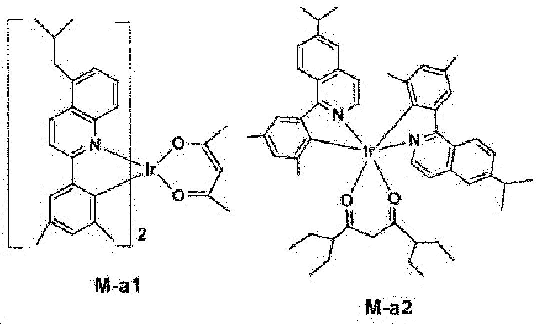

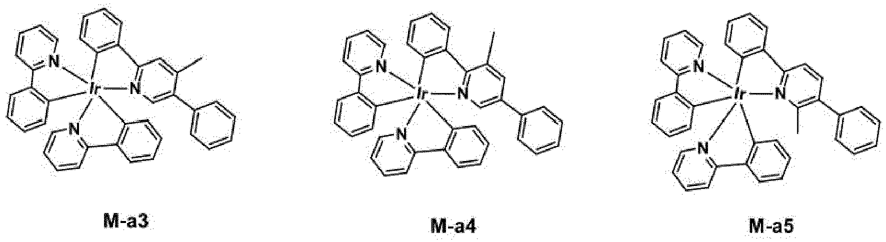

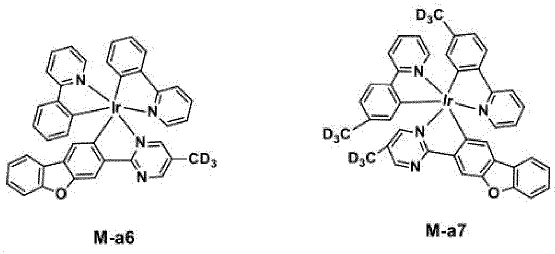

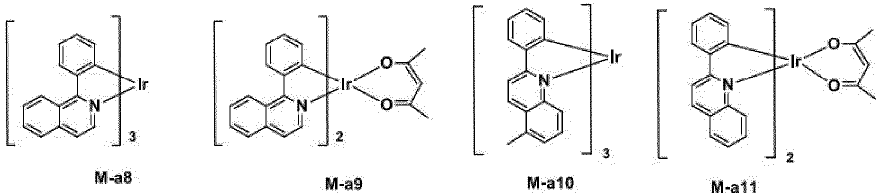

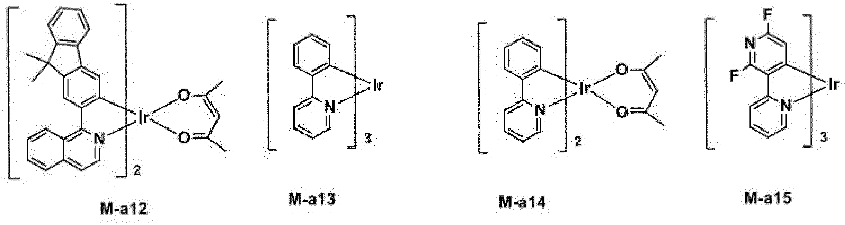

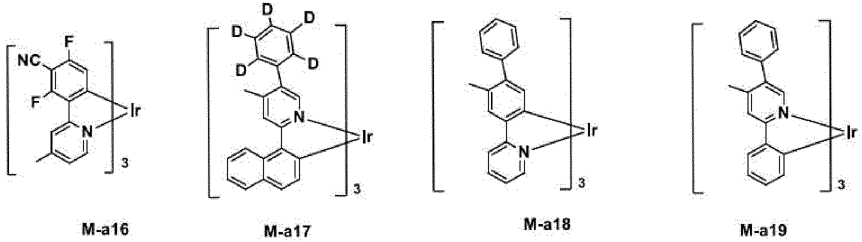

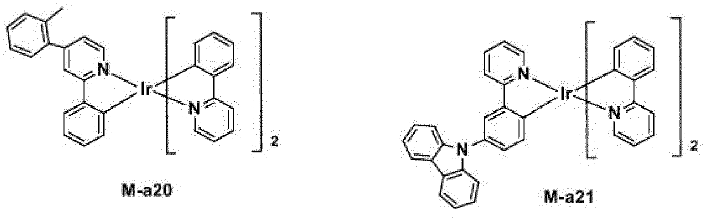

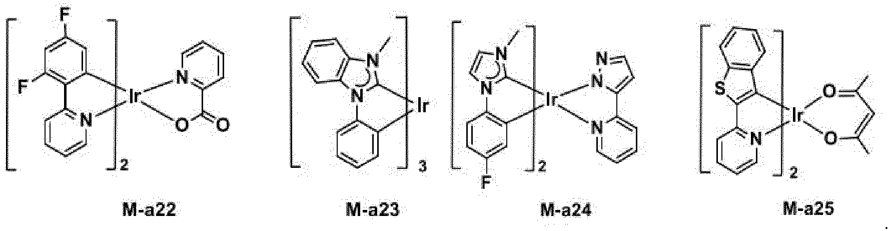

In an embodiment, the light-emitting layer EML may include a compound represented by one of Formula F-a to Formula F-c. The compound represented by one of Formula F-a to Formula F-c may be used as a fluorescent dopant material.

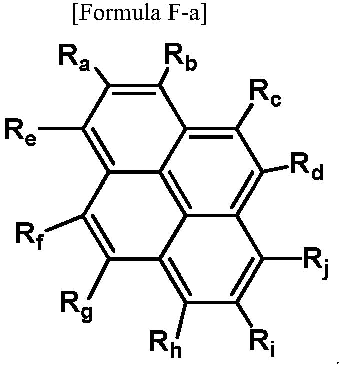

In Formula F-a, two of Rₐ to Rⱼ may each independently be substituted with a group represented by *-NAr₁Ar₂. The remainder of Rₐ to Rⱼ that are not substituted with the group represented by *-NAr₁Ar₂ may each independently be a hydrogen atom, a deuterium atom, a halogen atom, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In the group represented by * -NAr₁Ar₂, Ar₁ and Ar₂ may each independently be a substituted or unsubstituted aryl group having 6 to 30 ring-forming carbon atoms or a substituted or unsubstituted heteroaryl group having 2 to 30 ring-forming carbon atoms. For example, at least one of Ar₁ and Ar₂ may each independently be a heteroaryl group containing O or S as a ring-forming atom.

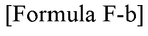

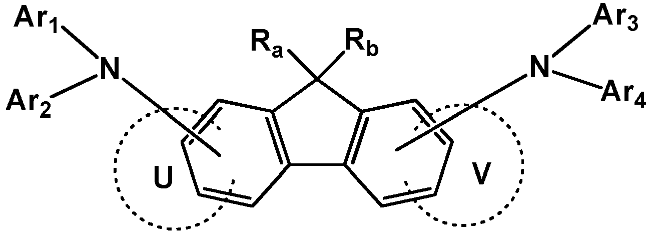

In Formula F-b, Rₐ and R_{b} may each independently be a hydrogen atom, a deuterium atom, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, or combined with an adjacent group to form a ring. In Formula F-b, Ar₁ to Ar₄ may each independently be a substituted or unsubstituted aryl group having 6 to 30 ring-forming carbon atoms or a substituted or unsubstituted heteroaryl group having 2 to 30 ring-forming carbon atoms. For example, at least one of Ar₁ to Ar₄ may each independently be a heteroaryl group containing O or S as a ring-forming atom.

In Formula F-b, U and V may each independently be a substituted or unsubstituted hydrocarbon ring having 5 to 30 ring-forming carbon atoms or a substituted or unsubstituted heterocycle having 2 to 30 ring-forming carbon atoms.

In Formula F-b, the number of rings represented by U and V may each independently be 0 or 1. When the number of U or V is 1, a fused ring may be present at a portion respectively indicated by U or V, and when the number of U or V is 0, a fused ring may not be present at the portion respectively indicated by U or V. When the number of U is 0 and the number of V is 1, or when the number of U is 1 and the number of V is 0, a fused ring having a fluorene core of Formula F-b may be a cyclic compound having four rings. When the number of U and V is each 0, a fused ring having a fluorene core of Formula F-b may be a cyclic compound having three rings. When the number of U and V is each 1, a fused ring having a fluorene core of Formula F-b may be a cyclic compound having five rings.

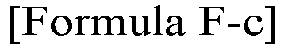

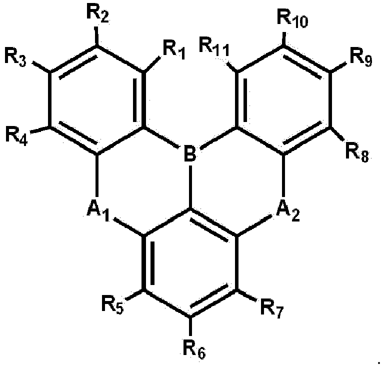

In Formula F-c, A₁ and A₂ may each independently be O, S, Se, or N(Rₘ); and Rₘ may be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. In Formula F-c, R₁ to R₁₁ may each independently be a hydrogen atom, a deuterium atom, a halogen atom, a cyano group, a substituted or unsubstituted amine group, a substituted or unsubstituted boryl group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or combined with an adjacent group to form a ring.

In Formula F-c, A₁ and A₂ may each independently be combined with a substituent of an adjacent ring to form a fused ring. For example, when A₁ and A₂ are each independently N(Rₘ), A₁ may be combined with R₄ or R₅ to form a fused ring, and/or A₂ may be combined with R₇ or R₈ to form a fused ring.

In an embodiment, the light-emitting layer EML may further include, as a dopant material of the related art, a styryl derivative (*e.g.,* 1,4-bis[2-(3-N-ethylcarbazolyl)vinyl]benzene (BCzVB), 4-(di-p-tolylamino)-4'-[(di-p-tolylamino)styryl]stilbene (DPAVB), and N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi)), perylene or a derivative thereof (*e.g.,* 2,5,8,11-tetra-t-butylperylene (TBP)), pyrene or a derivative thereof (*e.g.,* 1,1-dipyrene, 1,4-dipyrenylbenzene, 1,4-bis(N,N-diphenylamino)pyrene), *etc.*

The light-emitting layer EML may further include a phosphorescence dopant material of the related art. For example, a metal complex that includes iridium (Ir), platinum (Pt), osmium (Os), gold (Au), titanium (Ti), zirconium (Zr), hafnium (Hf), europium (Eu), terbium (Tb), or thulium (Tm) may be used as a phosphorescent dopant. For example, iridium(III) bis(4,6-difluorophenylpyridinato-N,C2) picolinato (FIrpic), bis(2,4-difluorophenylpyridinato)-tetrakis(1-pyrazolyl)borate iridium(III) (FI r6), or platinum octaethyl porphyrin (PtOEP) may be used as a phosphorescent dopant. However, embodiments are not limited thereto.

In an embodiment, the light-emitting layer EML may include a quantum dot. The quantum dot may include a Group II-VI compound, a Group I-II-VI compound, a Group II-IV-VI compound, a Group I-II-IV-VI compound, a Group III-VI compound, a Group I-III-VI compound, a Group III-V compound, a Group III-II-V compound, a Group IV-VI compound, a Group IV element, a Group IV compound, or a combination thereof.

Examples of a Group II-VI compound may include: a binary compound such as CdSe, CdTe, CdS, ZnS, ZnSe, ZnTe, ZnO, HgS, HgSe, HgTe, MgSe, MgS, and a mixture thereof; a ternary compound such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof; a quaternary compound such as HgZnTeS, CdZnSeS, CdZnSeTe, CdZnSTe, CdHgSeS, CdHgSeTe, CdHgSTe, HgZnSeS, HgZnSeTe, and a mixture thereof; and any combination thereof. In an embodiment, a Group II-VI compound may further include a Group I metal and/or a Group IV element. Examples of a Group I-II-VI compound may include CuZnS; and examples of a Group II-IV-VI compound may include ZnSnS, etc. Examples of a Group I-II-IV-VI compound may include a quaternary compound such as Cu₂ZnSnS₂, Cu₂ZnSnS₄, Cu₂ZnSnSe₄, Ag₂ZnSnS₂, and a mixture thereof.

Examples of a Group III-VI compound may include: a binary compound such as In₂S₃ and In₂Se₃; a ternary compound such as InGaS₃ or InGaSe₃; and any combination thereof.

Examples of a Group I-III-VI compound may include: a ternary compound such as AgInS, AgInS₂, CuInS, CuInS₂, AgGaS₂, CuGaS₂ CuGaO₂, AgGaO₂, AgAlO₂, and a mixture thereof; a quaternary compound such as AgInGaS, AgInGaS₂, AgInGaSe, AgInGaSe₂, CuInGaS, and CuInGaS₂; and any combination thereof.

Examples of a Group III-V compound may include: a binary compound such as GaN, GaP, GaAs, GaSb, AlN, AlP, AlAs, AlSb, InN, InP, InAs, InSb, and a mixture thereof; a ternary compound such as GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and a mixture thereof; a quaternary compound such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof; and any combination thereof. In an embodiment, a Group III-V compound may further include a Group II metal. Examples of a Group III-II-V compound may include InZnP, *etc.*

Examples of a Group IV-VI compound may include: a binary compound such as SnS, SnSe, SnTe, PbS, PbSe, PbTe, and a mixture thereof; a ternary compound such as SnSeS, SnSeTe, SnSTe, PbSeS, PbSeTe, PbSTe, SnPbS, SnPbSe, SnPbTe, and a mixture thereof; a quaternary compound such as SnPbSSe, SnPbSeTe, SnPbSTe, and a mixture thereof; and any combination thereof. Examples of a Group IV element may include Si, Ge, and a mixture thereof. Examples of a Group IV compound may include a binary compound such as SiC, SiGe, and a mixture thereof.

Each element included in a compound, such as a binary compound, a ternary compound, or a quaternary compound, may be present in a particle at a uniform concentration distribution or at a non-uniform concentration distribution. For example, a formula may indicate the elements that are included in a compound, but an elemental ratio of the compound may vary. For example, AgInGaS₂ may indicate AgInₓGa₁₋ₓS₂ (where x is a real number satisfying 0 <x< 1).

In an embodiment, the quantum dot may have a single structure, in which the concentration of each element included in the quantum dot is uniform. In another embodiment, the quantum dot may have a core-shell structure in which a quantum dot surrounds another quantum dot. For example, a material included in the core may be different from a material included in the shell.

The shell of a quantum dot may serve as a protection layer that prevents chemical deformation of the core to maintain semiconductor properties, and/or may serve as a charging layer that imparts electrophoretic properties to the quantum dot. The shell may have a single-layered structure or a multilayered structure. An interface between the core and the shell may have a concentration gradient in which the concentration of an element that is present in the shell decreases towards the center.

Examples of a shell of a quantum dot may include a metal oxide, a non-metal oxide, a semiconductor compound, and a combination thereof. Examples of a metal oxide or a non-metal oxide may include a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, and NiO; and a ternary compound such as MgAl₂O₄, CoFe₂O₄, NiFe₂O₄, and CoMn₂O₄, but embodiments are not limited thereto.

Examples of a semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, *etc.,* but embodiments are not limited thereto.

A quantum dot may have a full width at half maximum (FWHM) of an emission wavelength spectrum equal to or less than about 45 nm. For example, the quantum dot may have an FWHM of an emission wavelength spectrum equal to or less than about 40 nm. For example, the quantum dot may have an FWHM of an emission wavelength spectrum equal to or less than about 30 nm. Within any of the above ranges, color purity or color reproducibility may be improved. Light emitted through a quantum dot may be emitted in all directions, so that a wide viewing angle may be improved.

The form of a quantum dot is not particularly limited, and may be any shape that is used in the related art. For example, a quantum dot may have a spherical shape, a pyramidal shape, a multi-arm shape, or a cubic shape, or a quantum dot may be in the form of nanoparticles, nanotubes, nanowires, nanofibers, nanoplate particles, *etc.*

As a size of a quantum dot is adjusted or an elemental ratio of a quantum dot compound is adjusted, an energy band gap may be controlled accordingly, so that light in various wavelength ranges may be obtained from a quantum dot light-emitting layer. Therefore, by utilizing quantum dots as described above (using different sizes of quantum dots or different elemental ratios of a quantum dot compound), a light-emitting element that emits light in various wavelengths may be implemented. For example, a size of a quantum dot or an elemental ratio of a quantum dot compound may be adjusted to emit red light, green light, and/or blue light. In an embodiment, quantum dots may be configured to emit white light by combining various colors of light.

In the light-emitting elements ED according to embodiments as shown in each of FIGS. 3 to 7, the electron transport region ETR may be provided on the light-emitting layer EML. The electron transport region ETR may include at least one of a hole blocking layer HBL, an electron transport layer ETL, and an electron injection layer EIL, but embodiments are not limited thereto.

The electron transport region ETR may have a structure consisting of a layer consisting of a single material, a structure consisting of a layer including different materials, or a structure including multiple layers including different materials.

For example, the electron transport region ETR may have a single-layered structure of an electron injection layer EIL or an electron transport layer ETL, or may have a single-layered structure formed of an electron injection material and an electron transport material. The electron transport region ETR may have a single-layered structure formed of different materials. In embodiments, the electron transport region ETR may have an electron transport layer ETL/electron injection layer EIL structure, or a hole blocking layer HBL/electron transport layer ETL/electron injection layer EIL structure, in which the layers of each structure are stacked from the light-emitting layer EML in its respective stated order, but embodiments are not limited thereto. The electron transport region ETR may have a thickness, for example, in a range of about 1,000 Å to about 1,500 Å.

The electron transport region ETR may be formed using various methods such as a vacuum deposition method, a spin coating method, a cast method, a Langmuir-Blodgett (LB) method, an inkjet printing method, a laser printing method, and a laser induced thermal imaging (LITI) method.

In the light-emitting element ED according to an embodiment, the electron transport region ETR may include a compound represented by Formula ET-2:

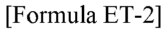

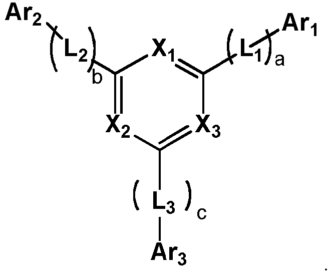

In Formula ET-2, at least one of X₁ to X₃ may each be N; and the remainder of X₁ to X₃ may each independently be C(Rₐ). In Formula ET-2, Rₐ may be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. In Formula ET-2, Ar₁ to Ar₃ may each independently be a hydrogen atom, a deuterium atom, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In Formula ET-2, a to c may each independently be an integer from 0 to 10. In Formula ET-2, L₁ to L₃ may each independently be a direct linkage, a substituted or unsubstituted arylene group having 6 to 30 ring-forming carbon atoms, or a substituted or unsubstituted heteroarylene group having 2 to 30 ring-forming carbon atoms. When a to c are each 2 or more, multiple groups of each of L₁ to L₃ may each independently be a substituted or unsubstituted arylene group having 6 to 30 ring-forming carbon atoms or a substituted or unsubstituted heteroarylene group having 2 to 30 ring-forming carbon atoms.

The electron transport region ETR may include an anthracene-based compound. However, embodiments are not limited thereto, and the electron transport region ETR may include, for example, tris(8-hydroxyquinolinato)aluminium (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1-yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenylyl)-5-(4*-tert*-butylphenyl)-1,3,4-oxadiazole (tBu-PBD), bis(2-methyl-8-quinolinolato-N1,O8)-(1,1'-biphenyl-4-olato)aluminum (BAlq), beryllium bis(benzoquinolin-10-olate) (Bebq₂), 9,10-di(naphthalene-2-yl)anthracene (ADN), 1,3-bis[3,5-di(pyridin-3-yl)phenyl]benzene (BmPyPhB), CNNPTRZ (4'-(4-(4-(4,6-diphenyl-1,3,5-triazin-2-yl)phenyl)naphthalen-1-yl)-[1,1'-biphenyl]-4-carbonitrile), or a mixture thereof.

In an embodiment, the electron transport region ETR may include a compound selected from Compound Group 3 as described above.

In an embodiment, the electron transport region ETR may include at least one of Compound ET1 to Compound ET36:

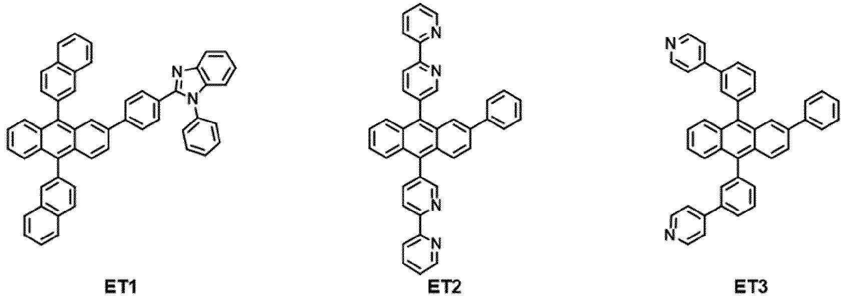

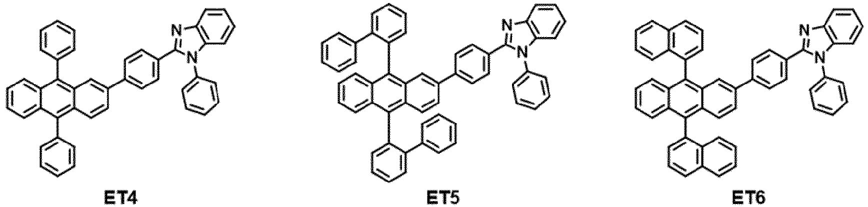

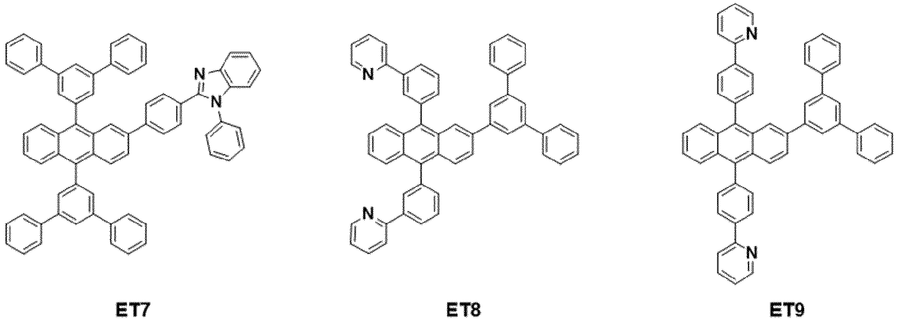

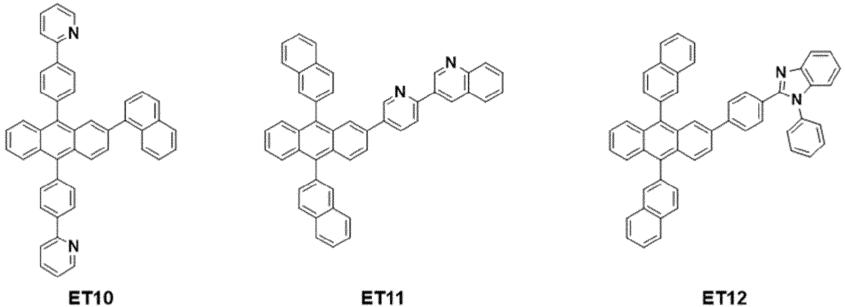

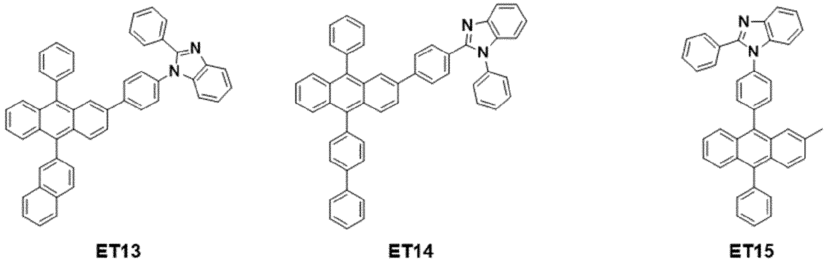

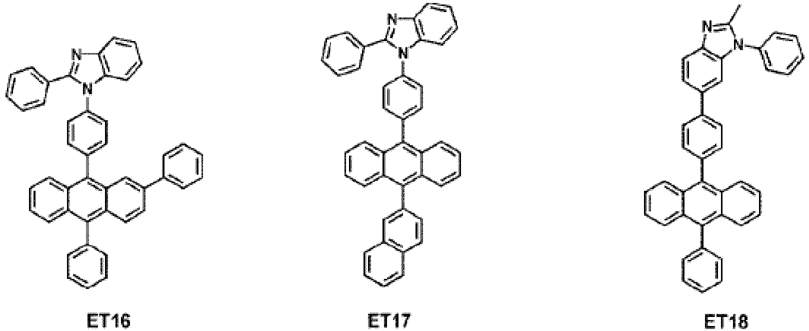

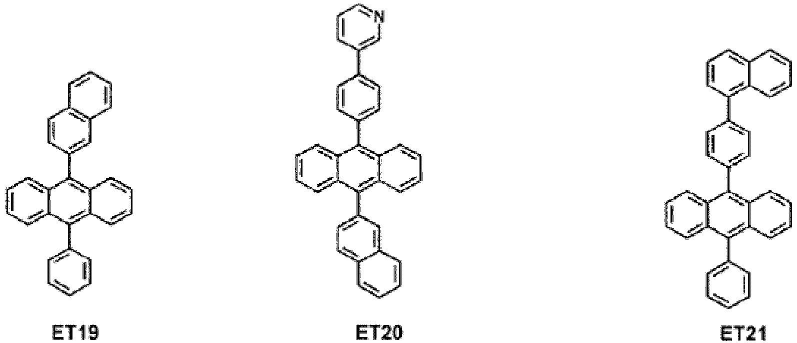

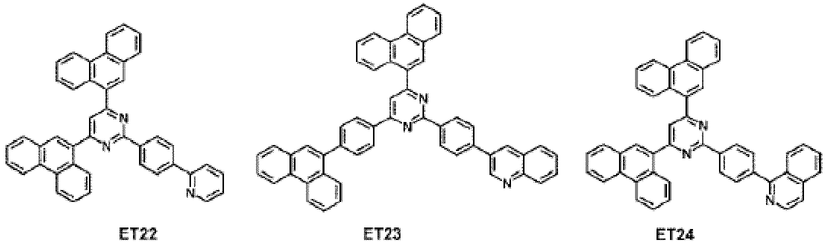

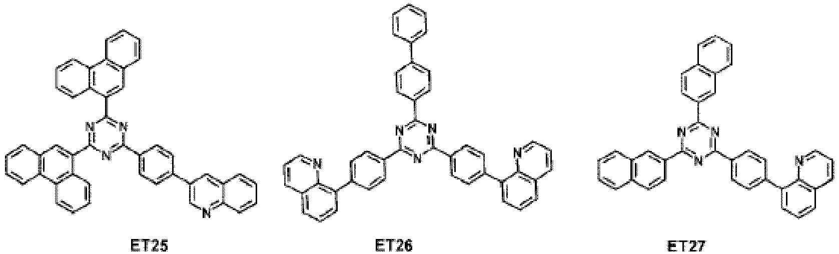

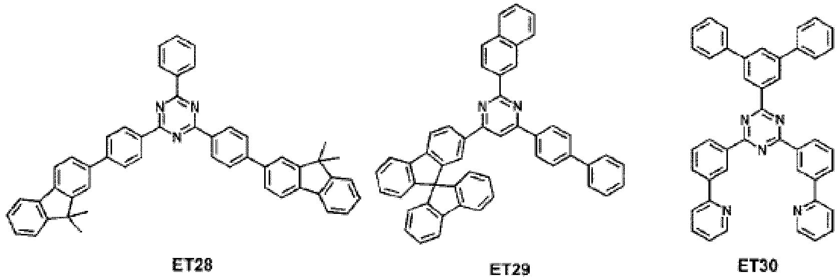

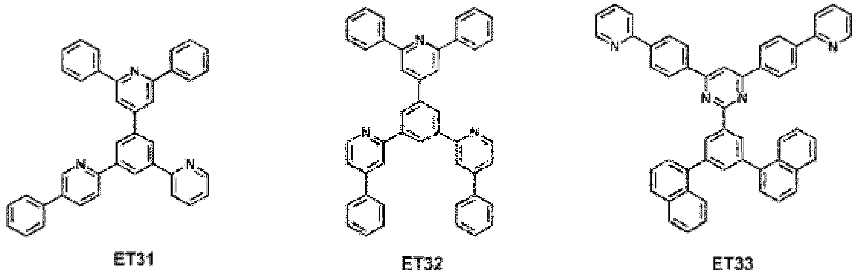

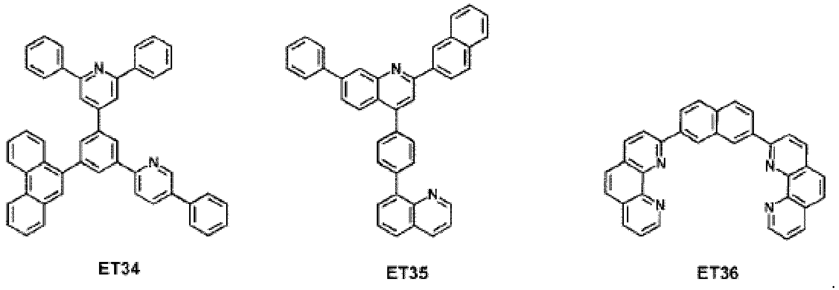

In an embodiment, the electron transport region ETR may include: a metal halide such as LiF, NaCl, CsF, RbCl, RbI, CuI, and KI; a lanthanide metal such as Yb; or a co-deposited material of a metal halide and a lanthanide metal. For example, the electron transport region ETR may include KI:Yb, RbI:Yb, LiF:Yb, *etc.,* as a co-deposited material. The electron transport region ETR may include a metal oxide such as Li₂O or BaO, or 8-hydroxyl-lithium quinolate (Liq), *etc.,* but embodiments are not limited thereto. In another embodiment, the electron transport region ETR may include a mixture of an electron transport material and an insulating organometallic salt. The organometallic salt may be a material having an energy band gap equal to or greater than about 4 eV. For example, the organometallic salt may include a metal acetate, a metal benzoate, a metal acetoacetate, a metal acetylacetonate, or a metal stearate.

The electron transport region ETR may further include at least one of 2,9-dimethyl-4,7-diphenyl-1,10-phenanthroline (BCP), diphenyl(4-(triphenylsilyl)phenyl)phosphine oxide (TSPO1), and 4,7-diphenyl-1,10-phenanthroline (Bphen) in addition to the above-described materials, but embodiments are not limited thereto.

The electron transport region ETR may include the above-described compounds of the electron transport region in at least one of an electron injection layer EIL, an electron transport layer ETL, and a hole blocking layer HBL.

When the electron transport region ETR includes an electron transport layer ETL, the electron transport layer ETL may have a thickness in a range of about 100 Å to about 1,000 Å. For example, the electron transport layer ETL may have a thickness in a range of about 150 Å to about 500 Å. If the thickness of the electron transport layer ETL satisfies any of the aforementioned ranges, satisfactory electron transport characteristics may be obtained without a substantial increase in driving voltage. When the electron transport region ETR includes an electron injection layer EIL, the electron injection layer EIL may have a thickness in a range of about 1 Å to about 100 Å. For example, the electron injection layer EIL may have a thickness in a range of about 3 Å to about 90 Å. If the thickness of the electron injection layer EIL satisfies any of the above-described ranges, satisfactory electron injection characteristics may be obtained without a substantial increase in driving voltage.

The second electrode EL2 may be provided on the electron transport region ETR. The second electrode EL2 may be a common electrode. The second electrode EL2 may be a cathode or an anode, but embodiments are not limited thereto. For example, when the first electrode EL1 is an anode, the second electrode EL2 may be a cathode, and when the first electrode EL1 is a cathode, the second electrode EL2 may be an anode.

The second electrode EL2 may be a transmissive electrode, a transflective electrode, or a reflective electrode. When the second electrode EL2 is a transmissive electrode, the second electrode EL2 may include a transparent metal oxide, for example, indium tin oxide (ITO), indium zinc oxide (IZO), zinc oxide (ZnO), indium tin zinc oxide (ITZO), *etc.*

When the second electrode EL2 is a transflective electrode or a reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, a compound thereof, or a mixture thereof (e.g., AgMg, AgYb, or MgYb). In an embodiment, the second electrode EL2 may have a multilayered structure that includes a reflective film or a transflective film formed of the above-described materials, and a transparent conductive film formed of ITO, IZO, ZnO, ITZO, *etc.* For example, the second electrode EL2 may include the above-described metal materials, combinations of at least two of the above-described metal materials, oxides of the above-described metal materials, or the like.

Although not shown in the drawings, in an embodiment, the second electrode EL2 may be electrically connected to an auxiliary electrode. If the second electrode EL2 is electrically connected to an auxiliary electrode, resistance of the second electrode EL2 may decrease.

In an embodiment, the light-emitting element ED may further include a capping layer CPL disposed on the second electrode EL2. The capping layer CPL may have a multilayered structure or a single-layered structure.

In an embodiment, the capping layer CPL may include an organic layer or an inorganic layer. For example, when the capping layer CPL includes an inorganic material, the inorganic material may include an alkaline metal compound (*e.g*., LiF), an alkaline earth metal compound (*e.g.,* MgF₂), SiON, SiNₓ, SiO_{y}, *etc.*

For example, when the capping layer CPL includes an organic material, the organic material may include α-NPD, NPB, TPD, m-MTDATA, Alq₃, CuPc, N4,N4,N4',N4'-tetra(biphenyl-4-yl)biphenyl-4,4'-diamine (TPD15), 4,4',4"-tris(carbazol-9-yl)triphenylamine (TCTA), etc., or may include an epoxy resin, or as acrylate such as methacrylate. However, embodiments are not limited thereto, and the capping layer CPL may include at least one of Compounds P1 to P5:

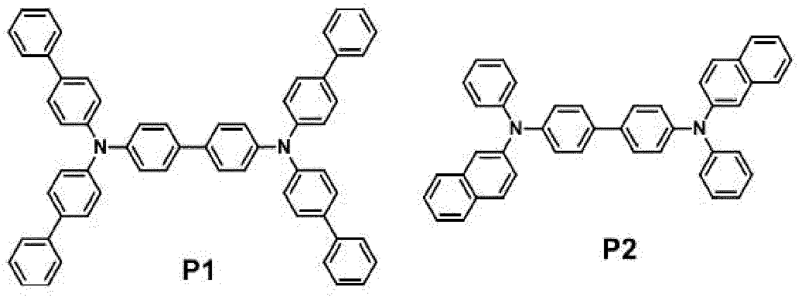

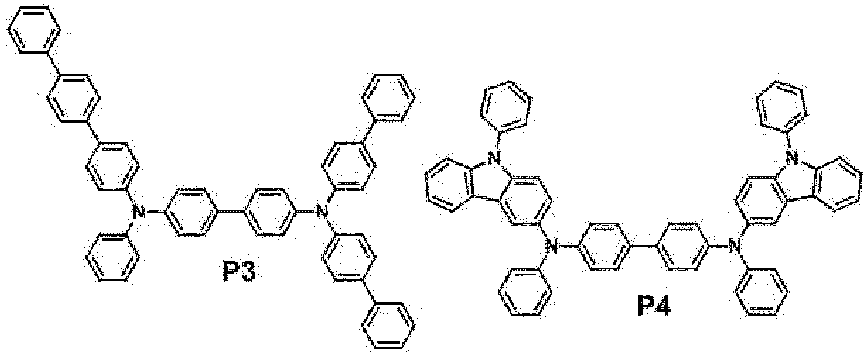

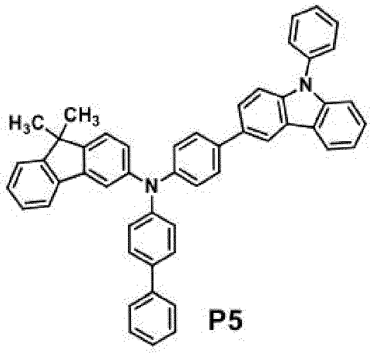

A refractive index of the capping layer CPL may be equal to or greater than about 1.6. For example, the refractive index of the capping layer CPL may be equal to or greater than about 1.6, with respect to light in a wavelength range of about 550 nm to about 660 nm.

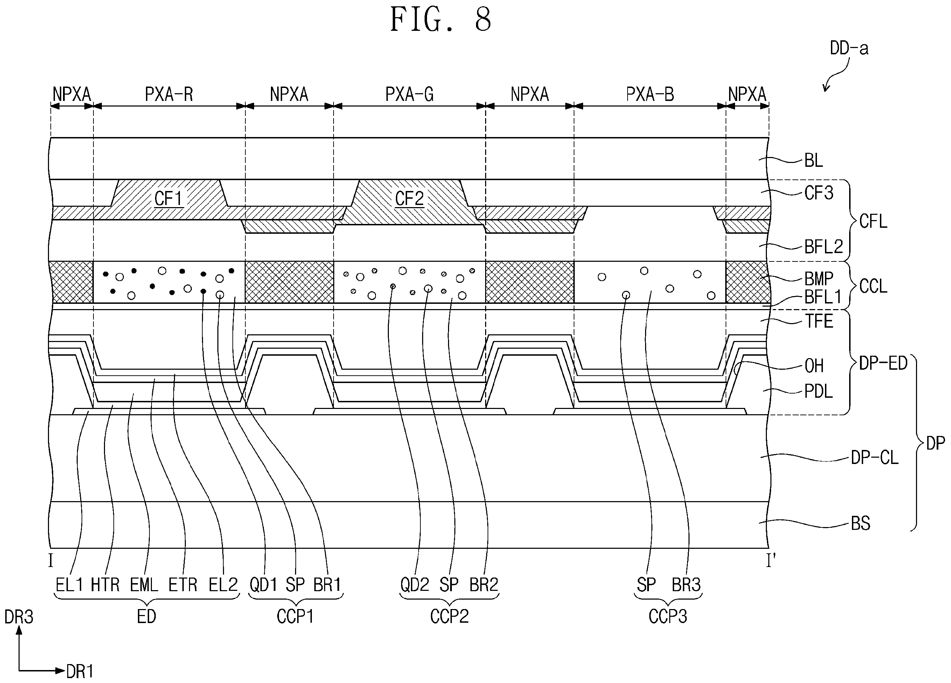

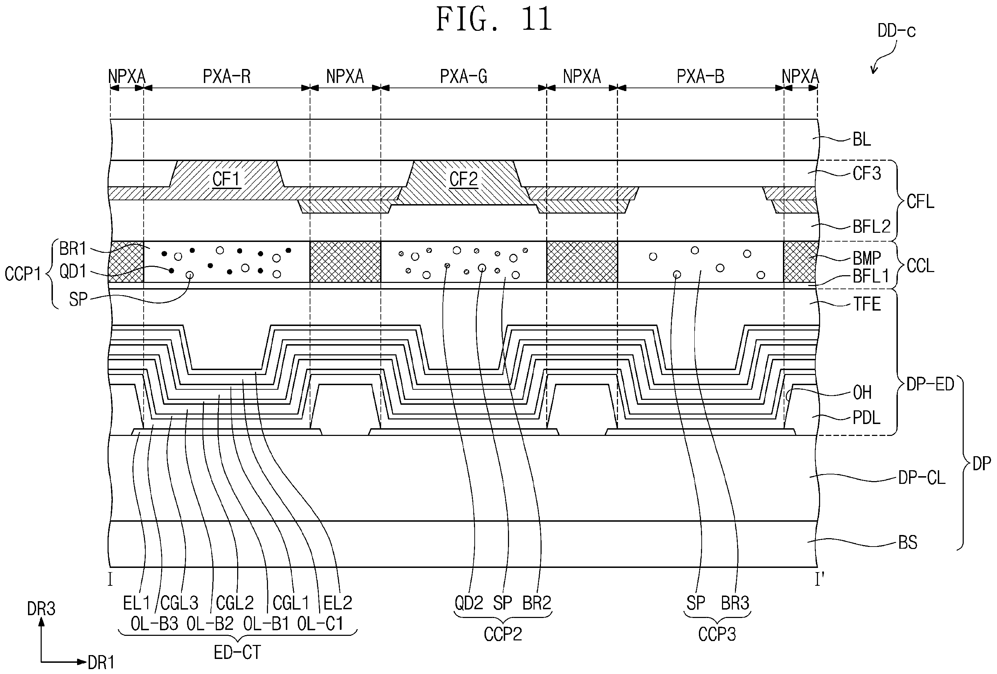

FIGS. 8 to 11 are each a schematic cross-sectional view of a display device according to embodiments. Hereinafter, in the description of the display devices according to embodiments as shown in FIGS. 8 to 11, the features that have been described above with respect to FIGS. 1 to 7 will not be explained again, and the differing features will be described.

Referring to FIG. 8, a display device DD-a according to an embodiment may include a display panel DP that includes a display element layer DP-ED, a light control layer CCL disposed on the display panel DP, and a color filter layer CFL. In an embodiment shown in FIG. 8, the display panel DP may include a base layer BS, a circuit layer DP-CL provided on the base layer BS, and the display element layer DP-ED, and the display device layer DP-ED may include a light-emitting element ED.

The light-emitting element ED may include a first electrode EL1, a hole transport region HTR disposed on the first electrode EL1, a light-emitting layer EML disposed on the hole transport region HTR, an electron transport region ETR disposed on the light-emitting layer EML, and a second electrode EL2 disposed on the electron transport region ETR. In embodiments, a structure of the light-emitting element ED shown in FIG. 8 may be the same as a structure of a light-emitting element ED according to one of FIGS. 3 to 7 as described above. The light-emitting elements ED shown in FIG. 8 may include the polycyclic compound according to an embodiment, and at least one of the second, third, and fourth compounds as described above. Accordingly, the light-emitting element ED may exhibit characteristics such as high efficiency and long lifespan.

Referring to FIG. 8, the light-emitting layer EML may be disposed in an opening OH defined in a pixel defining film PDL. For example, the light-emitting layer EML which is separated by the pixel defining film PDL and provided to correspond to each of the light emitting regions PXA-R, PXA-G, and PXA-B, may emit light in a same wavelength range. In the display device DD-a, the light-emitting layer EML may emit blue light. Although not shown in the drawings, in an embodiment, the light-emitting layer EML may be provided as a common layer for all of the light emitting regions PXA-R, PXA-G, and PXA-B.

The light control layer CCL may be disposed on the display panel DP. The light control layer CCL may include a light conversion body. The light conversion body may be a quantum dot, a phosphor, or the like. The light conversion body may convert the wavelength of a provided light and emit the resulting light. For example, the light control layer CCL may be a layer that includes a quantum dot or a layer that includes a phosphor.

The light control layer CCL may include light control parts CCP1, CCP2, and CCP3. The light control parts CCP1, CCP2, and CCP3 may be spaced apart from each other.

Referring to FIG. 8, divided patterns BMP may be disposed between the light control parts CCP1, CCP2, and CCP3, which are spaced apart from each other, but embodiments are not limited thereto. In FIG. 8, it is shown that the divided patterns BMP do not overlap the light control parts CCP1, CCP2, and CCP3, but the edges of the light control parts CCP1, CCP2, and CCP3 may overlap at least a portion of the divided patterns BMP.

The light control layer CCL may include a first light control part CCP1 including a first quantum dot QD1 that converts first color light provided from the light-emitting element ED into second color light, a second light control part CCP2 including a second quantum dot QD2 that converts the first color light into third color light, and a third light control part CCP3 that transmits the first color light.

In an embodiment, the first light control part CCP1 may provide red light, which is the second color light, and the second light control part CCP2 may provide green light, which is the third color light. The third light control part CCP3 may provide blue light by transmitting the blue light, which is the first color light provided from the light-emitting element ED. For example, the first quantum dot QD1 may be a red quantum dot, and the second quantum dot QD2 may be a green quantum dot. The quantum dots QD1 and QD2 may each be a quantum dot as described above.

The light control layer CCL may further include a scatterer SP. The first light control part CCP1 may include the first quantum dot QD1 and the scatterer SP, the second light control part CCP2 may include the second quantum dot QD2 and the scatterer SP, and the third light control part CCP3 may not include any quantum dot but may include the scatterer SP.

The scatterer SP may be inorganic particles. For example, the scatterer SP may include at least one of TiO₂, ZnO, Al₂O₃, SiO₂, and hollow silica. The scatterer SP may include one of TiO₂, ZnO, Al₂O₃, SiO₂, and hollow silica, or may be a mixture of at least two materials selected from TiO₂, ZnO, Al₂O₃, SiO₂, and hollow silica.

The first light control part CCP1, the second light control part CCP2, and the third light control part CCP3 may respectively include base resins BR1, BR2, and BR3 in which the quantum dots QD1 and QD2 and the scatterer SP are dispersed. In an embodiment, the first light control part CCP1 may include the first quantum dot QD1 and the scatterer SP dispersed in a first base resin BR1, the second light control part CCP2 may include the second quantum dot QD2 and the scatterer SP dispersed in a second base resin BR2, and the third light control part CCP3 may include the scatterer SP dispersed in a third base resin BR3.

The base resins BR1, BR2, and BR3 are media in which the quantum dots QD1 and QD2 and the scatterer SP are dispersed, and may include various resin compositions, which may be referred to as a binder. For example, the base resins BR1, BR2, and BR3 may be acrylic-based resins, urethane-based resins, silicone-based resins, epoxy-based resins, *etc.* The base resins BR1, BR2, and BR3 may each be a transparent resin. In an embodiment, the first base resin BR1, the second base resin BR2, and the third base resin BR3 may be the same as or different from each other.

The light control layer CCL may include a barrier layer BFL1. The barrier layer BFL1 may prevent the penetration of moisture and/or oxygen (hereinafter, referred to as 'moisture/oxygen'). The barrier layer BFL1 may block the light control parts CCP1, CCP2, and CCP3 from exposure to moisture/oxygen. The barrier layer BFL1 may cover the light control parts CCP1, CCP2, and CCP3. In an embodiment, a barrier layer BFL2 may be provided between the light control parts CCP1, CCP2, and CCP3, and the filters CF1, CF2, and CF3.

The barrier layers BFL1 and BFL2 may each independently include at least one inorganic layer. For example, the barrier layers BFL1 and BFL2 may each independently include an inorganic material. For example, the barrier layers BFL1 and BFL2 may each independently include a silicon nitride, an aluminium nitride, a zirconium nitride, a titanium nitride, a hafnium nitride, a tantalum nitride, a silicon oxide, an aluminium oxide, a titanium oxide, a tin oxide, a cerium oxide, a silicon oxynitride, a metal thin film that secures light transmittance, *etc.* The barrier layers BFL1 and BFL2 may each further include an organic film. The barrier layers BFL1 and BFL2 may be formed of a single layer or of multiple layers.

In the display device DD-a, the color filter layer CFL may be disposed on the light control layer CCL. In an embodiment, the color filter layer CFL may be directly disposed on the light control layer CCL. For example, the barrier layer BFL2 may be omitted.

The color filter layer CFL may include filters CF1, CF2, and CF3. The color filter layer CFL may include a first filter CF1 that transmits the second color light, a second filter CF2 that transmits the third color light, and a third filter CF3 that transmits the first color light. For example, the first filter CF1 may be a red filter, the second filter CF2 may be a green filter, and the third filter CF3 may be a blue filter. The filters CF1, CF2, and CF3 may each include a polymeric photosensitive resin and a pigment or dye. The first filter CF1 may include a red pigment or dye, the second filter CF2 may include a green pigment or dye, and the third filter CF3 may include a blue pigment or dye.

However, embodiments are not limited thereto, and the third filter CF3 may not include a pigment or dye. The third filter CF3 may include a polymeric photosensitive resin and may not include a pigment or dye. The third filter CF3 may be transparent. The third filter CF3 may be formed of a transparent photosensitive resin.

In an embodiment, the first filter CF1 and the second filter CF2 may each be a yellow filter. The first filter CF1 and the second filter CF2 may not be provided as separate filters and may be provided as a unitary filter.

Although not shown in the drawings, in an embodiment, the color filter layer CFL may further include a light shielding part (not shown). The light shielding part (not shown) may be a black matrix. The light shielding part (not shown) may include an organic light shielding material or an inorganic light shielding material, each including a black pigment or a black dye. The light shielding part (not shown) may prevent light leakage, and may separate the boundaries between adjacent filters CF1, CF2, and CF3.

The first to third filters CF1, CF2, and CF3 may be disposed so that they respectively correspond to the red light emitting region PXA-R, the green light emitting region PXA-G, and the blue light emitting region PXA-B.

A base substrate BL may be disposed on the color filter layer CFL. The base substrate BL may provide a base surface on which the color filter layer CFL, the light control layer CCL, and the like are disposed. The base substrate BL may be a glass substrate, a metal substrate, a plastic substrate, *etc.* However, embodiments are not limited thereto, and the base substrate BL may include an inorganic layer, an organic layer, or a composite material layer. Although not shown in the drawings, in an embodiment, the base substrate BL may be omitted.

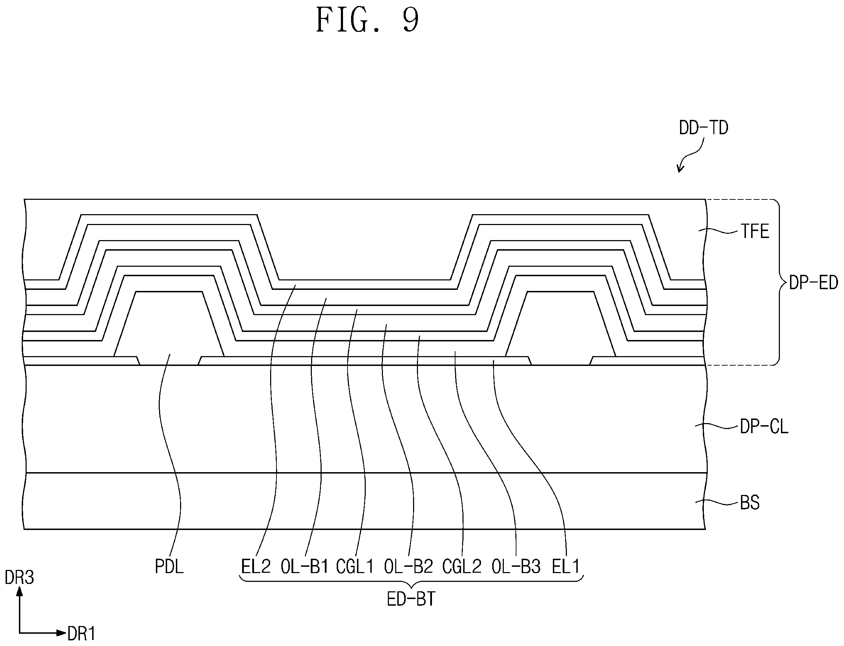

FIG. 9 is a schematic cross-sectional view of a portion of a display device according to an embodiment. In the display device DD-TD according to an embodiment, a light-emitting element ED-BT may include light emitting structures OL-B1, OL-B2, and OL-B3. At least one of the light-emitting structures OL-B1, OL-B2, and OL-B3 may include the polycyclic compound according to an embodiment, and at least one of the second, third, and fourth compounds. Accordingly, the light-emitting element ED-BT may exhibit characteristics such as high efficiency and long lifespan.

The light-emitting element ED-BT may include a first electrode EL1 and a second electrode EL2 that face each other, and light emitting structures OL-B1, OL-B2, and OL-B3 stacked in a thickness direction between the first electrode EL1 and the second electrode EL2. The light emitting structures OL-B1, OL-B2, and OL-B3 may each include a hole transport region HTR (FIG. 8), a light-emitting layer EML (FIG. 8), and an electron transport region ETR (FIG. 8), which may be disposed in that order between the first electrode EL1 and the second electrode EL2. For example, the light-emitting element ED-BT included in the display device DD-TD may be a light-emitting element having a tandem structure that includes multiple light-emitting layers.

In an embodiment shown in FIG. 9, light emitted from the light emitting structures OL-B1, OL-B2, and OL-B3 may each be blue light. However, embodiments are not limited thereto, and the light emitted from each of the light emitting structures OL-B1, OL-B2, and OL-B3 may have wavelength ranges that are different from each other. For example, the light-emitting element ED-BT that includes the light emitting structures OL-B1, OL-B2, and OL-B3, which emit light in different wavelength ranges, may emit white light.

Charge generation layers CGL1 and CGL2 may be each disposed between two adjacent light emitting structures among the light emitting structures OL-B1, OL-B2, and OL-B3. Charge generation layers CGL1 and CGL2 may each independently include a p-type charge generation layer and/or an n-type charge generation layer.

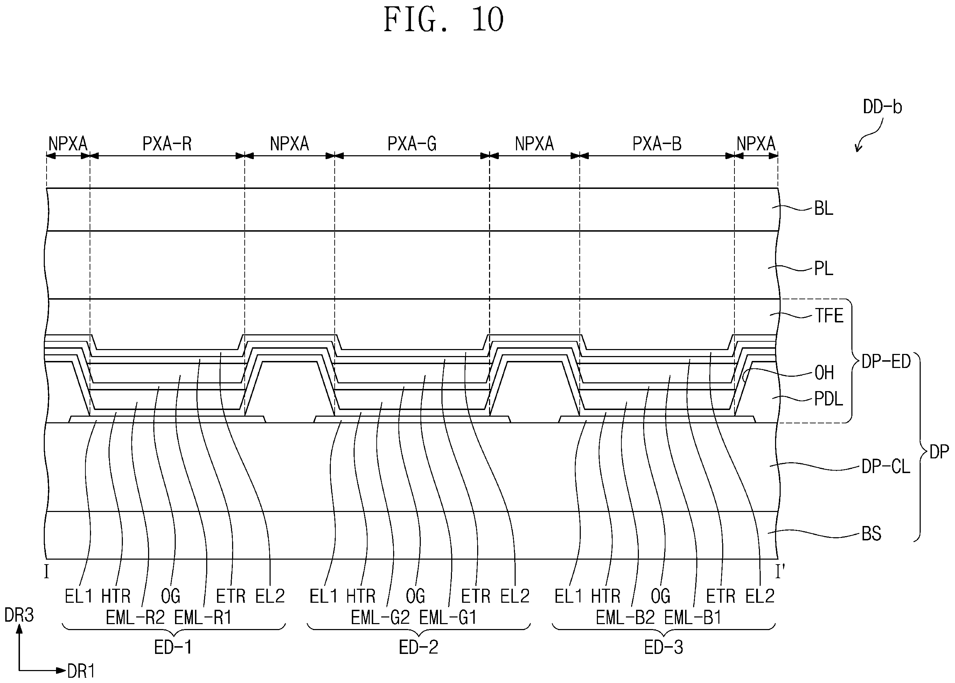

Referring to FIG. 10, a display device DD-b according to an embodiment may include light-emitting elements ED-1, ED-2, and ED-3 in which two light-emitting layers are stacked. At least one of the light-emitting elements ED-1, ED-2, and ED-3 may include the polycyclic compound according to an embodiment, and at least one of the second, third, and fourth compounds. Accordingly, the light-emitting elements ED-1, ED-2, and ED-3 may exhibit characteristics such as high efficiency and long lifespan.

In comparison to the display device DD shown in FIG. 2, the embodiment shown in FIG. 10 is different at least in that the first to third light-emitting elements ED-1, ED-2, and ED-3 each include two light-emitting layers that are stacked in a thickness direction. In the first to third light-emitting elements ED-1, ED-2, and ED-3, the two light-emitting layers may emit light in a same wavelength region.

The first light-emitting element ED-1 may include a first red light-emitting layer EML-R1 and a second red light-emitting layer EML-R2. The second light-emitting element ED-2 may include a first green light-emitting layer EML-G1 and a second green light-emitting layer EML-G2. The third light-emitting element ED-3 may include a first blue light-emitting layer EML-B1 and a second blue light-emitting layer EML-B2. An emission auxiliary part OG may be disposed between the first red light-emitting layer EML-R1 and the second red light-emitting layer EML-R2, between the first green light-emitting layer EML-G1 and the second green light-emitting layer EML-G2, and between the first blue light-emitting layer EML-B1 and the second blue light-emitting layer EML-B2.

The emission auxiliary part OG may have a single-layered structure or a multilayered structure. The emission auxiliary part OG may include a charge generation layer. For example, the emission auxiliary part OG may include an electron transport region, a charge generation layer, and a hole transport region, which may be stacked in that order. The emission auxiliary part OG may be provided as a common layer for the first to third light-emitting elements ED-1, ED-2, and ED-3. However, embodiments are not limited thereto, and the emission auxiliary part OG may be provided by being patterned within the openings OH defined in the pixel defining film PDL.

The first red light-emitting layer EML-R1, the first green light-emitting layer EML-G1, and the first blue light-emitting layer EML-B1 may be disposed between the emission auxiliary part OG and the electron transport region ETR. The second red light-emitting layer EML-R2, the second green light-emitting layer EML-G2, and the second blue light-emitting layer EML-B2 may be disposed between the hole transport region HTR and the emission auxiliary part OG.

The first light-emitting element ED-1 may include the first electrode EL1, the hole transport region HTR, the second red light-emitting layer EML-R2, the emission auxiliary part OG, the first red light-emitting layer EML-R1, the electron transport region ETR, and the second electrode EL2, which are stacked in that order. The second light-emitting element ED-2 may include the first electrode EL1, the hole transport region HTR, the second green light-emitting layer EML-G2, the emission auxiliary part OG, the first green light-emitting layer EML-G1, the electron transport region ETR, and the second electrode EL2, which are stacked in that order. The third light-emitting element ED-3 may include the first electrode EL1, the hole transport region HTR, the second blue light-emitting layer EML-B2, the emission auxiliary part OG, the first blue light-emitting layer EML-B1, the electron transport region ETR, and the second electrode EL2, which are stacked in that order.

An optical auxiliary layer PL may be disposed on display element layer DP-ED. The optical auxiliary layer PL may include a polarizing layer. The optical auxiliary layer PL may be disposed on the display panel DP and may control light that is reflected at the display panel DP from an external light. Although not shown in the drawings, in an embodiment, the optical auxiliary layer PL may be omitted from the display device DD-b.

In contrast to FIGS. 9 and 10, FIG. 11 shows a display device DD-c that is different at least in that it includes four light emitting structures OL-B1, OL-B2, OL-B3, and OL-C1. A light-emitting element ED-CT may include a first electrode EL1 and a second electrode EL2 that face each other, and first to fourth light emitting structures OL-B1, OL-B2, OL-B3, and OL-C1 that are stacked in a thickness direction between the first electrode EL1 and the second electrode EL2. At least one of the first to fourth light-emitting structures OL-B1, OL-B2, OL-B3, and OL-C1 may include the polycyclic compound according to an embodiment, and at least one of the second, third, and fourth compounds. Accordingly, the light-emitting element ED-CT may exhibit characteristics such as high efficiency and long lifespan.

Charge generation layers CGL1, CGL2, and CGL3 may be each disposed between two adjacent light emitting structures among the first to fourth light emitting structures OL-B 1, OL-B2, OL-B3, and OL-C1. Among the four light emitting structures, the first to third light emitting structures OL-B1, OL-B2, and OL-B3 may each emit blue light, and the fourth light emitting structure OL-C1 may emit green light. However, embodiments are not limited thereto, and the first to fourth light emitting structures OL-B1, OL-B2, OL-B3, and OL-C1 may emit light in wavelength regions that are different from each other.

Charge generation layers CGL1, CGL2, and CGL3 may each independently include a p-type charge generation layer and/or an n-type charge generation layer.

In an embodiment, an electronic device may include a display device that includes multiple light-emitting elements, and a control part that controls the display device. The electronic device may be a device that is activated according to an electrical signal. The electronic device may include display devices according to various embodiments. Examples of an electronic device may include large, medium-sized, and small electronic devices, such as a television, a monitor, a billboard, a personal computer, a laptop computer, a personal digital terminal, a display device for a vehicle, a game console, a portable electronic device, and a camera.

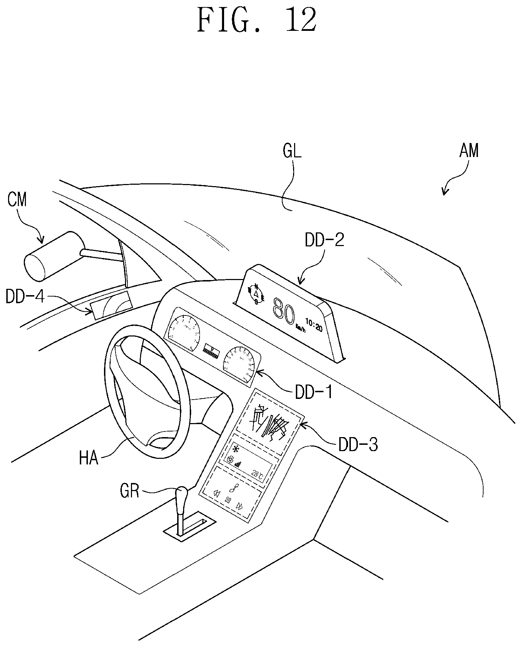

FIG. 12 is a schematic diagram of a vehicle AM that includes first to fourth display devices DD-1, DD-2, DD-3, and DD-4. At least one of the first to fourth display devices DD-1, DD-2, DD-3, and DD-4 may have a structure according to one of display devices DD, DD-TD, DD-a, DD-b, and DD-c as described with reference to FIGS. 1, 2, and 8 to 11.

FIG. 12 illustrates a vehicle AM, but this is only an example, and the first to fourth display devices DD-1, DD-2, DD-3, and DD-4 may be disposed in various transportation means such as a bicycle, a motorcycle, a train, a ship, and an airplane. In an embodiment, at least one of the first to fourth display devices DD-1, DD-2, DD-3, and DD-4 having a structure according to one of display devices DD, DD-TD, DD-a, DD-b, and DD-c may be included in a personal computer, a laptop computer, a personal digital terminal, a game console, a portable electronic device, a television, a monitor, a billboard, or the like. However, these are merely provided as examples, and the display device may be included in other electronic devices.

At least one of the first to fourth display devices DD-1, DD-2, DD-3, and DD-4 may each independently include a light-emitting element ED according to an embodiment as described with reference to any of FIGS. 3 to 7. At least one of the first to fourth display devices DD-1, DD-2, DD-3, and DD-4 may include the polycyclic compound according to an embodiment, and at least one of the second, third, and fourth compounds. Accordingly, the first to fourth display devices DD-1, DD-2, DD-3, and DD-4 including the polycyclic compound and at least one of the second, third, and fourth compounds may have improved display efficiency and display lifespan.

Referring to FIG. 12, the vehicle AM may include a steering wheel HA and a gearshift GR for operating the vehicle AM. The vehicle AM may include a front window GL that is disposed so as to face a driver.

The first display device DD-1 may be disposed in a first region that overlaps the steering wheel HA. For example, the first display device DD-1 may be a digital cluster that displays first information of the vehicle AM. The first information may include a first scale that indicates a driving speed of the vehicle AM, a second scale that indicates an engine speed (for example, as revolutions per minute (RPM)), an image that represents a fuel gauge, *etc.* The first scale and the second scale may each be represented by a digital image.

The second display device DD-2 may be disposed in a second region facing the driver's seat that overlaps the front window GL. The driver's seat may be a seat where the steering wheel HA is disposed. For example, the second display device DD-2 may be a head up display (HUD) that shows second information of the vehicle AM. The second display device DD-2 may be optically transparent. The second information may include digital numbers that indicate a driving speed, and may further include information such as the current time. Although not shown in the drawings, in an embodiment, the second information of the second display device DD-2 may be displayed by being projected onto the front window GL.

The third display device DD-3 may be disposed in a third region that is adjacent to the gearshift GR. For example, the third display device DD-3 may be a center information display (CID) for a vehicle AM that is disposed between a driver's seat and a passenger seat and which displays third information. The passenger seat may be a seat that is spaced apart from the driver's seat, and the gearshift GR may be disposed between the driver's seat and the passenger seat. The third information may include information about traffic conditions (*e.g*., navigation information), about music or radio that is playing, a video (or an image) that is displayed, about temperatures inside the vehicle AM, *etc.*

The fourth display device DD-4 may be disposed in a fourth region that is spaced apart from the steering wheel HA and the gearshift GR, and may be adjacent to a side of the vehicle AM. For example, the fourth display device DD-4 may be a digital side-view mirror that displays fourth information. The fourth display device DD-4 may display an image that is external to the vehicle AM, which may be taken by a camera module CM that disposed on the exterior of the vehicle AM. The fourth information may include an exterior image of the vehicle AM.

The first to fourth information as described above are only provided as examples, and the first to fourth display devices DD-1, DD-2, DD-3, and DD-4 may further display information about the interior and exterior of the vehicle AM. The first to fourth information may include information that is different from each other. However, embodiments are not limited thereto, and a part of the first to fourth information may include the same information as each other.

Hereinafter, a polycyclic compound according to an embodiment and a light-emitting element according to an embodiment will be described with reference to the Examples and the Comparative Examples. The Examples described below are only provided to assist in understanding the disclosure, and the scope thereof is not limited thereto.

### [Examples]

### 1. Synthesis of a polycyclic compound according to an embodiment

Methods for synthesizing Compounds 101, 153, 159, and 187 will be described below as examples of a method for synthesizing a polycyclic compound according to an embodiment. The methods for synthesizing a polycyclic compound are only provided as examples, and the method for synthesizing a polycyclic compound according to an embodiment is not limited thereto.

### (1) Synthesis of Compound 101

Compound 101 according to an embodiment may be synthesized by, for example, operations of Reaction Scheme 1 below.

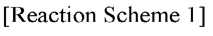

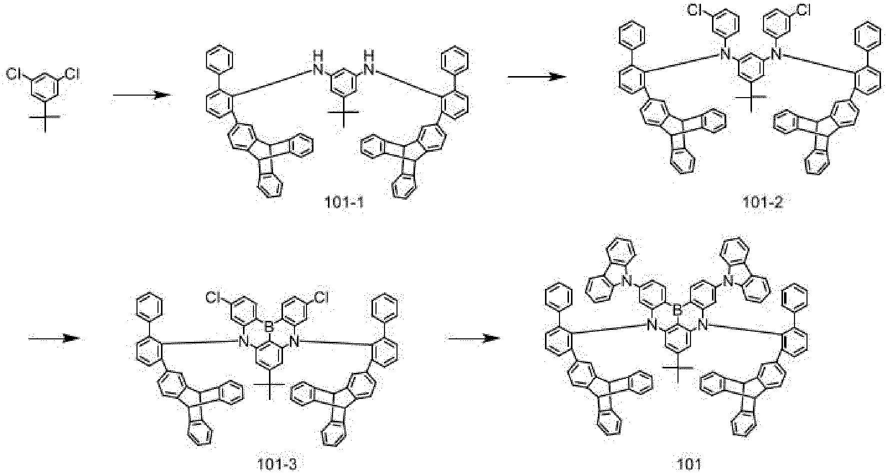

### <Synthesis of Intermediate 101-1>

Under a nitrogen atmosphere, 1-(tert-butyl)-3,5-dichlorobenzene (1 eq), 3-((9r,10r)-9,10-dihydro-9,10-[1,2]benzenoanthracen-2-yl)-[1,1'-biphenyl]-2-amine (2.1 eq), tris(dibenzylideneacetone)dipalladium (0) (Pd₂(dba)₃) (0.05 eq), tris-tert-butyl phosphine (0.1 eq), and sodium tert-butoxide (2.5 eq) were dissolved in o-xylene, and the reaction solution was stirred at about 140 °C for about one day. After cooling, water and ethyl acetate were added for extraction, and an organic layer was collected, dried with MgSO₄, and filtered. The solvent of the filtered solution was removed by reducing pressure, and the obtained reactant was purified and separated by column chromatography using silica gel to obtain Intermediate 101-1 (76% yield).

### <Synthesis of Intermediate 101-2>

Under a nitrogen atmosphere, Intermediate 101-1 (1 eq), 3-iodochlorobenzene (10 eq), Pd₂(dba)₃ (0.5 eq), tris-tert-butyl phosphine (1 eq), and sodium tert-butoxide (4 eq) were dissolved in o-xylene, and the reaction solution was stirred at about 160 °C for about three days. After cooling, water and ethyl acetate were added for extraction, and an organic layer was collected, dried with MgSO₄, and filtered. The solvent of the filtered solution was removed by reducing pressure, and the obtained reactant was purified and separated by column chromatography using silica gel to obtain Intermediate 101-2 (65% yield).

### <Synthesis of Intermediate 101-3>

Under a nitrogen atmosphere, BBr₃ (3eq) was slowly injected into ortho dichlorobenzene in which Intermediate 101-2 (1eq) was dissolved, and which was cooled to about 0 °C. After dropwise injection was completed, the solution was heated to about 180 °C and stirred for about 24 hours. After cooling, triethylamine was slowly dropped into a flask having the reactant to finish the reaction, and ethyl alcohol was added to the reactant for precipitation and filtering to obtain the reactant. The obtained solid was purified by column chromatography using methylene chloride (MC) and n-hexane, and recrystallized using toluene and acetone to obtain Intermediate 101-3 (25% yield).

### < Synthesis of Compound 101>

Under a nitrogen atmosphere, Intermediate 101-3 (1 eq), carbazole (1.2 eq), Pd₂(dba)₃ (0.05 eq), tris-tert-butyl phosphine (0.1 eq), sodium tert-butoxide (1.5 eq) were dissolved in o-xylene, and the reaction solution was stirred at about 140 °C for about one day. After cooling, water and ethyl acetate were added for extraction, and an organic layer was collected, dried with MgSO₄, and filtered. The solvent of the filtered solution was removed by reducing pressure, and the obtained reactant was purified and separated by column chromatography using silica gel to obtain compound 101 (45% yield, HRMS calcd. for Compound 101 [M]+: 1463.6118, found: 1463.2542).

### (2) Synthesis of Compound 153

Compound 153 according to an embodiment may be synthesized by, for example, operations of Reaction Scheme 2 below.

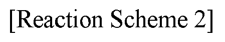

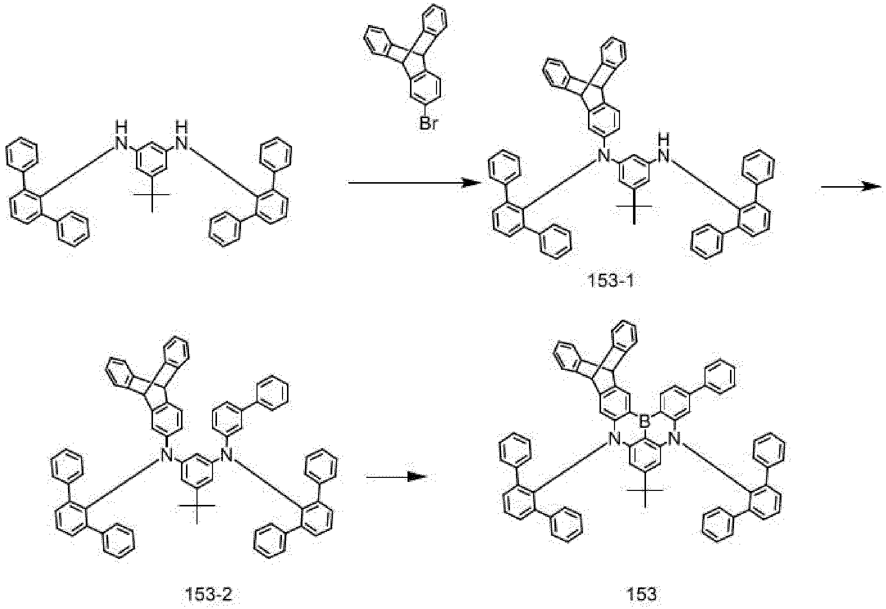

### <Synthesis of Intermediate 153-1>

N1,N3-di([1,1':3',1"-terphenyl]-2'-yl)-5-(tert-butyl)benzene-1,3-diamine (1eq), 2-bromotriptycene (1eq), tris(dibenzylideneacetone)dipalladium(0) (0.05eq), tri-tert-butylphosphine (0.1eq), and sodium tert-butoxide (3eq) were dissolved in o-xylene, and the reaction solution was stirred at about 140 °C for about 12 hours. After cooling, an organic layer obtained by washing three times with water and ethyl acetate and separating the liquid was dried with MgSO₄, and dried by reducing pressure. The obtained solid was purified by column chromatography using MC and n-hexane to obtain Intermediate 153-1 (37% yield).

### <Synthesis of Intermediate 153-2>

Intermediate 153-1 (1eq), 3-iodo-1,1'-biphenyl (1.3eq), tris(dibenzylideneacetone)dipalladium(0) (0.05eq), tri-tert-butylphosphine (0.1eq), and sodium tert-butoxide (3eq) were dissolved in o-xylene, and the reaction solution was stirred at about 140 °C for about 12 hours. After cooling, an organic layer obtained by washing three times with water and ethyl acetate and separating the liquid was dried with MgSO₄, and dried by reducing pressure. The obtained solid was purified by column chromatography using MC and n-hexane to obtain Intermediate 153-2 (51% yield).

### < Synthesis of Compound 153>

Under a nitrogen atmosphere, BBr₃ (3eq) was slowly injected into ortho dichlorobenzene in which Intermediate 153-2 (1eq) was dissolved, and which was cooled to about 0 °C. After dropwise injection was completed, the solution was heated to about 180 °C and stirred for about 24 hours. After cooling, triethylamine was slowly dropped into a flask having the reactant to finish the reaction, and ethyl alcohol was added to the reactant for precipitation and filtering to obtain the reactant. The obtained solid was purified by column chromatography using MC and n-hexane, and recrystallized using toluene and acetone to obtain Compound 153 (22% yield, HRMS calcd. for Compound 153 [M]+: 1032.4615, found: 1032.2535).

### (3) Synthesis of Compound 159

Compound 159 according to an embodiment may be synthesized by, for example, operations of Reaction Scheme 3 below.

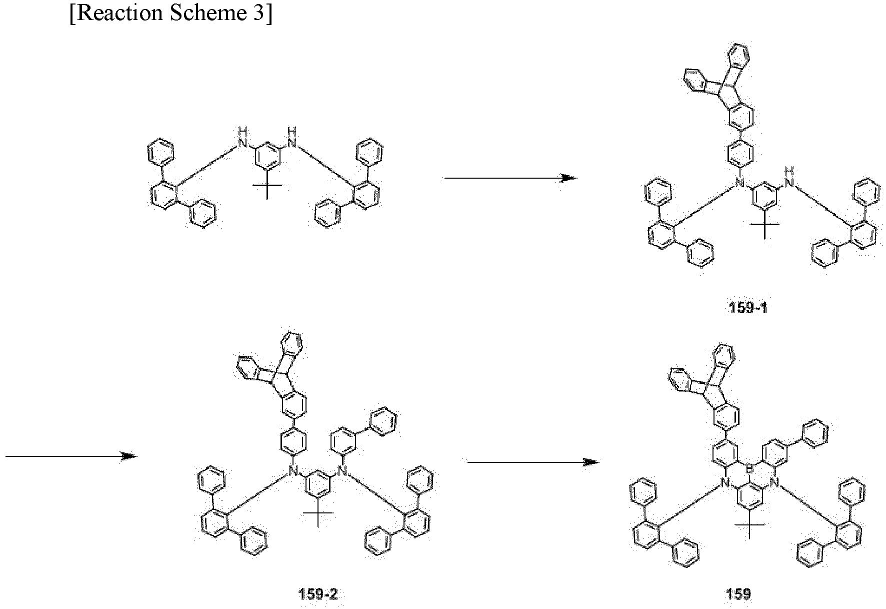

### <Synthesis of Intermediate 159-1>

N1,N3-di([1,1':3',1"-terphenyl]-2'-yl)-5-(tert-butyl)benzene-1,3-diamine (1eq), (9r,10r)-2-(4-bromophenyl)-9,10-dihydro-9,10-[1,2]benzenoanthracene (1eq), tris(dibenzylideneacetone)dipalladium(0) (0.05eq), tri-tert-butylphosphine (0.1eq), and sodium tert-butoxide (3eq) were dissolved in o-xylene, and the reaction solution was stirred at about 140 °C for about 12 hours. After cooling, an organic layer obtained by washing three times with water and ethyl acetate and separating the liquid was dried with MgSO₄, and dried by reducing pressure. The obtained solid was purified by column chromatography using MC and n-hexane to obtain Intermediate 159-1 (42% yield).

### <Synthesis of Intermediate 159-2>

Intermediate 159-1 (1eq), 3-iodo-1,1'-biphenyl (1.3eq), tris(dibenzylideneacetone)dipalladium(0) (0.05eq), tri-tert-butylphosphine (0.1eq), and sodium tert-butoxide (3eq) were dissolved in o-xylene, and the reaction solution was stirred at about 140 °C for about 12 hours. After cooling, an organic layer obtained by washing three times with water and ethyl acetate and separating the liquid was dried with MgSO₄, and dried by reducing pressure. The obtained solid was purified by column chromatography using MC and n-hexane to obtain Intermediate 159-2 (53% yield).

### < Synthesis of Compound 159>

Under a nitrogen atmosphere, BBr₃ (3eq) was slowly injected into ortho dichlorobenzene in which Intermediate 159-2 (1eq) was dissolved, and which was cooled to about 0 °C. After dropwise injection was completed, the solution was heated to about 180 °C and stirred for about 24 hours. After cooling, triethylamine was slowly dropped into a flask having the reactant to finish the reaction, and ethyl alcohol was added to the reactant for precipitation and filtering to obtain the reactant. The obtained solid was purified by column chromatography using MC and n-hexane, and recrystallized using toluene and acetone to obtain Compound 159 (25% yield, HRMS calcd. for Compound 159 [M]+: 1108.4928, found: 1108.2342).

### (4) Synthesis of Compound 187

Compound 187 according to an embodiment may be synthesized by, for example, operations of Reaction Scheme 4 below.

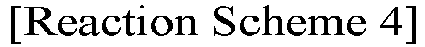

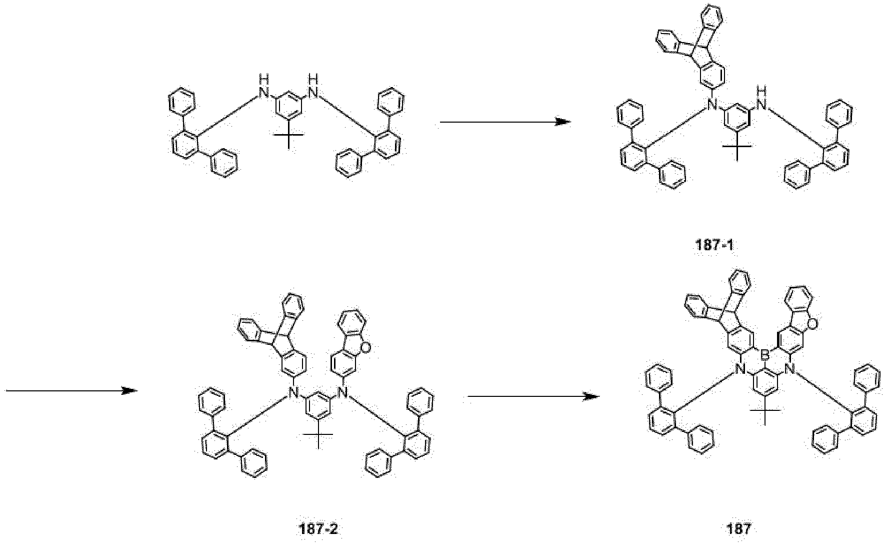

### <Synthesis of Intermediate 187-1>

N1,N3-di([1,1':3',1"-terphenyl]-2'-yl)-5-(tert-butyl)benzene-1,3-diamine (1eq), 2-bromotriptycene (1eq), tris(dibenzylideneacetone)dipalladium(0) (0.05eq), tri-tert-butylphosphine (0.1eq), and sodium tert-butoxide (3eq) were dissolved in o-xylene, and the reaction solution was stirred at about 140 °C for about 12 hours. After cooling, an organic layer obtained by washing three times with water and ethyl acetate and separating the liquid was dried with MgSO₄, and dried by reducing pressure. The obtained solid was purified by column chromatography using MC and n-hexane to obtain Intermediate 187-1 (46% yield).

### <Synthesis of Intermediate 187-2>

Intermediate 187-1 (1eq), 3-bromodibenzo[b,d]furan (1.3eq), tris(dibenzylideneacetone)dipalladium(0) (0.05eq), tri-tert-butylphosphine (0.1eq), and sodium tert-butoxide (3eq) were dissolved in o-xylene, and the reaction solution was stirred at about 140 °C for about 12 hours. After cooling, an organic layer obtained by washing three times with water and ethyl acetate and separating the liquid was dried with MgSO₄, and dried by reducing pressure. The obtained solid was purified by column chromatography using MC and n-hexane to obtain Intermediate 187-2 (62% yield).

### < Synthesis of Compound 187>

Under a nitrogen atmosphere, BBr₃ (3eq) was slowly injected into ortho dichlorobenzene in which Intermediate 187-2 (1eq) was dissolved, and which was cooled to about 0 °C. After dropwise injection was completed, the solution was heated to about 180 °C and stirred for about 24 hours. After cooling, triethylamine was slowly dropped into a flask having the reactant to finish the reaction, and ethyl alcohol was added to the reactant for precipitation and filtering to obtain the reactant. The obtained solid was purified by column chromatography using MC and n-hexane, and recrystallized using toluene and acetone to obtain Compound 187 (21% yield, HRMS calcd. for Compound 187 [M]+: 1046.4407, found: 1046.2405).

### 2. Manufacturing and evaluation of light-emitting element

### (1) Manufacturing of light-emitting element

A light-emitting element including, in a light-emitting layer, an Example Compound or a Comparative Compound was manufactured according to a method below. Light-emitting elements of Examples 1 to 8 were manufactured by using the polycyclic compounds according to the Examples as dopant materials of the light-emitting layers. Light-emitting elements of Comparative Examples 1 to 7 were manufactured using Comparative Compounds C1 to C7 as dopant materials of the light-emitting layers.

A glass substrate (made by Corning) on which an ITO electrode of 15 Ω/cm² (1,200 Å) was formed as a first electrode was cut into sizes of 50 mm × 50 mm × 0.7 mm, and ultrasonically cleaned for about 5 minutes using isopropyl alcohol and pure water, each. Thereafter, the glass substrate was cleaned by irradiating with ultraviolet rays for about 30 minutes and by exposure to ozone, and mounted in a vacuum deposition device.

HAT-CN (1,4,5,8,9,11-hexaazatriphenylenehexacarbonitrile) was deposited on the first electrode to form a hole injection layer having a thickness of about 100 Å, and Compound H-1-1 was deposited on an upper portion of the hole injection layer to form a hole transport layer having a thickness of about 600 Å. An electron blocking layer having a thickness of 50 Å was formed on an upper portion of the hole transport layer with Compound HT33.

A mixed host in which a second compound and a third compound according to an embodiment were mixed, a fourth compound, and an Example Compound or a Comparative Compound were co-deposited at a weight ratio of 86.6:13:0.4 to form a light-emitting layer having a thickness of 300 Å. The host is a mixture that includes Compound HT33, which is a hole transport host (a HT host), and Compound ETH66, which is an electron transport host (an ET host) at a weight ratio of 65:35. Compound AD-39 or Compound AD-37 was used as the fourth compound. An Example Compound or a Comparative Compound was used as a dopant material.

2SiTrzPh was vacuum deposited on an upper portion of the light-emitting layer to form a hole blocking layer having a thickness of about 50 Å. 2SiTrzPh and 8-quinolinolato lithium (Liq) were mixed at a weight ratio of 5:5 and co-deposited to form an electron transport layer having a thickness of about 310 Å. LiF was vacuum deposited on the electron transport layer to form an electron injection layer having a thickness of about 15 Å. Al was deposited at a thickness of 800 Å to form a second electrode, thereby completing manufacture of the light-emitting element.

Compounds used in manufacturing the light-emitting element are as follows.
(Common materials used in manufacturing light-emitting element) 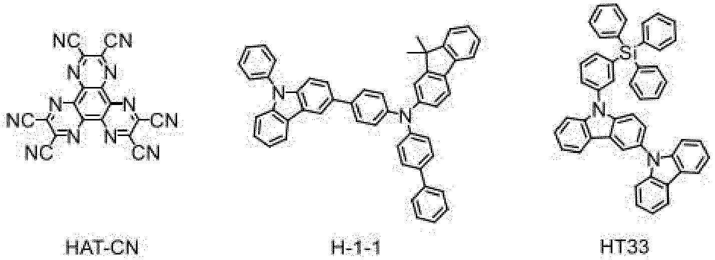 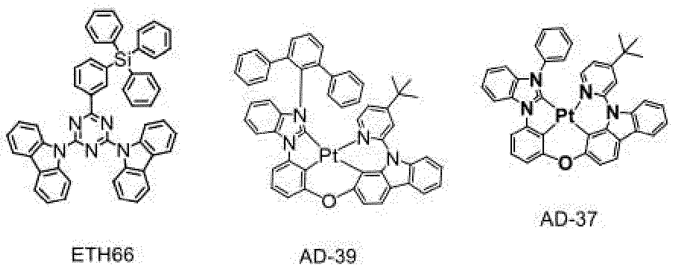 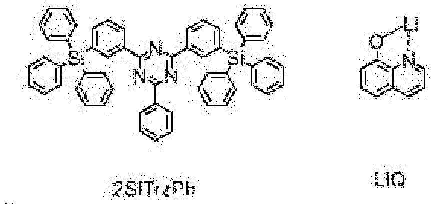
(Dopant material of Examples and Comparative Examples used in manufacturing light-emitting element)

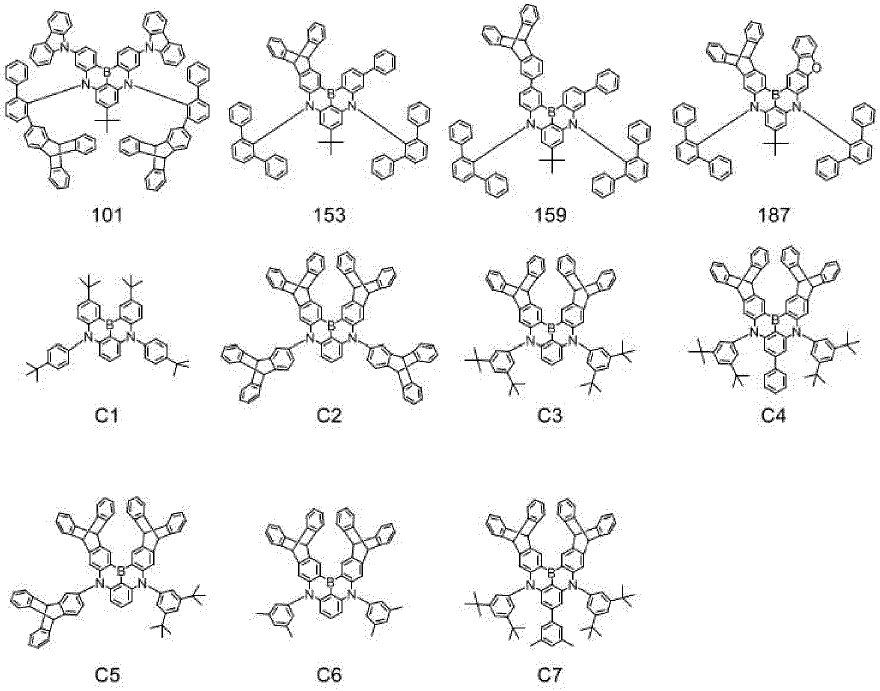

### (2) Evaluation of characteristics of light-emitting element

Table 1 shows evaluation results of the light-emitting elements of the Examples and the Comparative Examples. In the light-emitting elements of the Examples and the Comparative Examples, driving voltage (V), luminous efficiency (cd/A), maximum luminous wavelength (nm), and lifespan ratio (T₉₅) at luminance of about 1,000 cd/m² were measured using Keithley SMU 236 and luminance meter PR650, and the results are shown in Table 1. Lifespan ratio (T₉₅) in Table 1 is a value that is obtained by measuring the time taken until luminance decreases to about 95% of initial luminance and comparing the time with that of Comparative Example 1, and means a relative element lifespan.

**[Table 1]**

| | Host (Second Compound: Third compound = 65:35) | Fourth Compound | First Compound | Driving voltage (V) | Luminous efficiency (cd/A) | Emission wavelength (nm) | Lifespan ratio (T₉₅) |
|---|---|---|---|---|---|---|---|
| Example 1 | HT33/ETH66 | AD-39 | 101 | 4.2 | 27.3 | 460 | 7.1 |
| Example 2 | HT33/ETH66 | AD-39 | 153 | 4.1 | 26.8 | 463 | 6.5 |
| Example 3 | HT33/ETH66 | AD-39 | 159 | 4.2 | 26.8 | 464 | 6.4 |
| Example 4 | HT33/ETH66 | AD-39 | 187 | 4.1 | 26.8 | 470 | 4.2 |
| Example 5 | HT33/ETH66 | AD-37 | 101 | 4.2 | 27.3 | 460 | 7.0 |
| Example 6 | HT33/ETH66 | AD-37 | 153 | 4.1 | 26.8 | 462 | 6.5 |
| Example 7 | HT33/ETH66 | AD-37 | 159 | 4.2 | 26.8 | 464 | 6.2 |
| Example 8 | HT33/ETH66 | AD-37 | 187 | 4.1 | 26.8 | 470 | 3.8 |
| Comparative Example 1 | HT33/ETH66 | AD-39 | C1 | 4.3 | 22.1 | 462 | 1 |
| Comparative Example 2 | HT33/ETH66 | AD-39 | C2 | 4.2 | 23.6 | 463 | 2.2 |
| Comparative Example 3 | HT33/ETH66 | AD-39 | C3 | 4.2 | 23.2 | 463 | 2.1 |
| Comparative Example 4 | HT33/ETH66 | AD-39 | C4 | 4.2 | 23.1 | 469 | 1.7 |
| Comparative Example 5 | HT33/ETH66 | AD-39 | C5 | 4.2 | 23.5 | 463 | 2.0 |
| Comparative Example 6 | HT33/ETH66 | AD-39 | C6 | 4.1 | 23.2 | 463 | 1.8 |
| Comparative Example 7 | HT33/ETH66 | AD-39 | C7 | 4.2 | 22.7 | 468 | 1.6 |

Referring to the result of Table 1, it may be confirmed that the light-emitting elements of the Examples using the polycyclic compounds according to an embodiment as the light-emitting materials all emit blue light. It may be confirmed that the light-emitting elements of the Examples exhibit similar driving voltage characteristics to those of the Comparative Examples, but exhibit high luminous efficiency and improved lifespan characteristics, as compared to those of the Comparative Examples.

Comparative Compound C1 does not include a triptycene group and a biphenyl derivative in a molecule. The light-emitting element of Comparative Example 1 including Comparative Compound C1 as the light-emitting material exhibits deteriorated luminous efficiency characteristics compared to the light-emitting elements of the Examples, and exhibits deteriorated lifespan.

Comparative Compounds C2 to C7 each include a triptycene group, but each have a structure in which the biphenyl derivative is not connected to a nitrogen atom of a polycyclic central structure. Accordingly, the light-emitting elements of Comparative Examples 2 to 7 using Comparative compounds C2 to C7 as the light-emitting materials exhibit deteriorated luminous efficiency and lifespan characteristics compared to the light-emitting elements of the Examples.

A light-emitting element according to an embodiment may include a polycyclic compound according to an embodiment in a light-emitting layer to exhibit high efficiency and long lifespan characteristics.

The polycyclic compound according to an embodiment may contribute to luminous efficiency improvement and long lifespan of the light-emitting element.

A display device according to an embodiment may exhibit excellent display quality.

Embodiments have been disclosed herein, and although terms are employed, they are used and are to be interpreted in a generic and descriptive sense only and not for the purposes of limitation. In some instances, as would be apparent to one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the scope of the disclosure as set forth in the claims.

## Claims

1. A polycyclic compound represented by Formula 1: 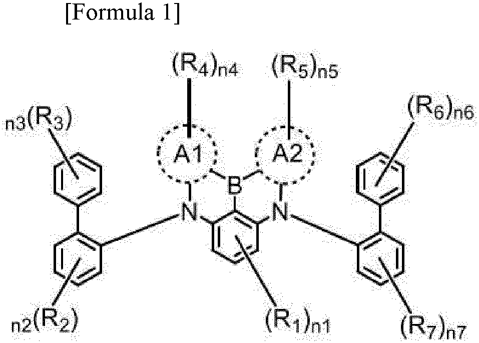 wherein in Formula 1,
ring A1 and ring A2 are each independently a substituted or unsubstituted hydrocarbon ring having a ring-forming carbon number of 6 to 30 or a substituted or unsubstituted heterocycle having a ring-forming carbon number of 5 to 30,
R₁ to R₇ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60, a substituted or unsubstituted cycloalkyl group having a ring-forming carbon number of 3 to 60, a substituted or unsubstituted alkenyl group having a carbon number of 2 to 60, a substituted or unsubstituted aryl group having a ring-forming carbon number of 6 to 60, or a substituted or unsubstituted heteroaryl group having a ring-forming carbon number of 2 to 60, or combined with an adjacent group to form a ring,
n1 is an integer from 0 to 3,
n2 and n7 are each independently an integer from 0 to 4,
n3 and n6 are each independently an integer from 0 to 5,
n4 and n5 are each independently an integer from 0 to 14, and
at least one of ring A1, ring A2, and R₁ to R₇ is each independently a substituted or unsubstituted triptycene group.

2. The polycyclic compound of claim 1, wherein the polycyclic compound is represented by Formula 2: 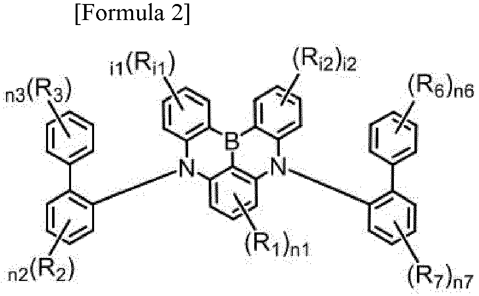 wherein in Formula 2,
Rᵢ₁ and Rᵢ₂ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60, a substituted or unsubstituted cycloalkyl group having a ring-forming carbon number of 3 to 60, a substituted or unsubstituted alkenyl group having a carbon number of 2 to 60, a substituted or unsubstituted aryl group having a ring-forming carbon number of 6 to 60, or a substituted or unsubstituted heteroaryl group having a ring-forming carbon number of 2 to 60, or combined with an adjacent group to form a ring,
i1 and i2 are each independently an integer from 0 to 4,
R₁ to R₃, R₆, R₇, n1 to n3, n6, and n7 are the same as defined in Formula 1, and
at least one of Rᵢ₁, Rᵢ₂, R₁ to R₃, R₆, and R₇ is each independently a group represented by Formula a: 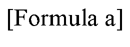 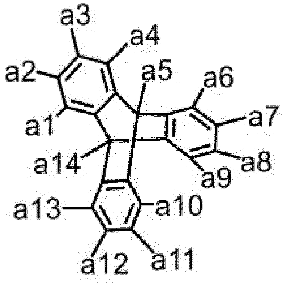 wherein in Formula a,
one of a1 to a14 is a position connected to Formula 2, and
the remainder of a1 to a14 are each independently a hydrogen atom, a deuterium atom, a substituted or unsubstituted alkyl group having a carbon number of 1 to 30, or a substituted or unsubstituted aryl group having a ring-forming carbon number of 6 to 30.

3. The polycyclic compound of claim 2, wherein remainder of a1 to a14 that are not connected to Formula 2 are each a hydrogen atom.

4. The polycyclic compound of claim 2 or claim 3, wherein the first compound is represented by Formula 2-1 or Formula 2-2: 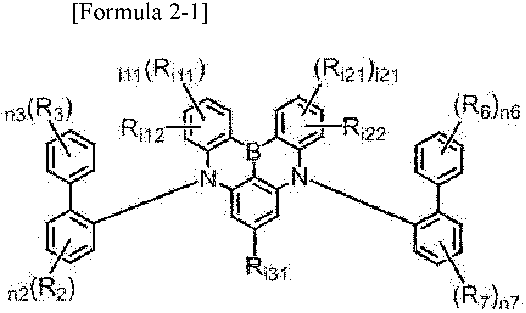 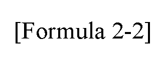 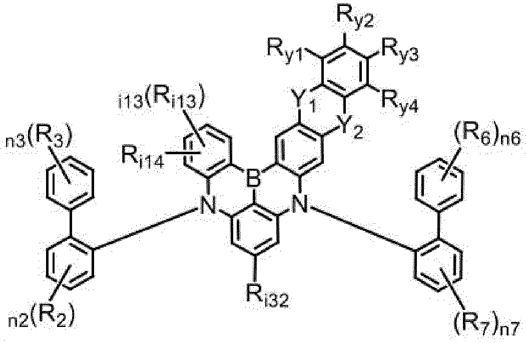 wherein in Formula 2-1,
Rᵢ₁₁ and Rᵢ₂₁ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60, a substituted or unsubstituted cycloalkyl group having a ring-forming carbon number of 3 to 60, a substituted or unsubstituted alkenyl group having a carbon number of 2 to 60, a substituted or unsubstituted aryl group having a ring-forming carbon number of 6 to 60, or a substituted or unsubstituted heteroaryl group having a ring-forming carbon number of 2 to 60, or combined with an adjacent group to form a ring,
Rᵢ₁₂, Rᵢ₂₂, and Rᵢ₃₁ are each independently a substituted or unsubstituted amine group, a substituted or unsubstituted alkyl group having a carbon number of 1 to 30, a substituted or unsubstituted aryl group having a ring-forming carbon number of 6 to 60, or a substituted or unsubstituted heteroaryl group having a ring-forming carbon number of 2 to 60,
i11 and i21 are each independently an integer from 0 to 3, and
at least one of Rᵢ₁₂, Rᵢ₂₂, Rᵢ₃₁, R₂, R₃, R₆, and R₇ is each independently a group represented by Formula a;
wherein in Formula 2-2,
one of Y₁ and Y₂ is a direct linkage,
the other of Y₁ and Y₂ is N(R_{y5}), O or S,
R_{y1} to R_{y5} are each independently a hydrogen atom, a deuterium atom, a substituted or unsubstituted alkyl group having a carbon number of 1 to 30, a substituted or unsubstituted alkenyl group having a carbon number of 2 to 30, or a substituted or unsubstituted aryl group having a ring-forming carbon number of 6 to 30, or combined with an adjacent group to form a ring,
Rᵢ₁₃ is a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60, a substituted or unsubstituted cycloalkyl group having a ring-forming carbon number of 3 to 60, a substituted or unsubstituted alkenyl group having a carbon number of 2 to 60, a substituted or unsubstituted aryl group having a ring-forming carbon number of 6 to 60, or a substituted or unsubstituted heteroaryl group having a ring-forming carbon number of 2 to 60, or combined with an adjacent group to form a ring,
Rᵢ₁₄ and Rᵢ₃₂ are each independently a substituted or unsubstituted amine group, a substituted or unsubstituted alkyl group having a carbon number of 1 to 30, a substituted or unsubstituted aryl group having a ring-forming carbon number of 6 to 60, or a substituted or unsubstituted heteroaryl group having a ring-forming carbon number of 2 to 60,
i13 is an integer from 0 to 3, and
at least one of Rᵢ₁₄, Rᵢ₃₂, R₂, R₃, R₆, and R₇ is each independently a group represented by Formula a; and
wherein in Formula 2-1 and Formula 2-2,
R₂, R₃, R₆, and R₇ are each the same as defined in Formula 1, in case that they are not a group represented by Formula a, and
n2, n3, n6, and n7 are the same as defined in Formula 1.

5. The polycyclic compound of claim 1, wherein the polycyclic compound is represented by Formula 3-1 or Formula 3-2: 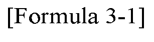 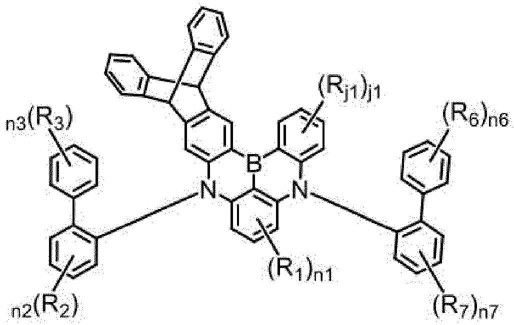 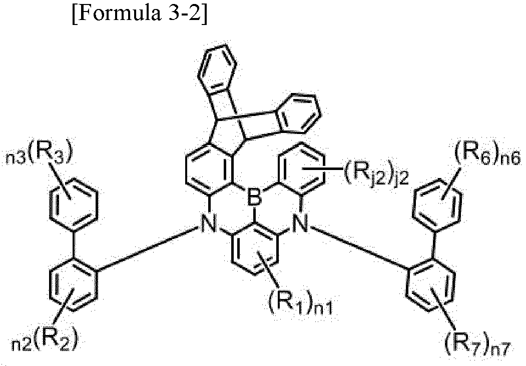 wherein in Formula 3-1 and Formula 3-2,
Rⱼ₁ and Rⱼ₂ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60, a substituted or unsubstituted cycloalkyl group having a ring-forming carbon number of 3 to 60, a substituted or unsubstituted alkenyl group having a carbon number of 2 to 60, a substituted or unsubstituted aryl group having a ring-forming carbon number of 6 to 30, or a substituted or unsubstituted heteroaryl group having a ring-forming carbon number of 2 to 60, or combined with an adjacent group to form a ring,
j1 and j2 are each independently an integer from 0 to 4, and
R₁ to R₃, R₆, R₇, n1 to n3, n6, and n7 are the same as defined in Formula 1.

6. The polycyclic compound of claim 5, wherein the first compound is represented by Formula 3-1-1: 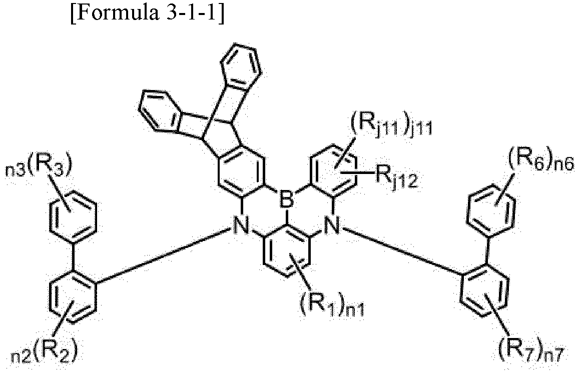 wherein in Formula 3-1-1,
Rⱼ₁₁ is a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60, a substituted or unsubstituted cycloalkyl group having a ring-forming carbon number of 3 to 60, a substituted or unsubstituted alkenyl group having a carbon number of 2 to 60, a substituted or unsubstituted aryl group having a ring-forming carbon number of 6 to 60, or a substituted or unsubstituted heteroaryl group having a ring-forming carbon number of 2 to 60, or combined with an adjacent group to form a ring,
Rⱼ₁₂ is a substituted or unsubstituted amine group, a substituted or unsubstituted aryl group having a ring-forming carbon number of 6 to 30, or a substituted or unsubstituted heteroaryl group having a ring-forming carbon number of 2 to 60,
j11 is an integer from 0 to 3, and
R₁ to R₃, R₆, R₇, n1 to n3, n6, and n7 are the same as defined in Formula 1.

7. The polycyclic compound of claim 5, wherein the first compound is represented by Formula 3-2-1: 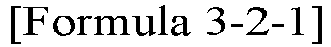 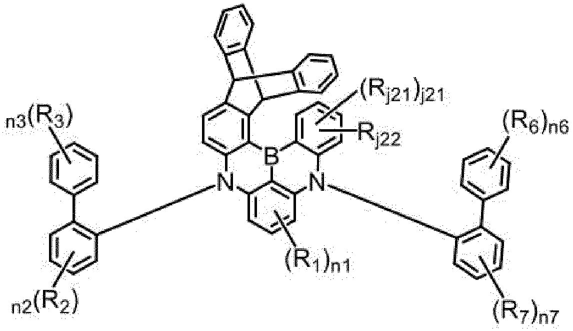 wherein in Formula 3-2-1,
Rⱼ₂₁ is a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted alkyl group having a carbon number of 1 to 60, a substituted or unsubstituted cycloalkyl group having a ring-forming carbon number of 3 to 60, a substituted or unsubstituted alkenyl group having a carbon number of 2 to 60, a substituted or unsubstituted aryl group having a ring-forming carbon number of 6 to 60, or a substituted or unsubstituted heteroaryl group having a ring-forming carbon number of 2 to 60, or combined with an adjacent group to form a ring,
Rⱼ₂₂ is a substituted or unsubstituted amine group, a substituted or unsubstituted aryl group having a ring-forming carbon number of 6 to 30, or a substituted or unsubstituted heteroaryl group having a ring-forming carbon number of 2 to 60,
j21 is an integer from 0 to 3, and
R₁ to R₃, R₆, R₇, n1 to n3, n6, and n7 are the same as defined in Formula 1.

8. The polycyclic compound of claim 1, wherein the polycyclic compound is represented by Formula 4: 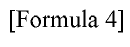 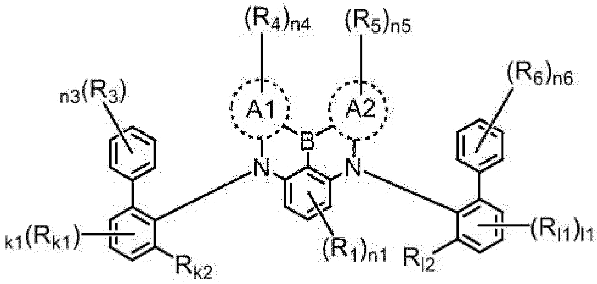 wherein in Formula 4,
Rₖ₁ and Rₗ₁ are each independently a hydrogen atom, a deuterium atom, a substituted or unsubstituted alkyl group having a carbon number of 1 to 10, or a substituted or unsubstituted aryl group having a ring-forming carbon number of 6 to 30,
Rₖ₂ and Rₗ₂ are each independently a substituted or unsubstituted alkyl group having a carbon number of 1 to 10 or a substituted or unsubstituted aryl group having a ring-forming carbon number of 6 to 30,
k1 and l1 are each independently an integer from 0 to 3,
at least one of ring A1, ring A2, R₁, R₃ to R₆, Rₖ₂, and Rₗ₂ is each independently a substituted or unsubstituted triptycene group,
ring A1, ring A2, R₁, and R₃ to R₆ are each the same as defined in Formula 1, in case that they are not a substituted or unsubstituted triptycene group, and
n1 and n3 to n6 are the same as defined in Formula 1.

9. The polycyclic compound of claim 1, wherein the polycyclic compound is selected from Compound Group 1: 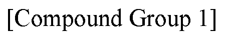 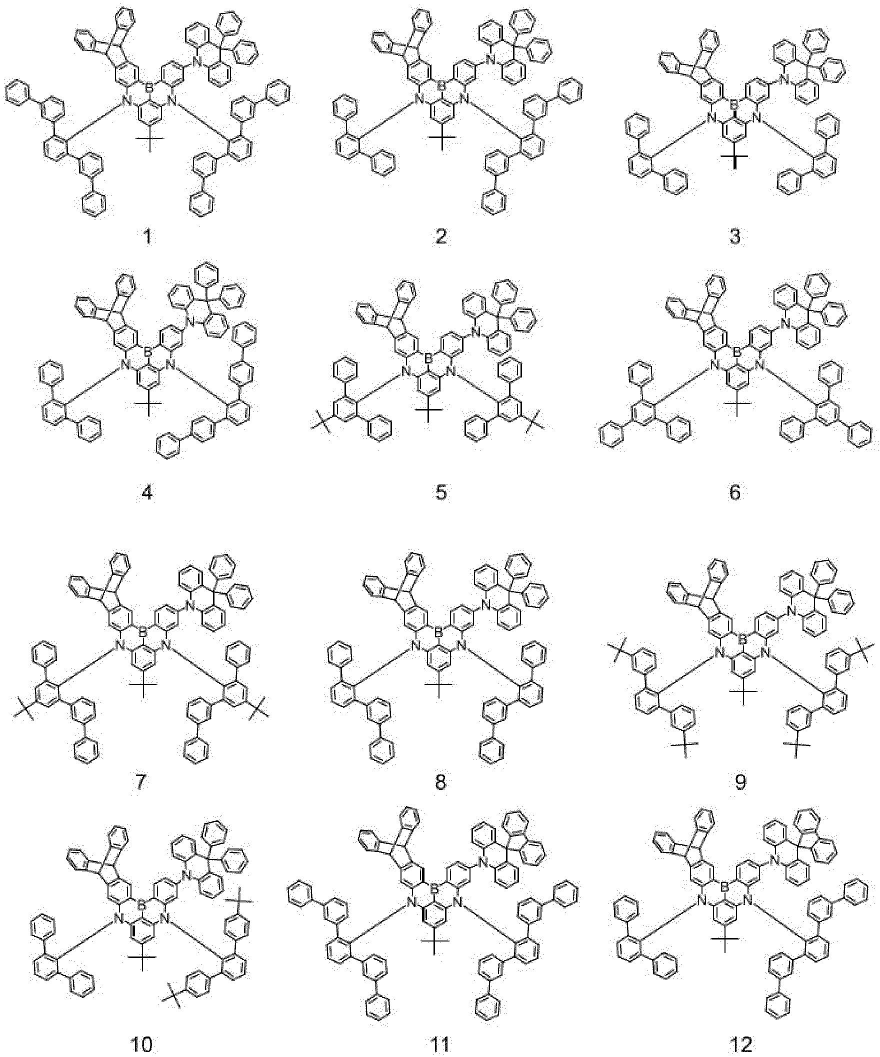 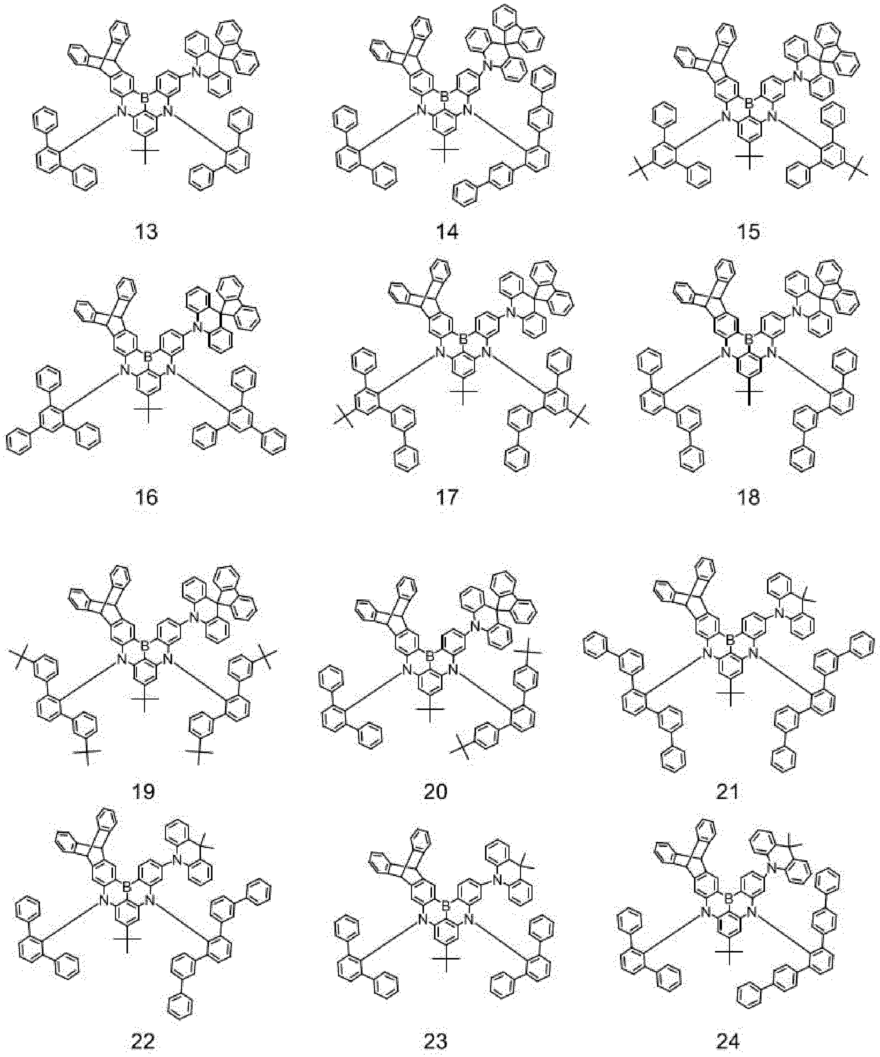 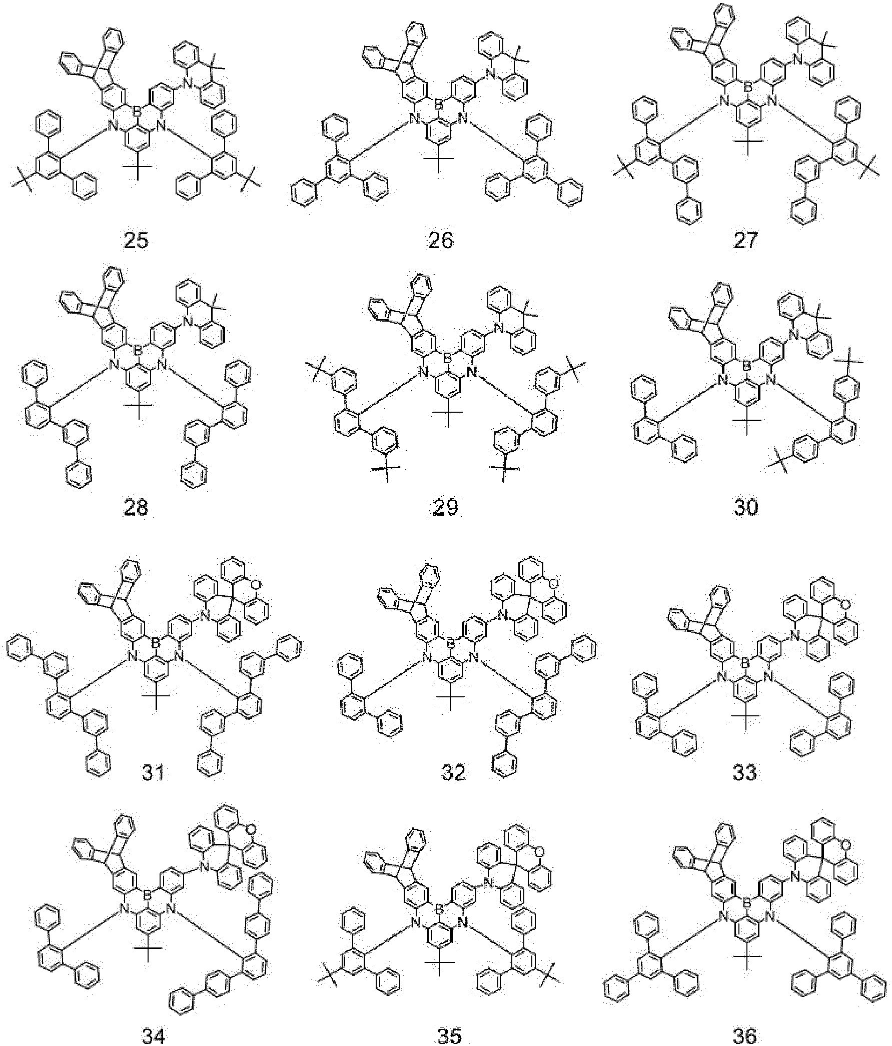 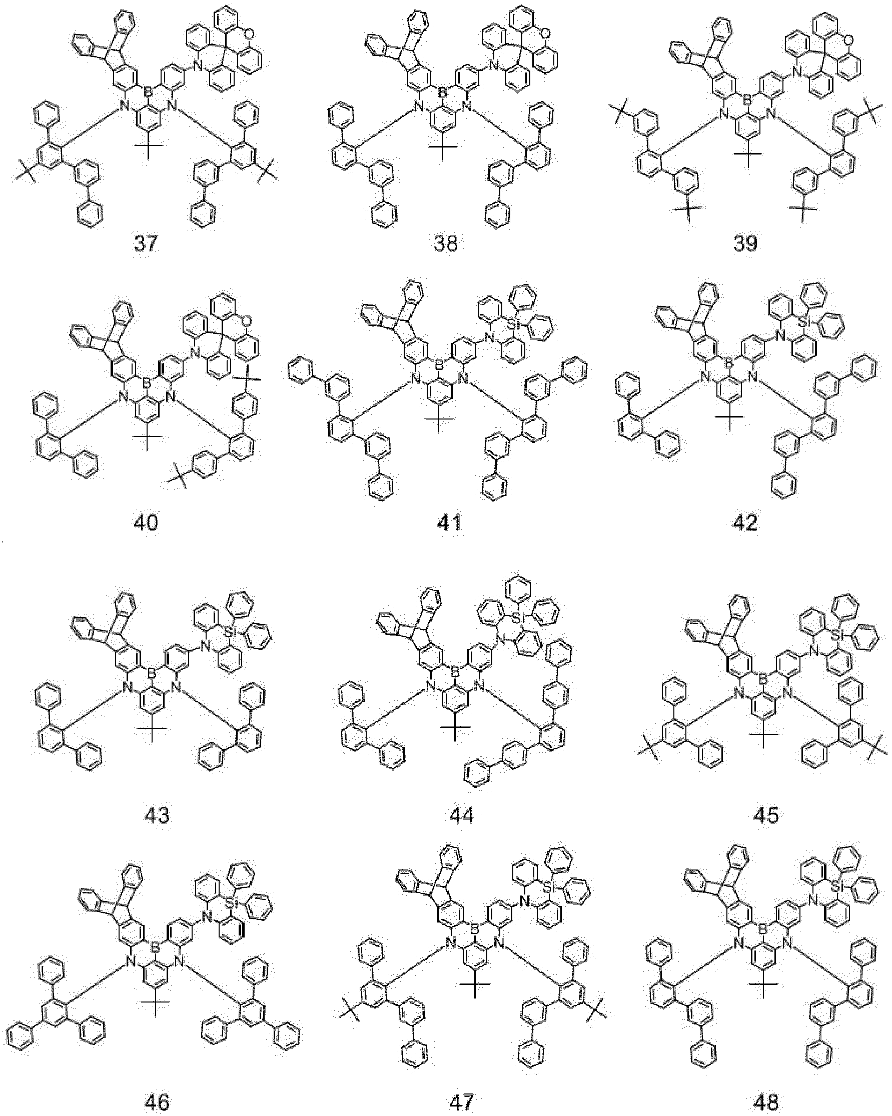 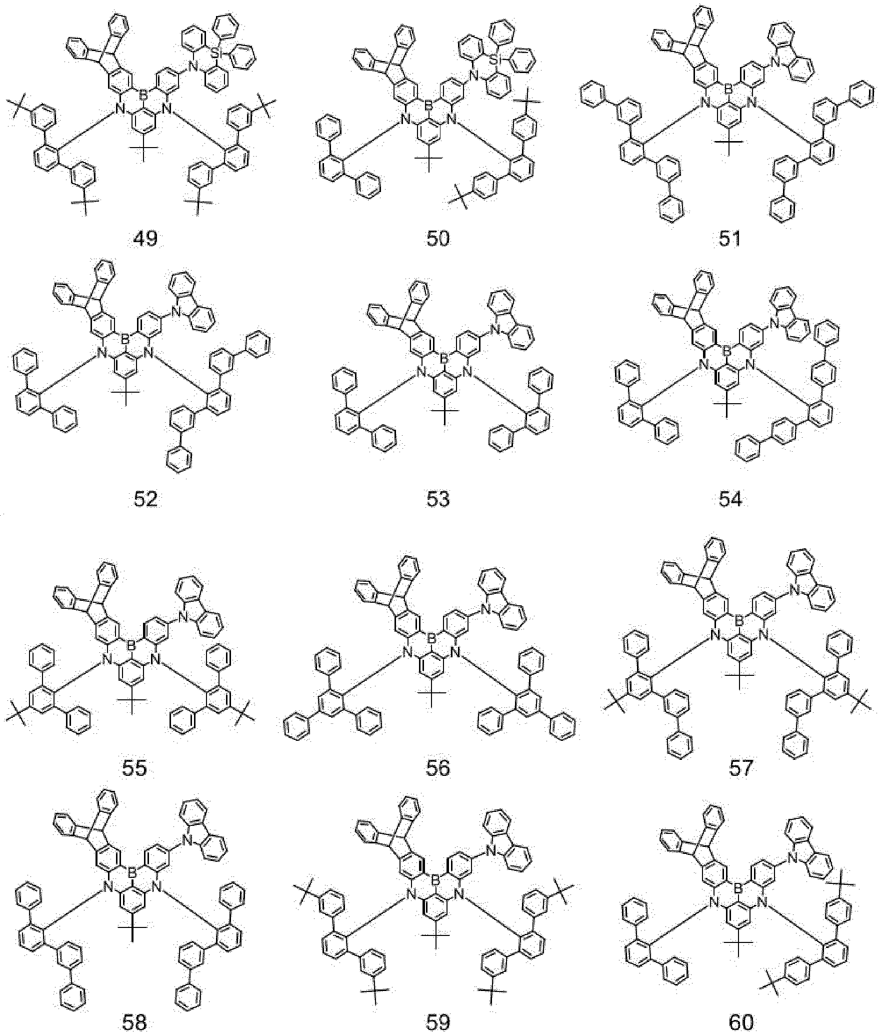 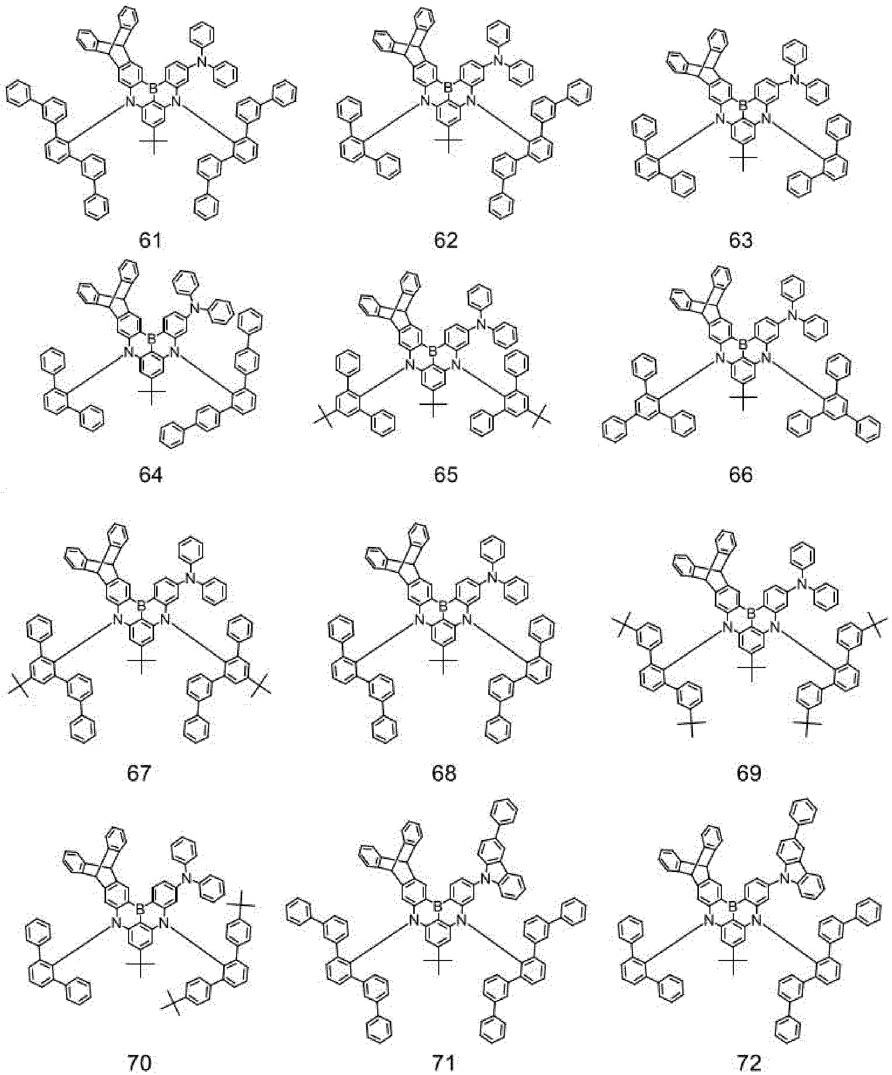 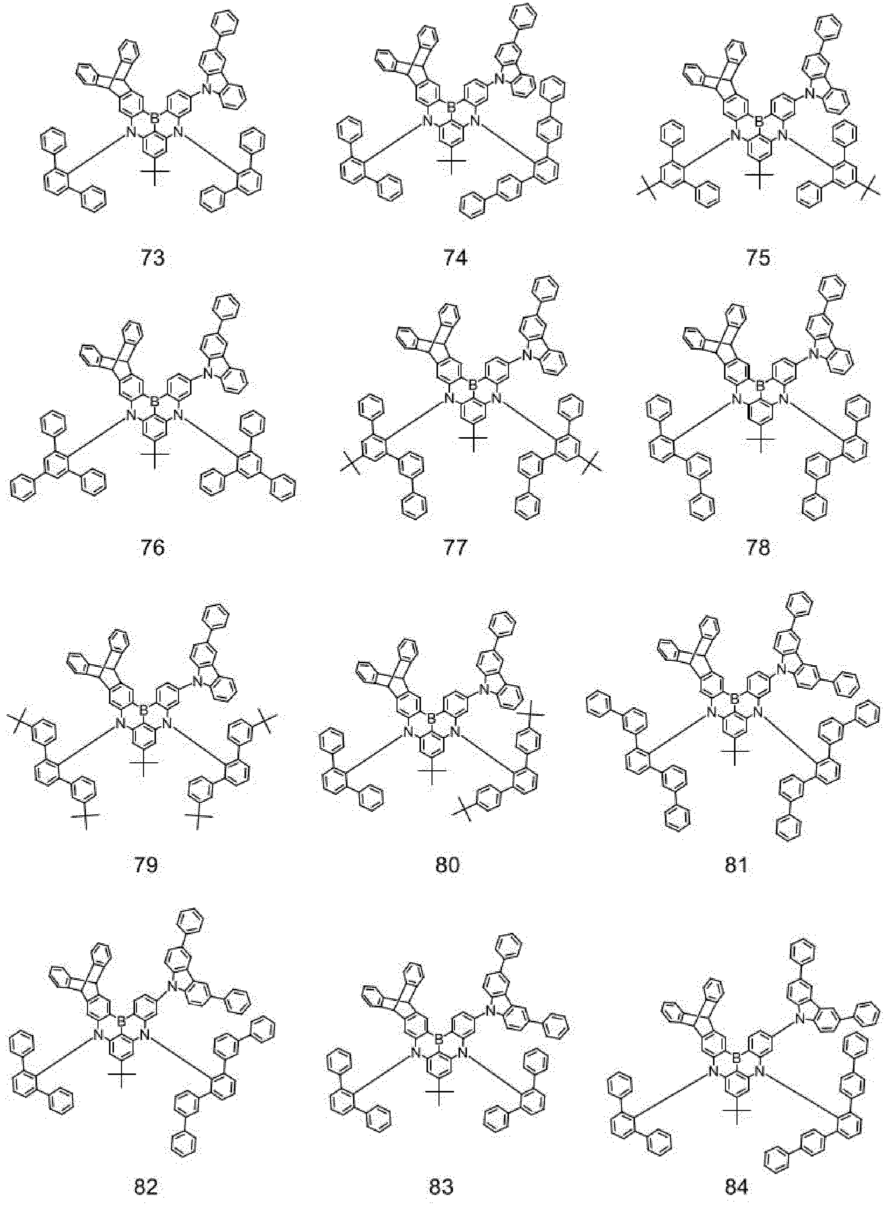 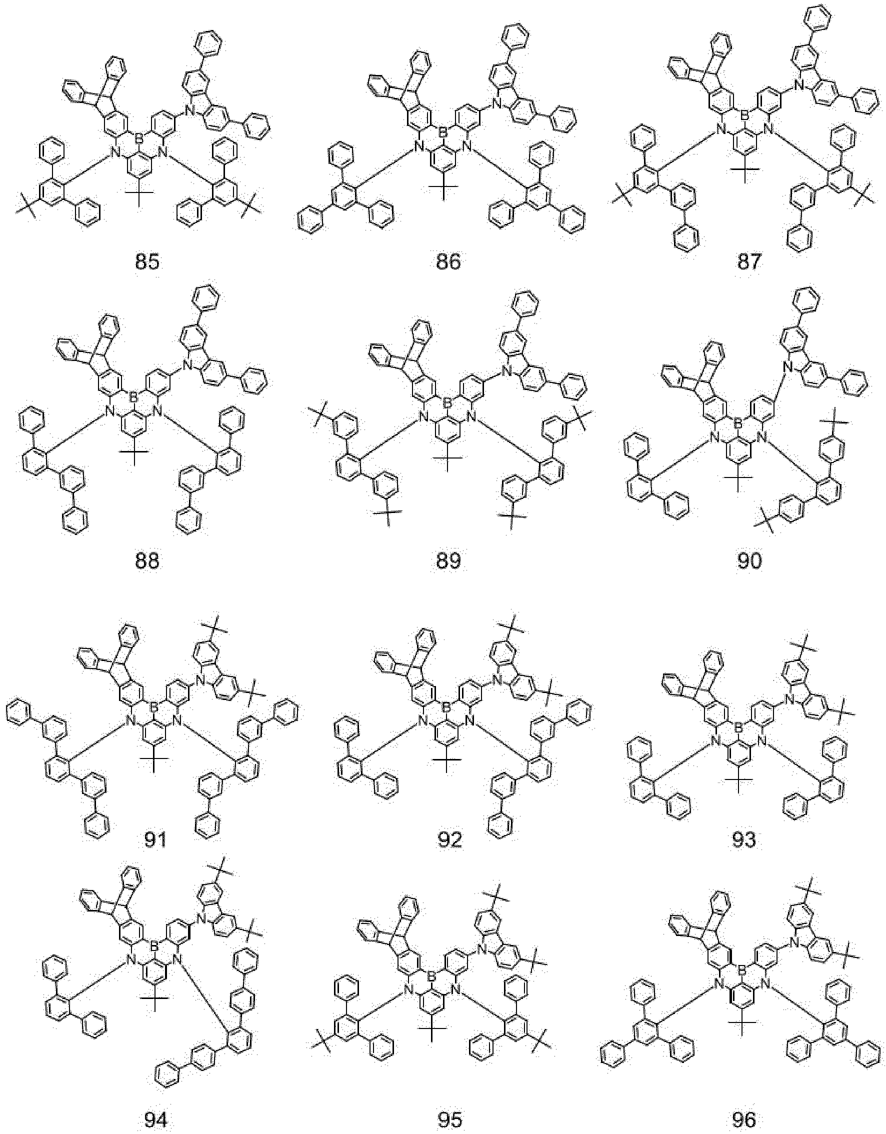 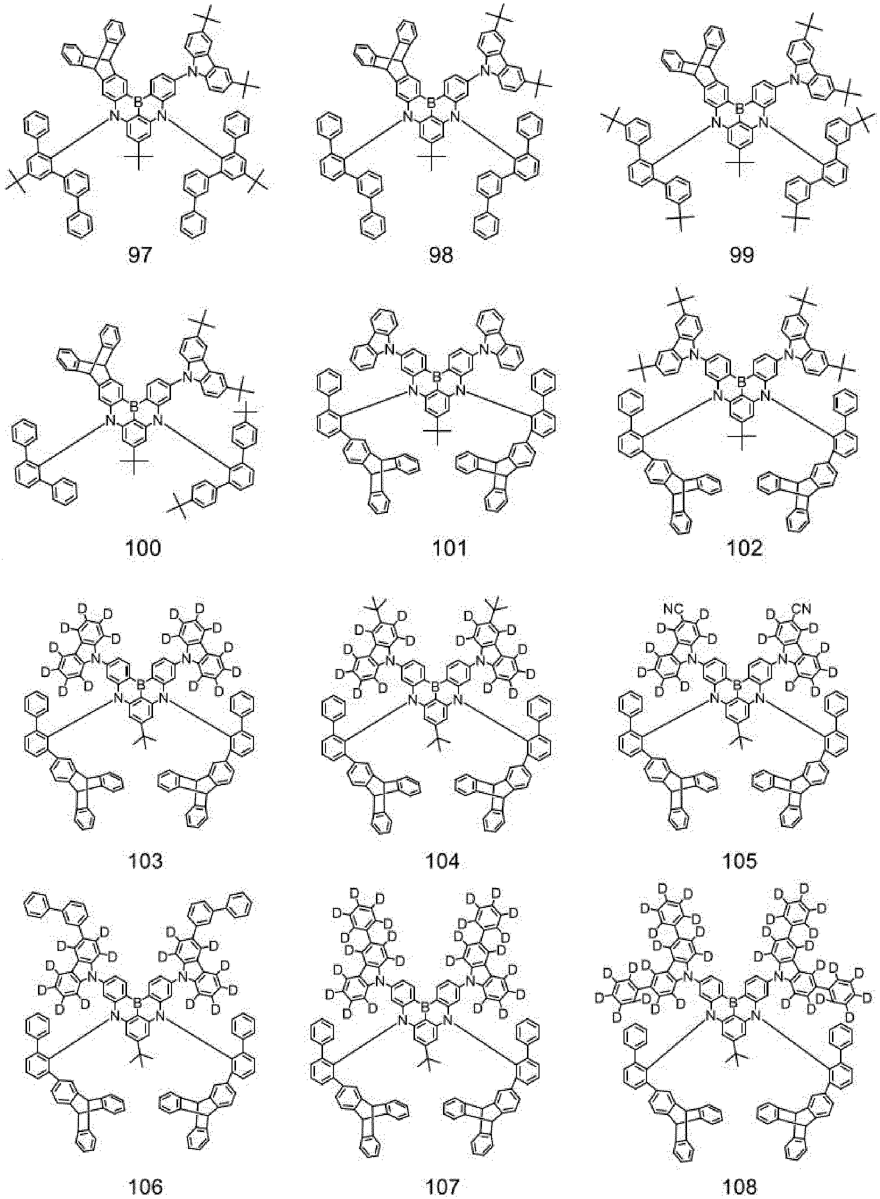 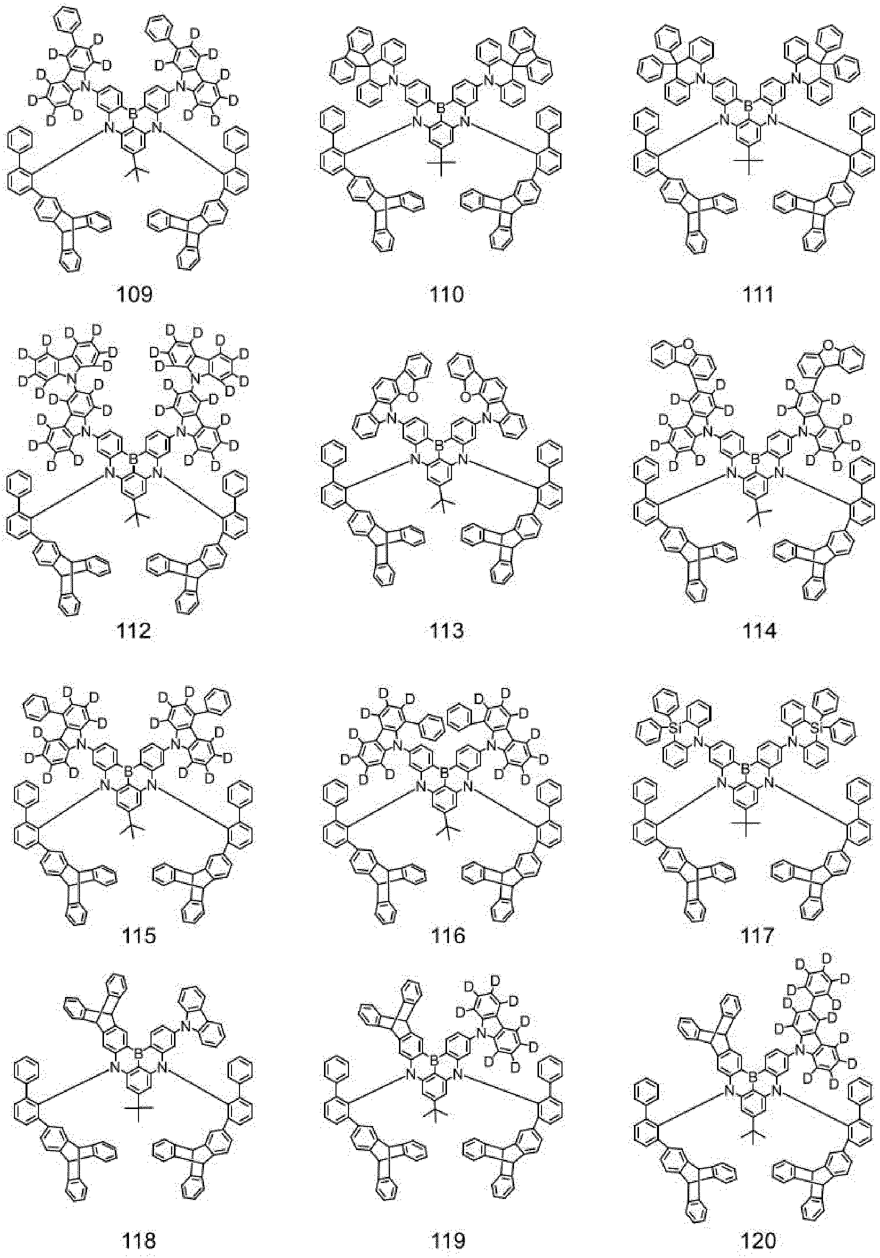 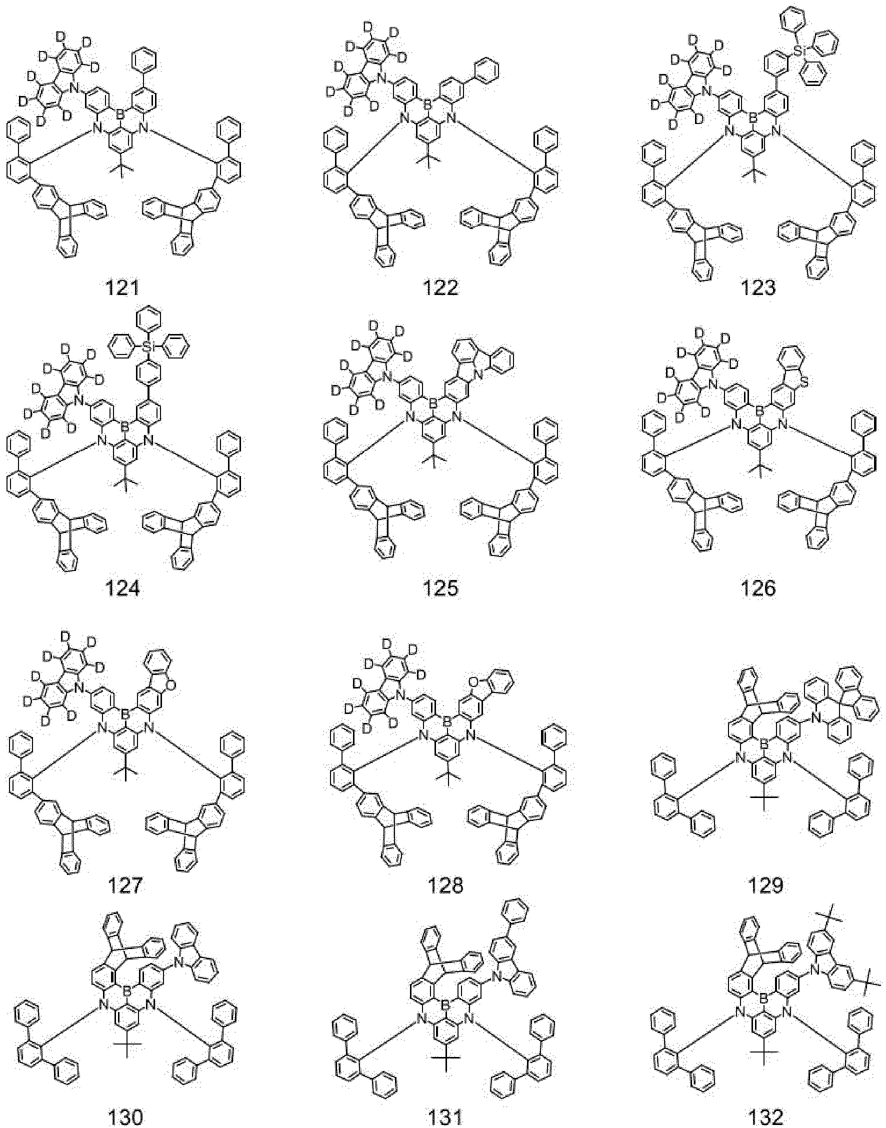 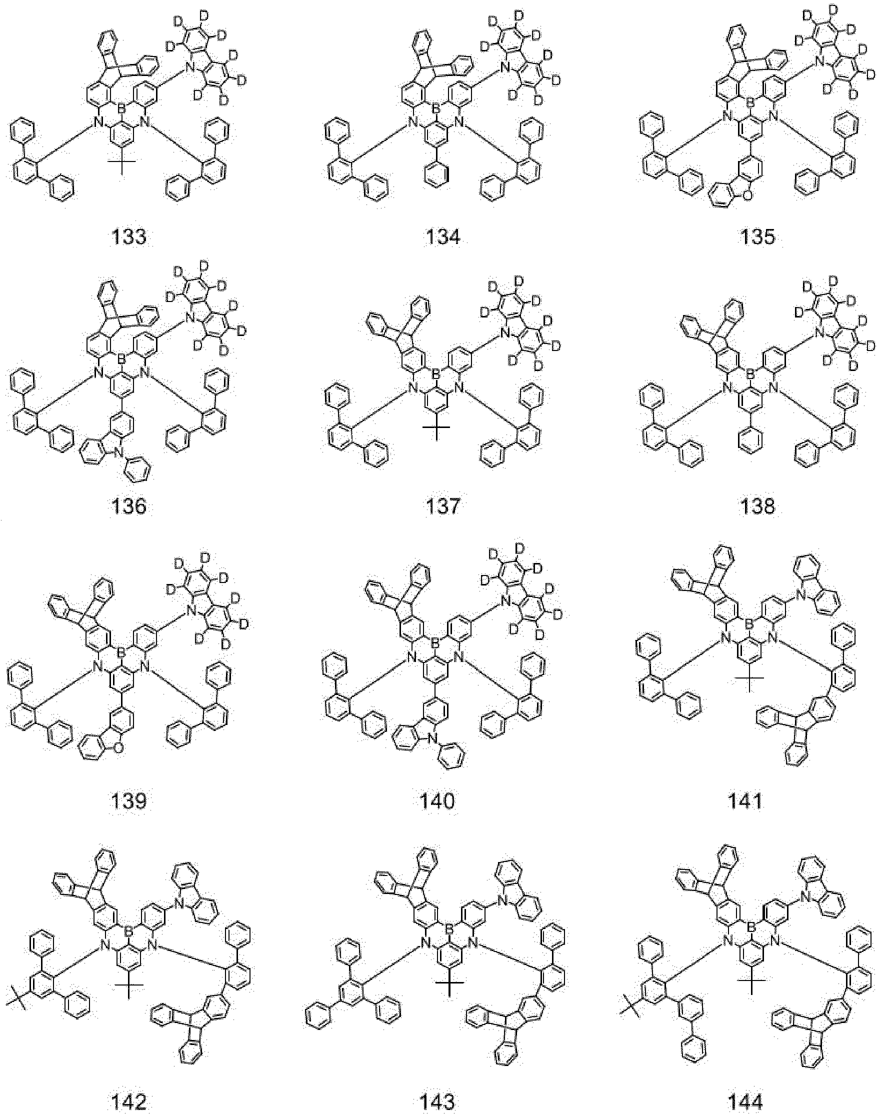 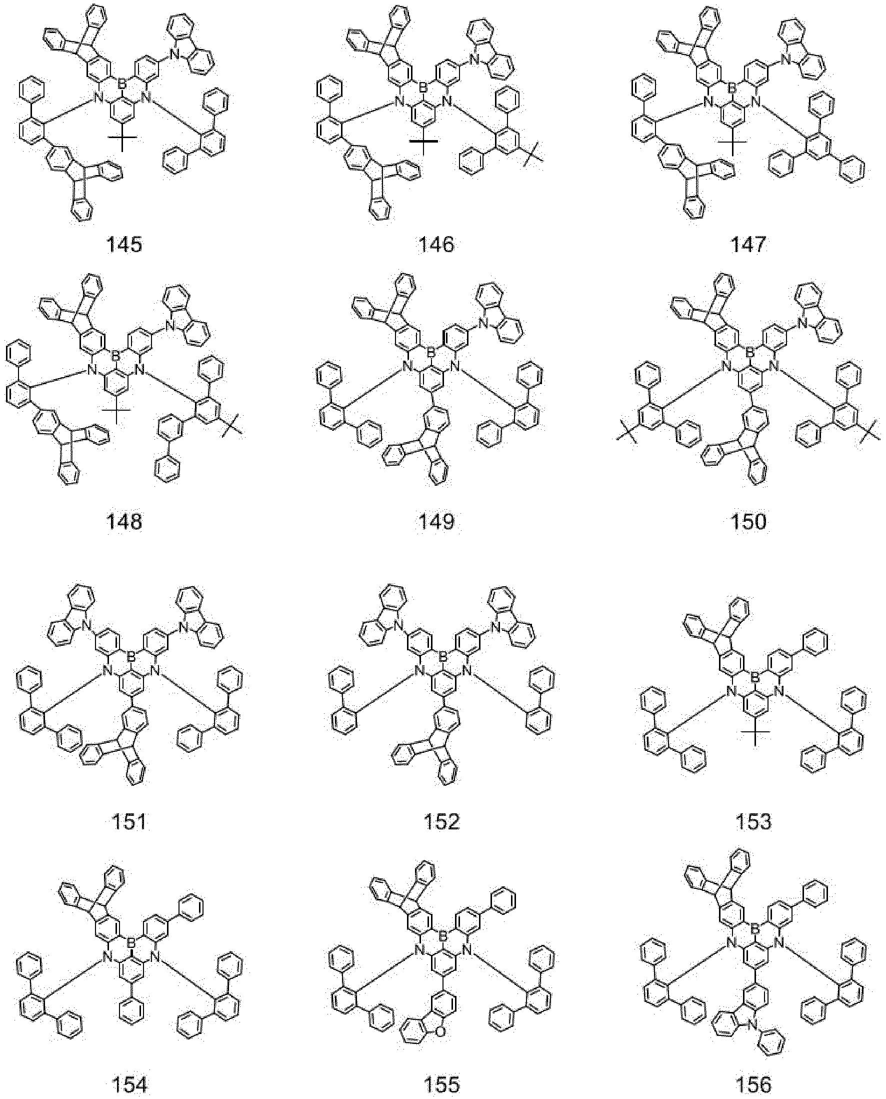 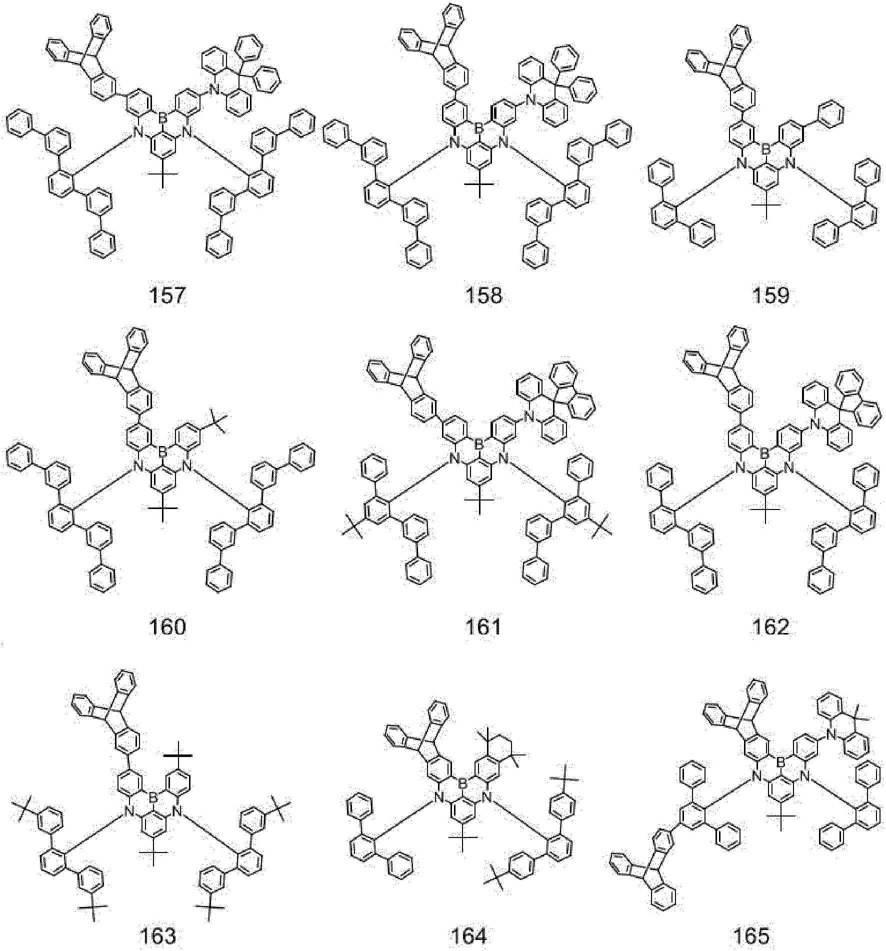 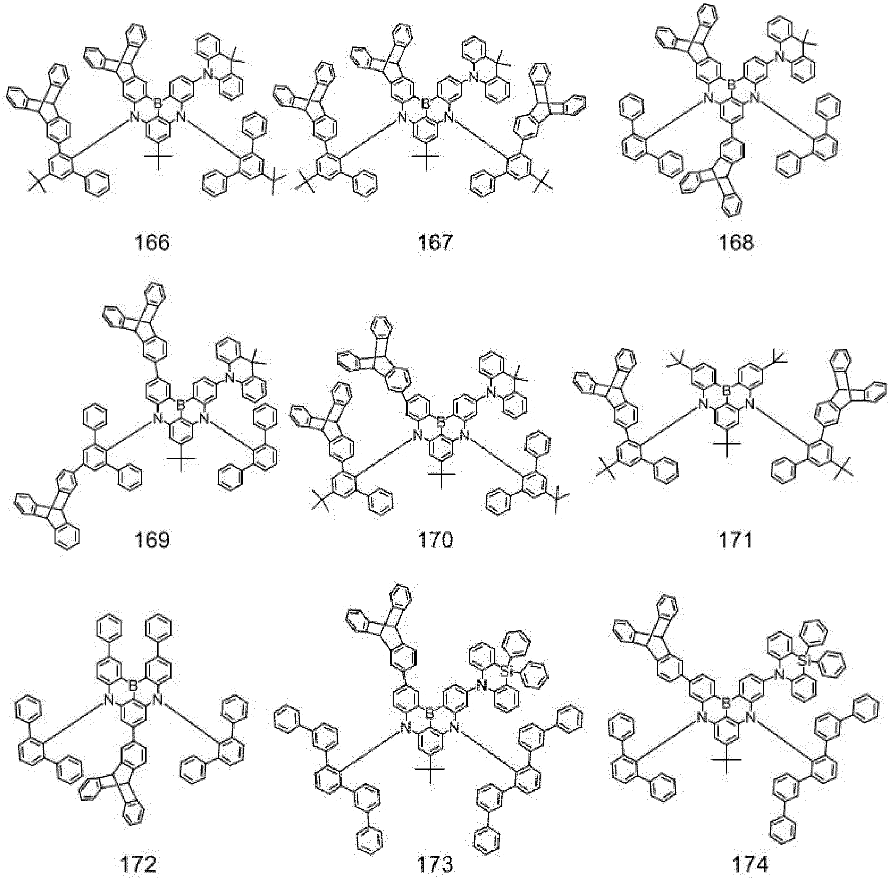 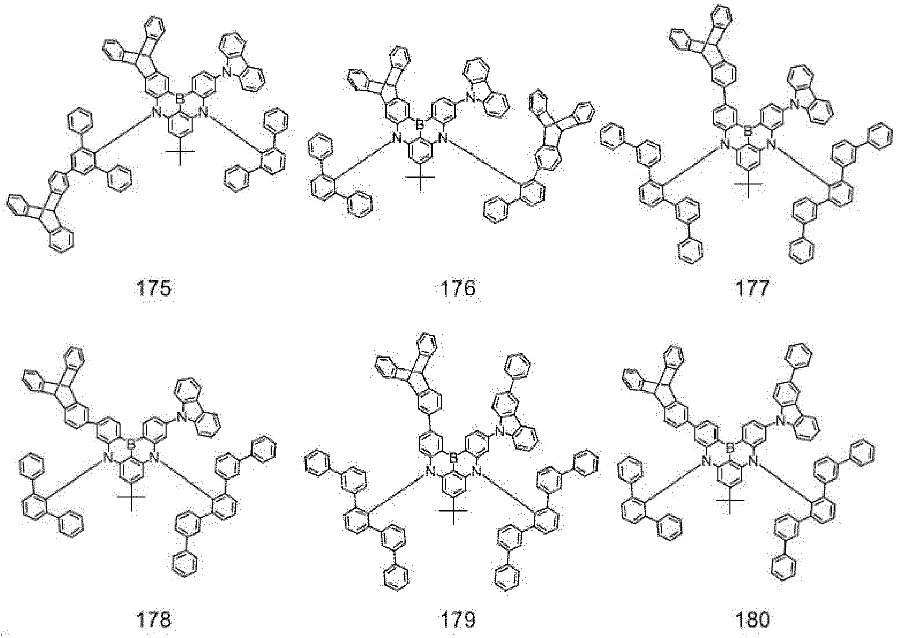 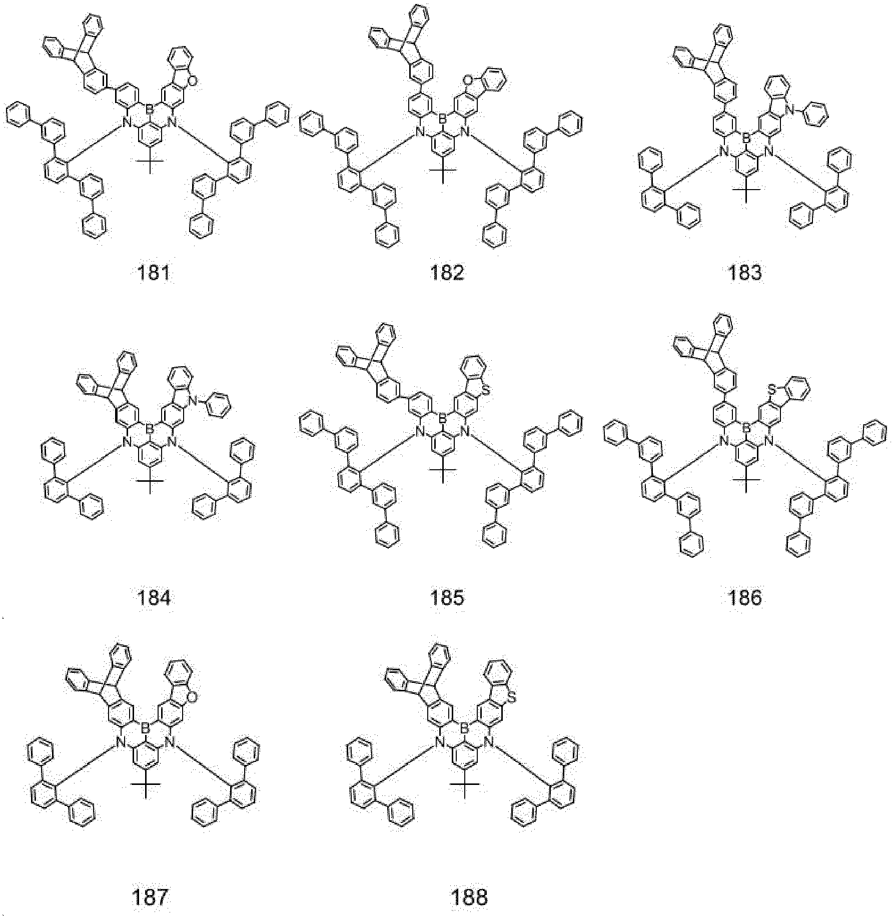 wherein in Compound Group 1,
D represents a deuterium atom.

10. A light-emitting element comprising:
a first electrode;
a second electrode disposed on the first electrode; and
a light-emitting layer disposed between the first electrode and the second electrode, and including a first compound according to any one of claims 1 to 9.

11. The light-emitting element of claim 10, wherein the light-emitting layer further comprises:
at least one of a second compound represented by Formula HT-1, a third compound represented by Formula ET-1, and a fourth compound represented by Formula D-1: 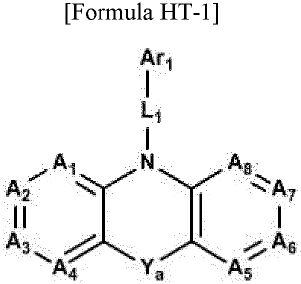
wherein in Formula HT-1,
A₁ to A₈ are each independently N or C(R₅₁),
L₁ is a direct linkage, a substituted or unsubstituted arylene group having a ring-forming carbon number of 6 to 30, or a substituted or unsubstituted heteroarylene group having a ring-forming carbon number of 2 to 30,
Yₐ is a direct linkage, C(R₅₂)(R₅₃), or Si(R₅₄)(R₅₅),
Ar₁ is a substituted or unsubstituted aryl group having a ring-forming carbon number of 6 to 30 or a substituted or unsubstituted heteroaryl group having a ring-forming carbon number of 2 to 30, and
R₅₁ to R₅₅ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having a carbon number of 1 to 20, a substituted or unsubstituted alkenyl group having a carbon number of 2 to 20, a substituted or unsubstituted aryl group having a ring-forming carbon number of 6 to 60, or a substituted or unsubstituted heteroaryl group having a ring-forming carbon number of 2 to 60, or combined with an adjacent group to form a ring; 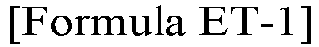 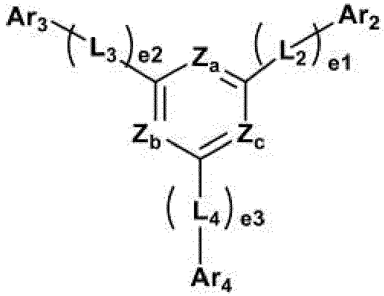 wherein in Formula ET-1,
at least one of Zₐ, Z_{b}, and Z_{c} is N,
the remainder of Zₐ, Z_{b}, and Z_{c} are each independently C(R₅₆),
R₅₆ is a hydrogen atom, a deuterium atom, a substituted or unsubstituted alkyl group having a carbon number of 1 to 20, a substituted or unsubstituted aryl group having a having a ring-forming carbon number of 6 to 60, or a substituted or unsubstituted heteroaryl group having a ring-forming carbon number of 2 to 60,
e1 to e3 are each independently an integer from 0 to 10,
Ar₂ to Ar₄ are each independently a hydrogen atom, a deuterium atom, a substituted or unsubstituted alkyl group having a carbon number of 1 to 20, a substituted or unsubstituted aryl group having a ring-forming carbon number of 6 to 30, or a substituted or unsubstituted heteroaryl group having a ring-forming carbon number of 2 to 30, and
L₂ to L₄ are each independently a direct linkage, a substituted or unsubstituted arylene group having a ring-forming carbon number of 6 to 30, or a substituted or unsubstituted heteroarylene group having a ring-forming carbon number of 2 to 30; 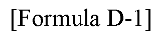 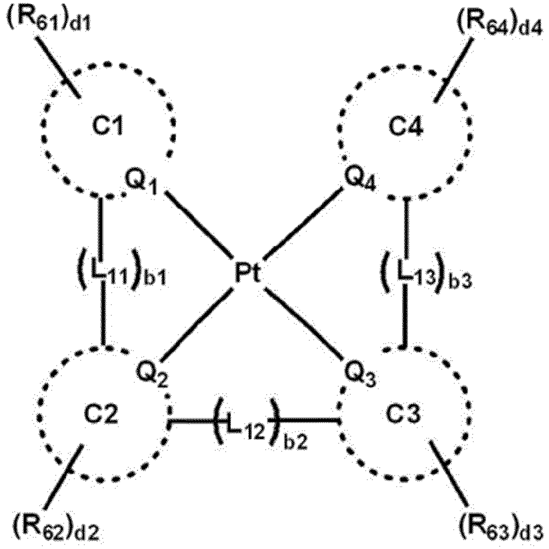 wherein in Formula D-1,
Q₁ to Q₄ are each independently C or N,
C1 to C4 are each independently a substituted or unsubstituted hydrocarbon ring having a ring-forming carbon number of 5 to 30 or a substituted or unsubstituted heterocycle having a ring-forming carbon number of 2 to 30,
L₁₁ to L₁₃ are each independently a direct linkage, 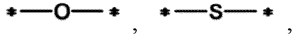 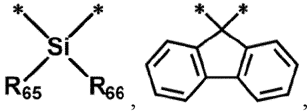 a substituted or unsubstituted alkylene group having a carbon number of 1 to 20, a substituted or unsubstituted arylene group having a ring-forming carbon number of 6 to 30, or a substituted or unsubstituted heteroarylene group having a ring-forming carbon number of 2 to 30,
b1 to b3 are each independently 0 or 1,
R₆₁ to R₆₆ are each independently a hydrogen atom, a deuterium atom, a halogen atom, a cyano group, a nitro group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having a carbon number of 1 to 20, a substituted or unsubstituted alkenyl group having a carbon number of 2 to 20, a substituted or unsubstituted aryl group having a ring-forming carbon number of 6 to 60, or a substituted or unsubstituted heteroaryl group having a ring-forming carbon number of 2 to 60, or combined with an adjacent group to form a ring, and
d1 to d4 are each independently an integer from 0 to 4.

12. The light-emitting element of claim 11, wherein the light-emitting layer further comprises:
the second compound, the third compound, and the fourth compound.

13. An electronic device includes display device comprising:
a circuit layer disposed on a base layer; and
a display element layer disposed on the circuit layer, and including a light-emitting element according to any one of claims 10 to 12.

14. The electronic device of claim 13, the electronic device further comprising:
an optical control layer disposed on the display element layer, wherein
the optical control layer includes a quantum dot.
